(19) Europäisches Patentamt
European Patent Office
Office européen des brevets

(11) EP 2 253 032 B1

# (12) EUROPÄISCHE PATENTSCHRIFT

(45) Veröffentlichungstag und Bekanntmachung des Hinweises auf die Patenterteilung:
**16.10.2013 Patentblatt 2013/42**

(21) Anmeldenummer: **09719173.8**

(22) Anmeldetag: **25.02.2009**

(51) Int Cl.:
***H01L 51/42*** (2006.01) ***H01L 51/50*** (2006.01)
***C09K 11/06*** (2006.01) ***C07F 15/00*** (2006.01)

(86) Internationale Anmeldenummer:
**PCT/EP2009/001332**

(87) Internationale Veröffentlichungsnummer:
**WO 2009/112152 (17.09.2009 Gazette 2009/38)**

## (54) OPTO-ELEKTRONISCHES BAUELEMENT ENTHALTEND NEUTRALE ÜBERGANGSMETALLKOMPLEXE

OPTOELECTRONIC COMPONENT COMPRISING NEUTRAL TRANSITION METAL COMPLEXES

COMPOSANT OPTOELECTRONIQUE CONTENANT DES COMPLEXES DE METAUX DE TRANSITION NEUTRES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **11.03.2008 DE 102008013691**

(43) Veröffentlichungstag der Anmeldung:
**24.11.2010 Patentblatt 2010/47**

(73) Patentinhaber: **Merck Patent GmbH**
**64293 Darmstadt (DE)**

(72) Erfinder:
- **YERSIN, Hartmut**
**93161 Sinzing (DE)**
- **FISCHER, Tobias**
**93485 Rimbach (DE)**
- **CZERWIENIEC, Rafal**
**DE-93055 Regensburg (DE)**
- **MONKOWIUS, Uwe**
**A-4020 Linz (AT)**

(56) Entgegenhaltungen:
**WO-A-2004/006353 WO-A-2007/118671**
**US-A- 6 137 118 US-A1- 2005 164 031**
**US-A1- 2006 237 059**

- **BIWU MA ET AL: "PLATINUM BINUCLEAR COMPLEXES AS PHOSPHORESCENT DOPANTS FOR MONOCHROMATIC AND WHITE ORGANIC LIGHT-EMMITTING DIODES" ADVANCED FUNCTIONAL MATERIALS, WILEY VCH, WIENHEIM, DE, Bd. 16, Nr. 18, 4. Dezember 2006 (2006-12-04), Seiten 2438-2446, XP001504257 ISSN: 1616-301X**
- **SCHAAFSMA T J: "Organic solar cells using porphyrin assemblies on semiconductor substrates" SOLAR ENERGY MATERIALS AND SOLAR CELLS, ELSEVIER SCIENCE PUBLISHERS, AMSTERDAM, NL, Bd. 38, Nr. 1/4, 1. August 1995 (1995-08-01), Seiten 349-351, XP004005379 ISSN: 0927-0248**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 253 032 B1

## Beschreibung

Die Erfindung betrifft die Verwendung von Zusammensetzungen für opto-elektronische Bauteile, wobei die Zusammensetzungen einen ersten neutralen Übergangsmetallkomplex und einen zweiten neutralen Übergangsmetallkomplex aufweisen. Weiterhin betrifft die Erfindung ein Verfahren zur Herstellung derartiger opto-elektronischer Bauteile und opto-elektronische Bauteile, die derartige Komplexe enthalten.

Elektrolumineszierende Verbindungen stellen das Herzstück organischer Leuchtdioden (sog. OLEDs, organic light emitting diodes) dar. Diese Verbindungen werden häufig eingebettet in oder chemisch gebunden an polymere Materialien, die in der Regel so beschaffen sind, dass in ihnen geeignete Ladungsträger erzeugt und transportiert werden können mit der Maßgabe, dass beim Zusammentreffen gegensätzlich geladener Ladungsträger Exzitonen gebildet werden, die ihre Überschussenergie auf die jeweilige elektrolumineszierende Verbindung übertragen. Diese elektrolumineszierende Verbindung kann daraufhin in einen bestimmten elektronischen Anregungszustand übergehen, der dann möglichst vollständig und unter Vermeidung strahlungsloser Desaktivierungsprozesse durch Lichtemission in den zugehörigen Grundzustand umgewandelt wird.

Als elektronischer Anregungszustand, der auch durch Energieübertragung von einem geeigneten Vorläufer-Exziton gebildet werden kann, kommt, von wenigen Ausnahmen abgesehen, entweder ein Singulett- oder Triplett-Zustand in Betracht. Da beide Zustände aufgrund der Spinstatistik in der Regel im Verhältnis 1: 3 besetzt werden, ergibt sich, dass bei einer Emission aus dem Singulett- Zustand, die als Fluoreszenz bezeichnet wird und hauptsächlich bei organischen, schwermetallfreien Verbindungen auftritt, nur maximal 25 % der erzeugten Exzitonen zur Emission führen. Dagegen können bei einer Triplett- Emission, die als Phosphoreszenz bezeichnet wird und vornehmlich bei Übergangsmetall- organischen Verbindungen auftritt, sämtliche Exzitonen ausgenutzt, umgewandelt und als Licht emittiert werden (Triplett- Harvesting), so dass in diesem Fall die Innere Quantenausbeute den Wert von 100 % erreichen kann, sofern sich der mitangeregte und energetisch über dem Triptett- Zustand liegende Singulett- Zustand vollständig in den Triplett-Zustand umwandelt (Intersystem Crossing) und strahlungslose Konkurrenzprozesse bedeutungslos bleiben. Somit sollten Triplett- Emitter grundsätzlich effizientere Elektro- Luminophore und besser geeignet sein, in einer organischen Leuchtdiode für eine hohe Lichtausbeute zu sorgen.

Trotz intensiver Suche nach hocheffizienten Triplett-Emittern sind bisher nur wenige Verbindungen bekannt geworden, deren Lichtausbeute an die Grenze von 100 % heranreicht, da fast immer strahlungslose Konkurrenzprozesse simultan mit der gewünschten Phosphoreszenz ablaufen. Bei den bisher bekannt gewordenen hocheffizienten Triplett-Emittern handelt es sich zumeist um Komplexe einiger vorwiegend aus den Gruppen 6 bis 11 des Periodensystems stammender Schwermetalle mit bestimmten, vorwiegend $\pi$-elektronenhaltigen Liganden.

Es hat sich gezeigt, dass bei den genannten Komplexen die Art und Stärke der Metall-Ligand-Bindungen und die Art der Liganden einen entscheidenden Einfluss auf das Wechselspiel zwischen strahlungsloser und strahlender Desaktivierung und damit auf die jeweils erzielbare Lumineszenzquantenausbeute besitzt, dass diese Größen aber kaum für eine bestimmte Verbindung eindeutig voraussagbar sind. Dies hat zur Folge, dass gegenwärtig die Suche nach geeigneten Triplett-Emittern mit hoher Lumineszensquantenausbeute und passender Emissionsfarbe sowie Emissionslebensdauer noch weitgehend empirisch betrieben wird.

Diese Emitter-Moleküle können in verschiedener Weise realisiert werden, und zwar unter Verwendung rein organischer oder metall-organischer Moleküle. Es lässt sich zeigen, dass die Lichtausbeute der OLEDs mit Übergangsmetall-organischen Substanzen, den sog. Triplett-Emittern, wesentlich größer sein kann als für rein organische Materialien. Aufgrund dieser Eigenschaft kommt der Weiterentwicklung der Übergangsmetallorganischen Materialien ein wesentlicher Stellenwert zu.

Ein anderes wichtiges Ziel ist die effiziente Umwandlung von Sonnenenergie in elektrische Energie. Die damit verbundenen Anforderungen an den Device-Aufbau ähneln in vielen Anforderungen denen zum Bau eines OLEDs. So ist in den OLEDs dafür Sorge zu tragen, dass Löcher, von der Anode kommend, und Elektronen, von der Kathode kommend, an den Farbstoffen (= metallorganische Emitter) rekombinieren und Licht abgeben. Umgekehrt ist bei den organischen Solarzellen (OSCs, organic solar cell), ausgehend von den durch Sonnenlicht angeregten Farbstoffmolekülen darauf zu achten, dass keine erneute Lichtemission erfolgt, sondern dass Löcher und Elektronen entstehen und zur Anode bzw. Kathode wandern.

Bei dem zur Entstehung des Photo-Stroms in einer organischen Solarzelle führenden Prozess, der sich aus mehreren "elementaren" Schritten zusammensetzt, wird zunächst ein Photon des eingestrahlten Lichts von einem Farbstoff-Molekül in der Absorptions-Schicht absorbiert. Damit wird das Farbstoffmolekül elektronisch angeregt. Da das Molekül im angeregten Zustand (Exziton) andere Redox-Eigenschaften aufweist als im Grundzustand, kommt es bei geeignet gewählten HOMO- und LUMO-Lagen der Lochleiter- und Elektronenleitersschicht relativ zu den HOMO-/LUMO-Lagen der Absorptionsschicht zu einer elektrischen Ladungstrennung innerhalb der Absorptions-Schicht oder an einer der Schichtgrenzen. Die dadurch entstandenen Elektronen und Löcher wandern durch die jeweilige Elektronen- bzw. Loch-Leitungs-Schicht in Richtung der Elektroden, wodurch eine elektrische Spannung an den Elektroden entsteht. Aus diesem Funktionsprinzip ergeben sich die Anforderungen an die im Device verwendeten Substanzen:

i) eine sehr hohe Absorption des Farbstoffs über das ganze sichtbare Spektralgebiet möglichst bis in den nahen-IR Bereich,
ii) relativ gute Loch- bzw. Elektronenleitfähigkeiten der dafür vorgesehenen Schichten,
iii) guter Exzitonentransport in der Absorptionsschicht,
iv) effektive und schnelle Exzitonendissoziation sowie Abtransport der Ladungsträger in der Absorptionsschicht oder an einer der Grenzschichten, um eine Loch-Elektron-Rekombination zu vermeiden.

Die im Stand der Technik beschriebenen Probleme bei der Herstellung effizienter OSCs ergeben sich im Wesentlichen aus den folgenden zwei Gründen:

i) Fehlen von Materialien mit hoher Lichtabsorption vom Sichtbaren bis in den nahen Infrarot-Spektralbereich, und
ii) Fehlen von Materialien mit hohen Exzitonen-Diffusionslängen, die eine Wanderung der Exzitonen aus dem Inneren der lichtabsorbierenden Schicht hin zur z. B. Grenzfläche, an der z. B. die Trennung der Exzitonen stattfindet, gewährleisten.

Die Lichtabsorptionsstärke eines Materials bei einer gegebenen Wellenlänge λ wird durch das Lambert-Beersche Gesetz gegeben:

$$-\log(I/I_0) = \varepsilon(\lambda)cd$$

mit *I* = Intensität des transmittierten Lichtes, $I_0$ = Intensität des einfallenden/ eingestrahlten Lichtes, *c* = Konzentration der absorbierenden Substanz und *d* = Weglänge des Lichtes im Material und ε(λ)= molarer dekadischer Extinktionskoeffizient.

Unter der Annahme, dass 99 % des einfallenden Lichtes absorbiert werden, d. h. $I/I_0$ = 0.01 bzw. $-\log(I/I_0)$ = 2 und der Vernachlässigung von Reflexionen sowie einem Wert von *c* = 5 mol/l (typische Feststoffkonzentrationen von Metallkomplexen bzw. Zusammensetzungen, die Gegenstand der vorliegenden Erfindung sind) und *d* = 100 nm (Dicke der Lichtabsorptionsschicht in einer OSC), lassen sich die erforderlichen molaren Extinktionskoeffizienten in Höhe von mindestens $10^4$ l $mol^{-1}cm^{-1}$ bis $10^5$ l $mol^{-1}cm^{-1}$ abschätzen.

Typischerweise betragen jedoch die ε(λ) Werte für die bisher als OSC-Materialien verwendeten Übergangsmetall-Komplexe nur $10^3$ l $mol^{-1}cm^{-1}$ bis $10^4$ l $mol^{-1}cm^{-1}$ (gemessen auf dem Maximum der im Sichtbaren liegenden Absorptionsbande).

Demgemäß lag der vorliegenden Erfindung die Aufgabe zu Grunde, Stoffe, insbesondere Emitter-Substanzen für OLEDs oder Absorptionsfarbstoffe für OSCs, bereitzustellen, mit denen die Nachteile des Standes der Technik überwunden werden können, bzw. mit denen sich insbesondere OLEDs mit hoher Strahlungsleistung und geringer Degradation und OSCs mit hoher Absorption herstellen lassen.

Quadratisch- planar oder quasi- quadratisch- planar koordinierte Pt (II)- Zentren besitzen eine starke Tendenz zur Ausbildung von Pt- Pt- Wechselwirkungen und bilden häufig Kolumnarstrukturen, die auch als Oligomere oder Aggregate bezeichnet werden. [1- 5] Dieses Verhalten kann sowohl bei neutralen (z. B. bei $(RNC)_2Pt(CN)_2$- Komplexen), als auch bei geladenen Komplexen (z. B. $[Pt(CN)_4]^{2-}$) beobachtet werden. Bei letzteren bilden sich diese Kolumnarstrukturen sogar trotz der gleichartigen Ladungen der Komplexanionen. [5]

Derartige Verbindungen zeigen im Festkörper intensive Emissionen und sehr intensive Absorptionen (bei etwas höheren Energien), die den durch Pt-Pt-Wechselwirkungen resultierenden elektronischen Zuständen entsprechen. [5-10] Die Emissions- und Absorptionswellenlängen werden vorwiegend durch die Pt-Pt-Abstände in den Kolumnarstrukturen bestimmt, und diese lassen sich bei geladenen Komplexen gezielt durch die Variation des Gegenions bzw. bei neutralen Komplexen durch die Variation der Liganden oder der Substituten an den Liganden steuern.

Die Erfinder haben überraschend festgestellt, dass durch eine einfache Mischung (Zusammensetzung) neutraler Übergangsmetallkomplexe, insbesondere Pt (II)- Komplexe, auch eine Veränderung der Emissions- und Absorptionseigenschaften erreicht werden kann. Dazu werden zwei oder mehr neutrale Übergangsmetall- Komplexverbindungen, beispielsweise Pt (II)- Komplexverbindungen gleichzeitig im Vakuum verdampft und auf einer Oberfläche, z. B. als Emissionsschicht oder Absorptionsschicht eines optoelektronischen Bauelements, abgeschieden. Dadurch erhält man einen Aufbau der Verbindungen oder Zusammensetzungen als Kolumnarstrukturen (die vom Fachmann auch als Aggregate oder Oligomere bezeichnet werden), die im Vergleich zu den jeweiligen reinen Verbindungen andere Metall-Metall- Abstände (z. B. Pt- Pt- Abstände) aufweisen. So lässt sich durch eine geeignete Wahl der Verbindungen und deren Mischungsverhältnissen die Emissionswellenlänge variieren. Dabei kann eine beliebige Anzahl von Substanzen in allen möglichen Mischungsformen in der Emissionsschicht des optoelektronischen Bauelements abgeschieden werden.

Wesentliche Vorteile dieser Mischungen sind unter anderem die mögliche Variation oder Anpassung der Emissions- bzw. Absorptionswellenlänge und die Möglichkeit, besonders hohe Emissionsintensitäten zu erreichen.

WO 2004/06353 beschreibt die Verwendung einer Zusammensetzung in einem elektronischen Bauelement, wobei die Zusammensetzung einen ersten Übergangsmetallkomplex (Pt- Amin- Komplex), sowie einen zweiten Übergangsmetallkomplex (Pt- Choloro- Komplex) aufweist, wobei der erste Übergangsmetallkomplex und der zweite Übergangsmetallkomplex zusammen eine Kolumnarstruktur ausbilden.

Die der Erfindung zu Grunde liegende Aufgabe wird durch die Verwendung einer Zusammensetzung gemäß Anspruch 1 für opto-elektronische Bauteile, insbesondere in deren Emitter- oder Absorberschicht, gelöst. Weitere neutrale Übergangsmetallkomplexe können auch in beliebiger Anzahl in der Zusammensetzung enthalten sein bzw. die Zusammensetzung kann weitere neutrale Übergangsmetallkomplexe auch in beliebiger Anzahl aufweisen, bevorzugt insgesamt bis zu fünf, besonders bevorzugt zwei, drei oder vier verschiedene Übergangsmetallkomplexe der hier beschrieben Art. Außerdem können weitere Verbindungen vorhanden sein, die keine Übergangsmetalle enthalten.

Die Zusammensetzung dient somit der Umwandlung von elektrischer Energie in Lichtenergie oder der Umwandlung von Lichtenergie in elektrische Energie.

Erfindungsgemäß sind der erste Übergangsmetallkomplex und der zweite Übergangsmetallkomplex derart beschaffen, dass beide eine quadratisch-planare Struktur oder eine quasi-quadratisch-planare Struktur aufweisen und dass sie zusammen eine Kolumnarstruktur bilden. Der Begriff der Kolumnarstruktur ist dem Fachmann bekannt. Derartige Strukturen werden in der Literatur auch als Aggregate oder Oligomere bezeichnet. [1-5] Experimentell kann das Vorliegen einer Kolumnarstruktur dadurch bestimmt werden, dass der Metall-Metall-Abstand in der Röntgenstruktur bestimmt wird. Ist dieser bei Platinkomplexen kleiner als 3.7 Å und insbesondere kleiner als etwa 3.5 Å, so kann daraus geschlossen werden, dass eine Kolumnarstruktur vorliegt. Eine weitere Methode zur Bestimmung des Vorliegens einer Kolumnarstruktur liegt in der Messung des Photolumineszenzspektrums. Dazu wird dieses Spektrum in Lösung in unterschiedlicher Konzentration gemessen. Verschiebt sich dabei bei höherer Konzentration das Maximum des Photolumineszenzspektrums, so kann daraus geschlossen werden, dass eine Kolumnarstruktur vorliegt. Falls die Übergangsmetallkomplexe keine ausreichend hohe Löslichkeit zur Messung in Lösung aufweisen, kann die Messung auch im Film in unterschiedlichen Konzentrationen in einem Matrixmaterial durchgeführt werden. Da die unter-schiedlichen Methoden zu einer leichten Abweichung der Ergebnisse voneinander führen können, soll im Sinne dieser Anmeldung insbesondere die Verschiebung des Maximums des Photolumineszenzspektrums in Abhängigkeit der Konzentration in einem Film zusammen mit einem inerten Matrixmaterial, welches selber nicht an der Emission teilnimmt, verstanden werden.

Diese Kolumnarstruktur kann auch unterbrochen sein. Die erfindungsgemäße Zusammensetzung muss demnach keine durchgängige Kolumnarstruktur aufweisen, sondern kann abschnittsweise eine Kolumnarstruktur aufweisen.

Der erste Übergangsmetallkomplex und der zweite Übergangsmetallkomplex der erfindungsgemäßen Zusammensetzung weisen eine quadratisch-planare Struktur oder eine quasi-quadratisch-planare Struktur auf. Dabei ist die Kolumnarstruktur durch Überlappung eines (besetzten) d-Orbitals des ersten Übergangsmetallkomplexes mit einem (besetzten) d-Orbital des zweiten Übergangsmetallkomplexes und gleichermaßen durch Überlappung der (unbesetzten) p-Orbitale entlang der Längsausrichtung der Kolumne (des Oligomers) charakterisiert. Durch dieses Modell lassen sich die Metall-Metall-Wechselwirkungen in einer solchen Struktur beschreiben.

Unter einer quadratisch-planaren Struktur im Sinne dieser Anmeldung wird eine Struktur verstanden, in der das Metall und die vier koordinierenden Atome der Liganden in einer Ebene liegen. Unter einer quasi-quadratisch-planaren Struktur im Sinne dieser Anmeldung wird eine Struktur verstanden, in der das Metall und die vier koordinierenden Atome der Liganden näherungsweise in einer Ebene liegen. Diese kann jedoch leicht in Richtung Tetraeder oder quadratisch-pyramidale Struktur verzerrt sein. Im Sinne dieser Anmeldung soll eine Abweichung von bis zu 30° von der planaren Struktur noch als quasi-planare Struktur bezeichnet werden. Die genaue Geometrie der Komplexe lässt sich durch quantenmechanische Rechnung (Geometrieoptimierung mit dem Programm Gaussian 2003 und der Methode Hartree-Fock / LanL2MB) bestimmen.

Gemäß der Erfindung sind der erste Übergangsmetallkomplex und der zweite Übergangsmetallkomplex ausgewählt aus Pt (II)- Komplexen, Rh (I)- Komplexen, Ir (I)- Komplexen, Au (III)- Komplexen, Pd (II)- Komplexen, Au (I)- Komplexen und Ag (I)- Komplexen, wie in Anspruch 1 definiert.

In den nachfolgenden Formeln handelt es sich bei R1- R8 jeweils um Substituenten, die identisch oder voneinander unabhängig sein können. Diese sind ausgewählt aus der Gruppe bestehend aus: H, D, F, Cl, Br, I, CHO, C (=O) $Ar^1$, P (=O) $(Ar^1)_2$, S (=O) $Ar^1$, S $(=O)_2Ar^1$, $CR^2$=$CR^2Ar^1$, CN, $NO_2$, Si $(R^2)_3$, B $(OR')_2$, B $(R')_2$, B (N $(R')_2)_2$, $OSO_2R'$, einer geradkettigen Alkyl-, Alkenyl-, Alkinyl-, Alkoxy- oder Thioalkoxygruppe mit 1 bis 40 C- Atomen oder einer verzweigten oder cyclischen Alkyl-, Alkenyl-, Alkinyl-, Alkoxy- oder Thioalkoxygruppe mit 3 bis 40 C- Atomen, die jeweils mit einem oder mehreren Resten $R^2$ substituiert sein kann, wobei eine oder mehrere nicht benachbarte $CH_2$- Gruppen durch R'C=CR', C=C , Si $(R')_2$, Ge $(R')_2$, Sn $(R')_2$, C=O, C=S, C=Se, C=NR', P (=O) (R), SO, $SO_2$, NR, O, S oder CONR ersetzt sein können und wobei ein oder mehrere H- Atome durch F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste R' substituiert sein kann, oder eine Aryloxy- oder Heteroaryloxygruppe mit 5 bis 60 aromatischen

Ringatomen, die durch einen oder mehrere Reste R' substituiert sein kann, oder eine Kombination dieser Systeme; dabei können zwei oder mehrere benachbarte Substituenten auch miteinander ein mono- oder polycyclisches, aliphatisches oder aromatisches Ringsystem bilden.

Dabei steht $Ar^1$ bei jedem Auftreten gleich oder verschieden für ein aromatisches oder heteroaromatisches Ringsystem mit 5 bis 40 aromatischen Ringatomen, das mit einem oder mehreren Resten R' substituiert sein kann. Weiterhin steht R bei jedem Auftreten gleich oder verschieden für H, D, CN oder einen aliphatischen, aromatischen und/ oder heteroaromatischen Kohlenwasserstoffrest mit 1 bis 20 C-Atomen, in dem auch H-Atome durch F ersetzt sein können; dabei können zwei oder mehrere benachbarte Substituenten R' auch miteinander ein mono- oder polycyclisches, aliphatisches oder aromatisches Ringsystem bilden.

In den nachfolgenden Formeln bedeuten

NL1 - NL3 = neutrale einzähnige Liganden, und

AL1 - AL3 = anionische einzähnige Liganden.

Beispiele neutraler, einzähniger Liganden sind etwa Carbonyl CO, Nitrile NCR', Isonitrile CNR" oder Oxazole. Es können auch Nitrile oder Isonitrile verwendet werden, die mit einer großen organischen Gruppe R (wie oben definiert) substituiert sind. Als neutrale Liganden kommen auch Verbindungen in Frage, die über N, P, S, O, As oder Se koordinieren.

Anionische, einzähnige Liganden sind beispielweise Cyanid $CN^-$, Chlorid $Cl^-$, Bromid $Br^-$, Iodid $I^-$, $RS^-$, $RO^-$, $SCN^-$, $OCN^-$, Arylgruppen, Alkenylgruppen, Alkinylgruppen oder Borate.

Im Folgenden werden beispielhaft besonders bevorzugte neutrale Übergangsmetallkomplexe der erfindungsgemäßen Zusammensetzung genannt.

**Ir(I)-Komplexe**

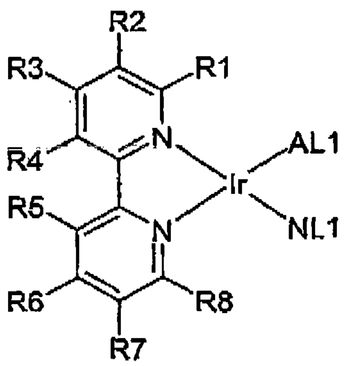

**1**

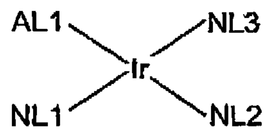

**2**

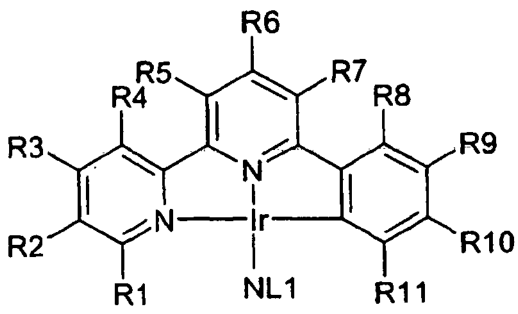

**3**

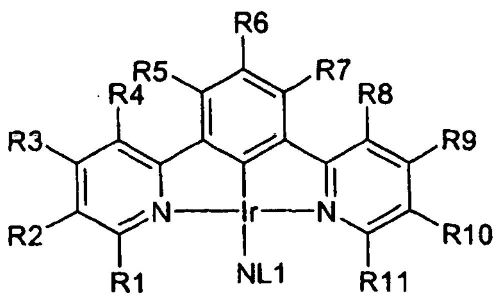

**4**

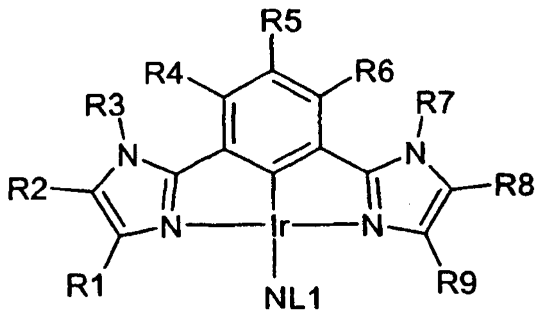

5

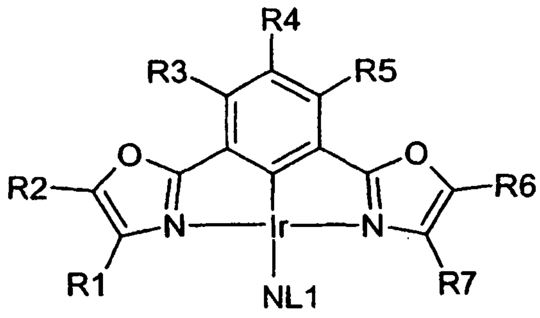

6

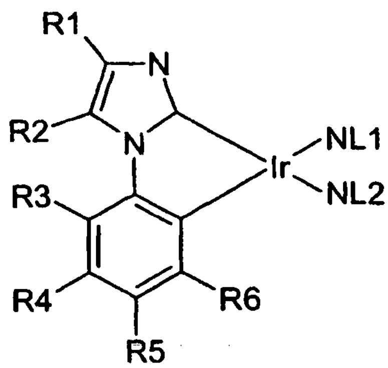

7

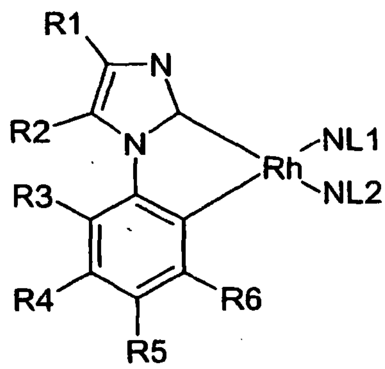

8

**Rh(I)-Komplexe**

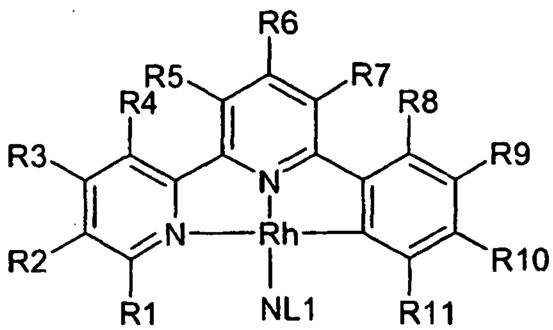

9

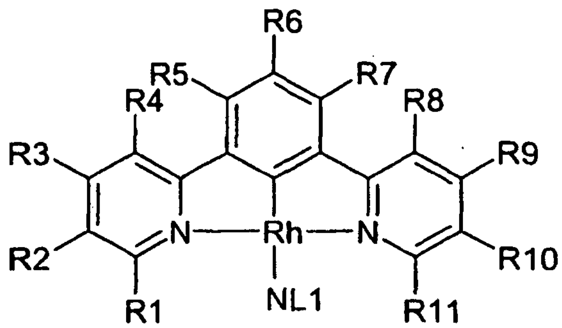

10

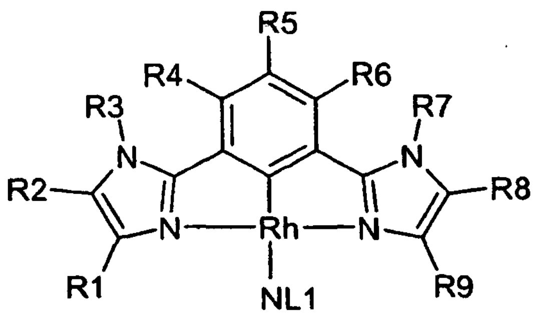
**11**

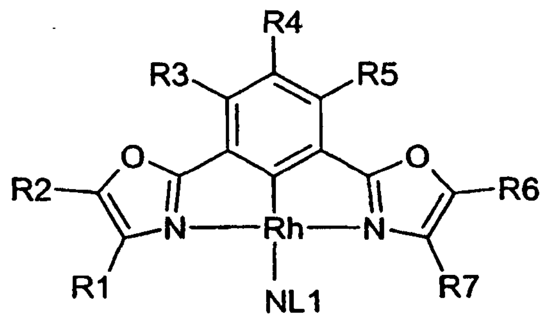
**12**

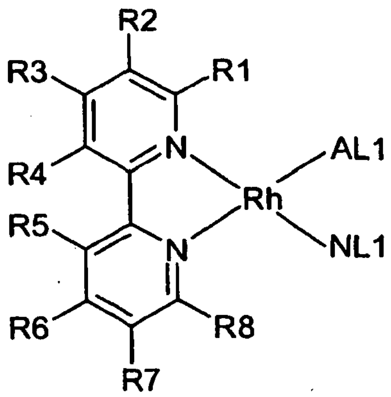
**13**

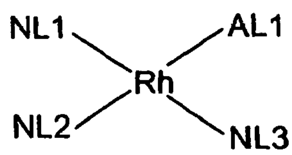
**14**

**Pt(II)-Komplexe**

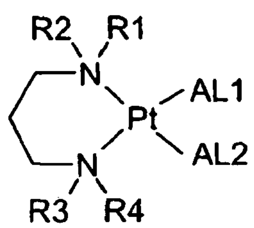
**15**

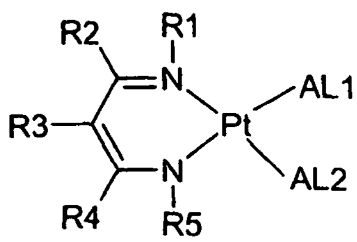
**16**

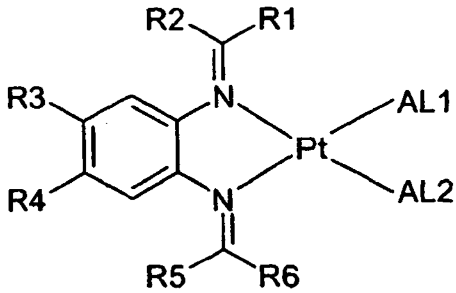

**17**

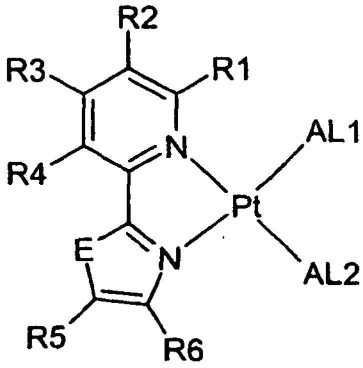

**18**

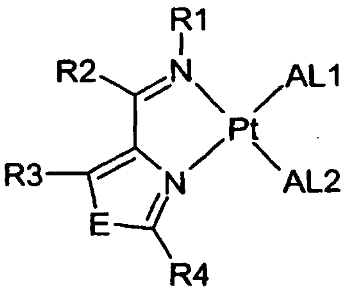

**19**

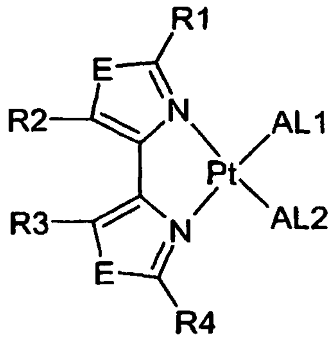

**20**

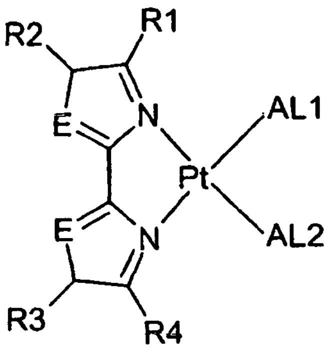

**21**

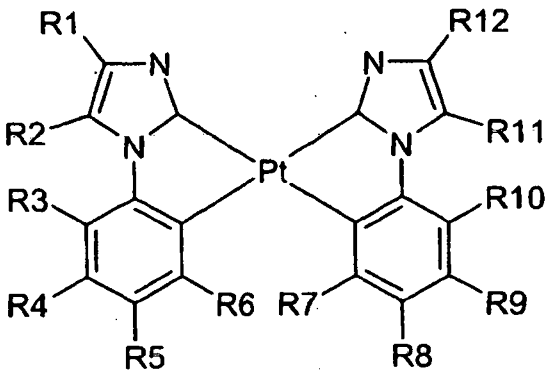

**22**

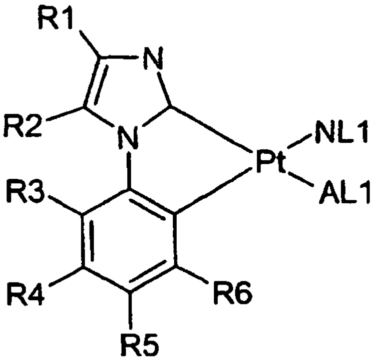

**23**

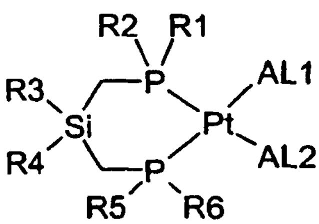

**24**

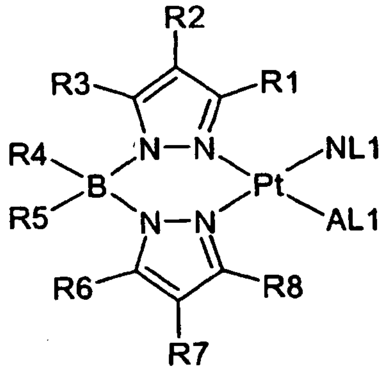

25

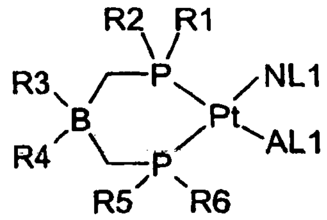

26

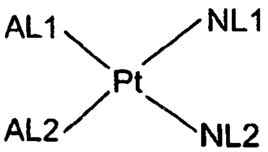

27

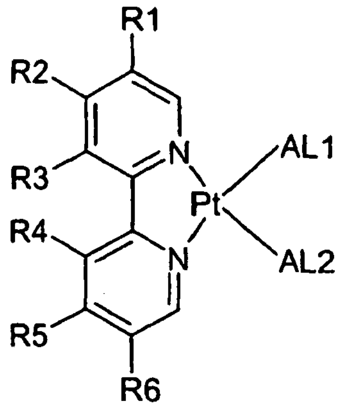

28

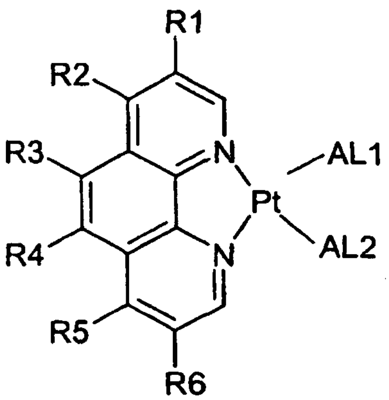

29

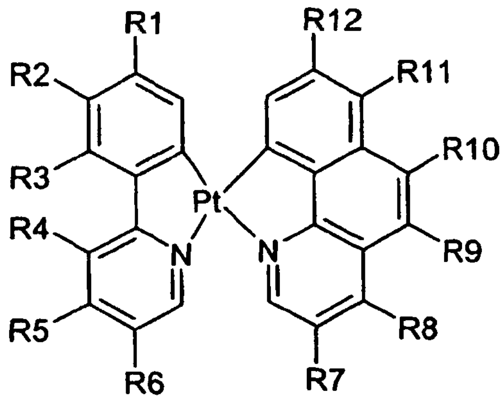

30

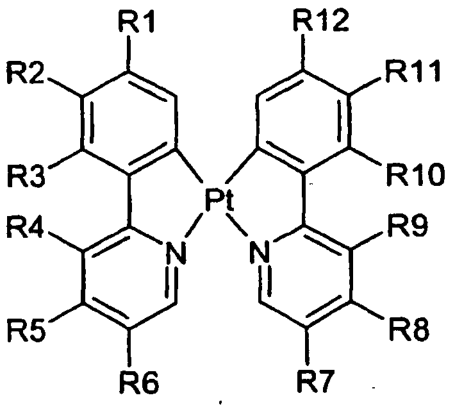

31

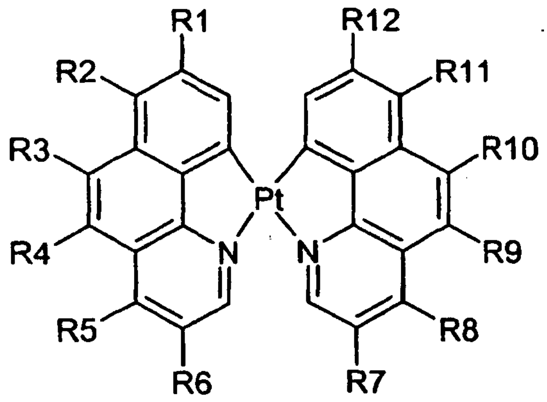

32

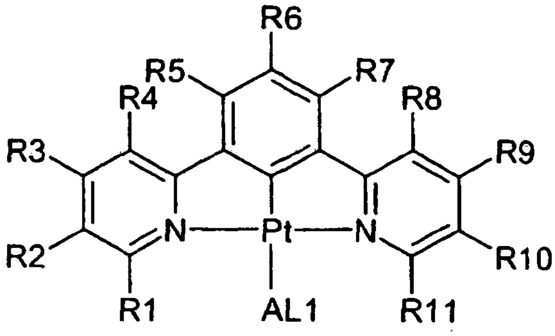

33

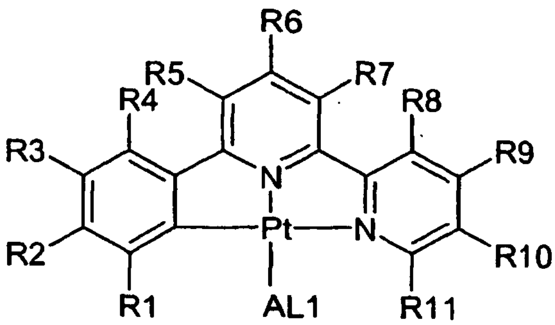

34

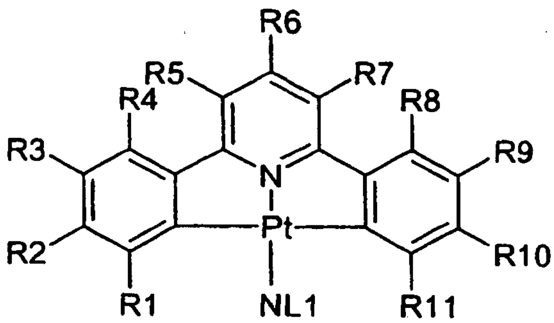

35

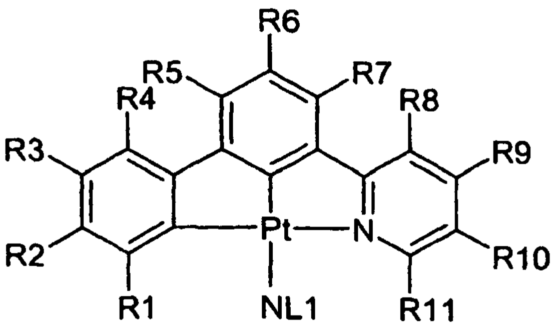

36

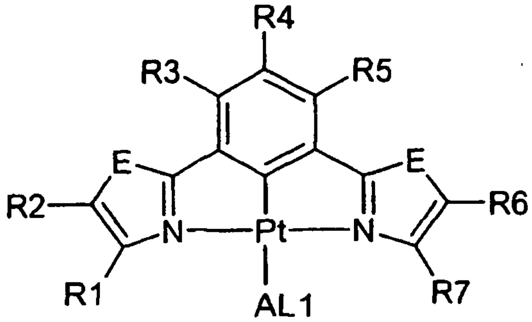

37

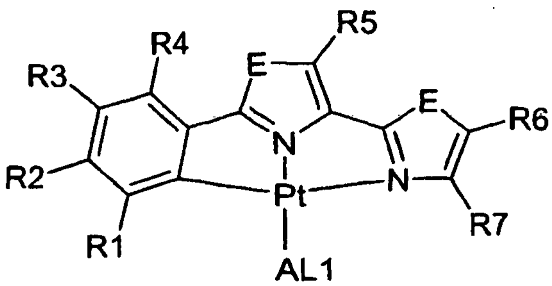

38

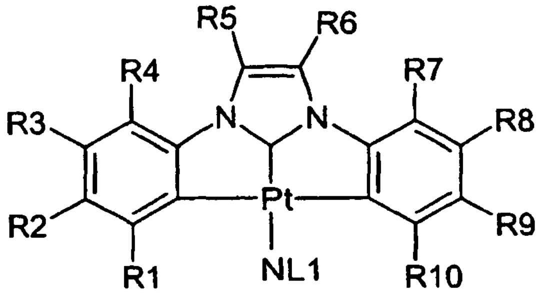

39

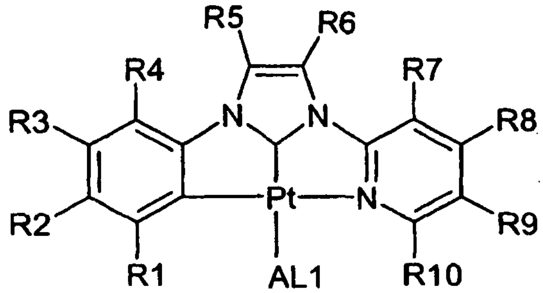

40

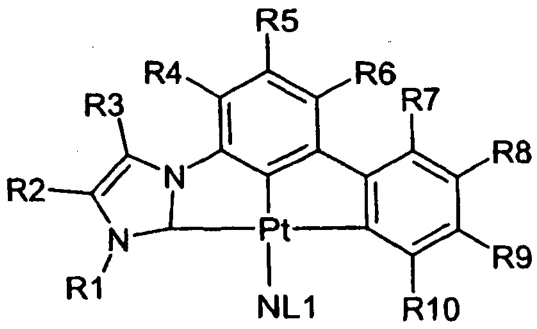

**41**

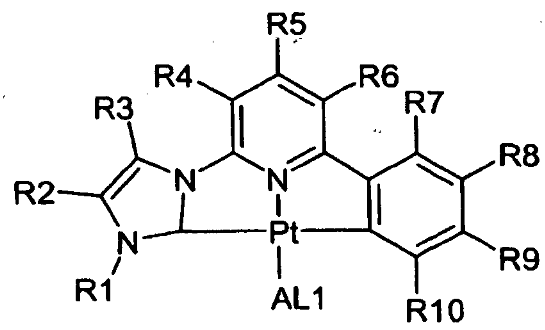

**42**

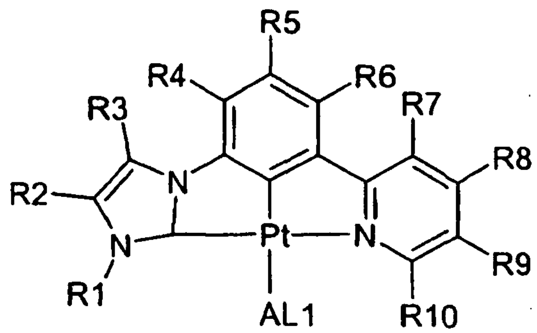

**43**

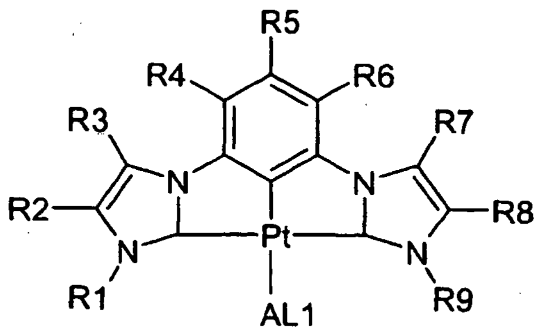

**44**

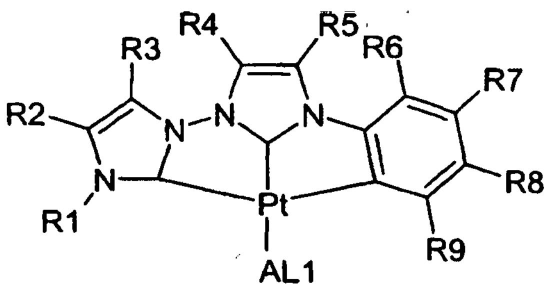

**45**

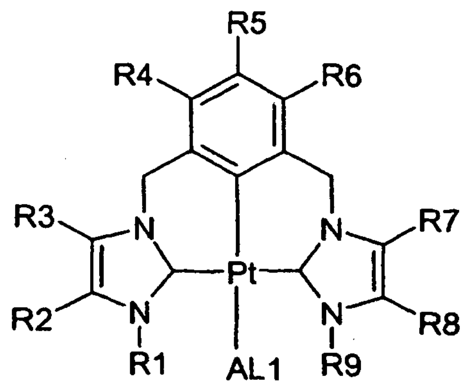

**46**

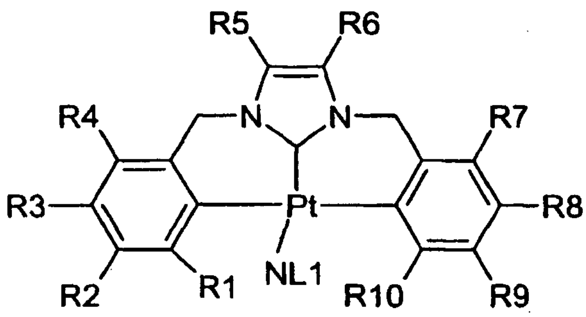

**47**

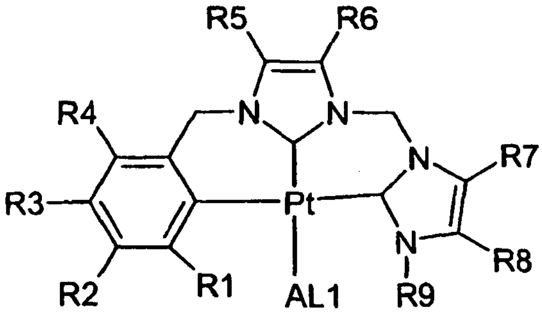

**48**

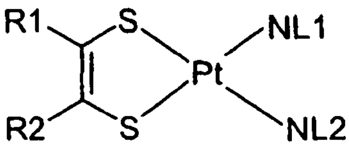

**49**

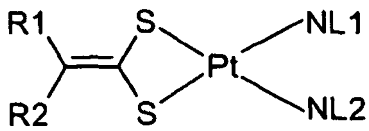

**50**

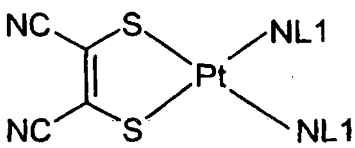

**51**

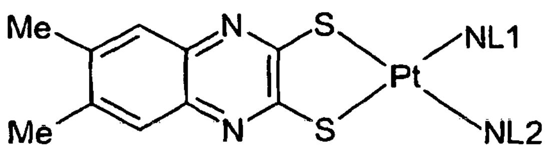

**52**

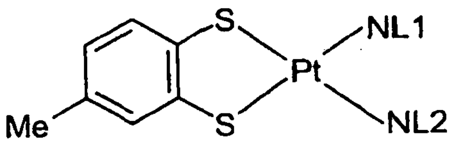

**53**

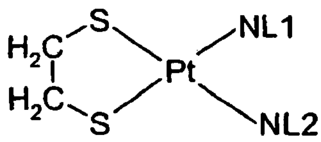

**54**

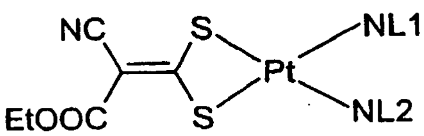

**55**

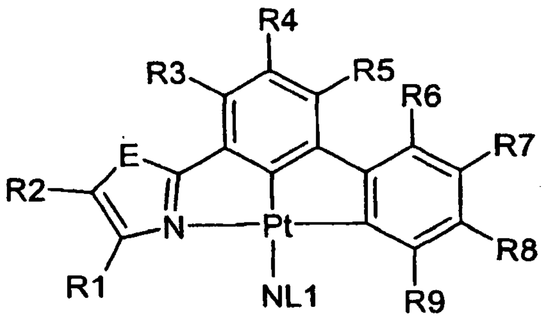

**56**

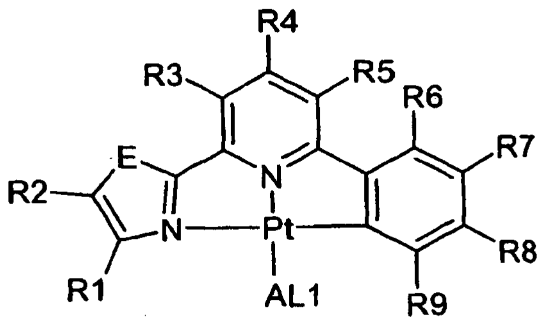

57

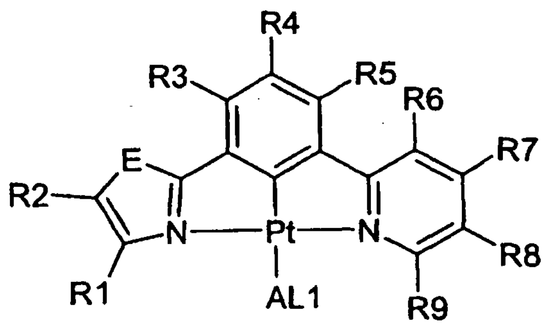

58

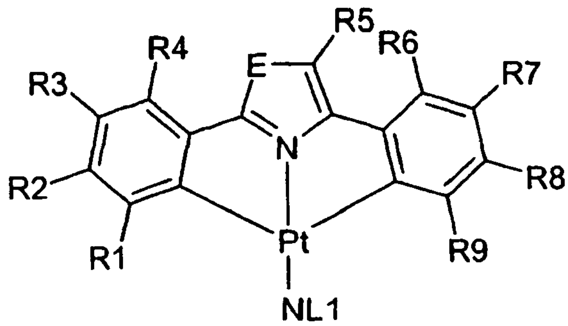

59

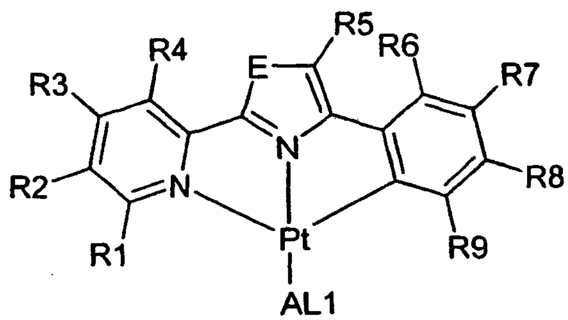

60

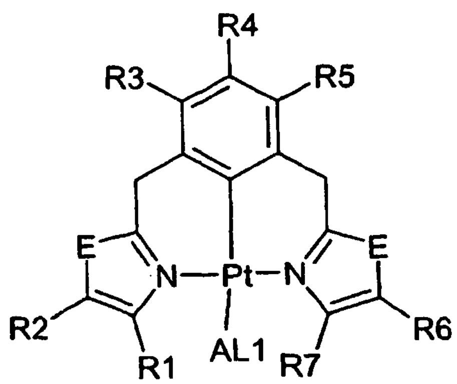

61

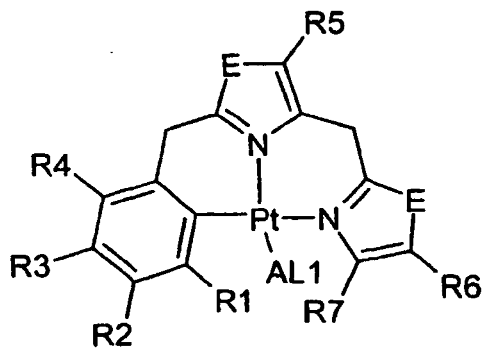

62

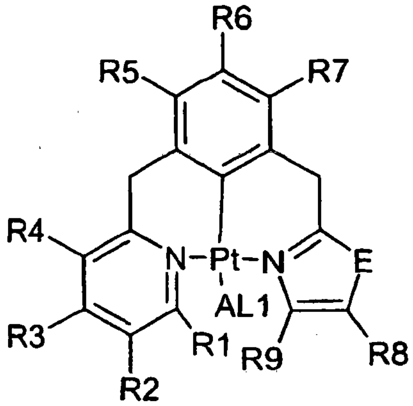

63

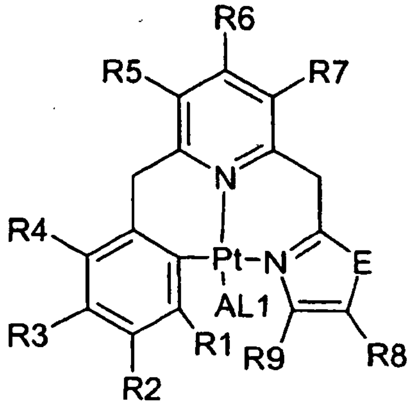

64

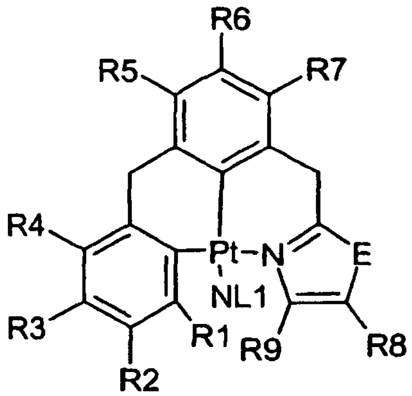

65

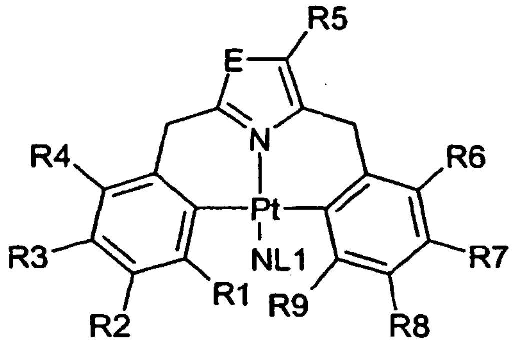

66

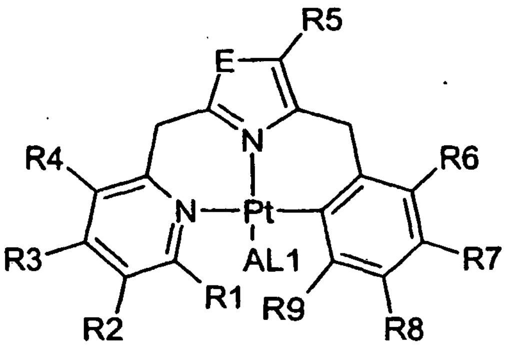

67

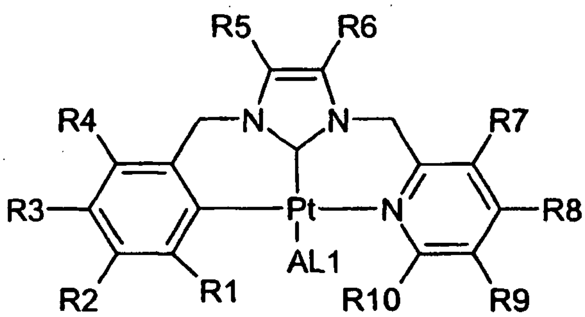

68

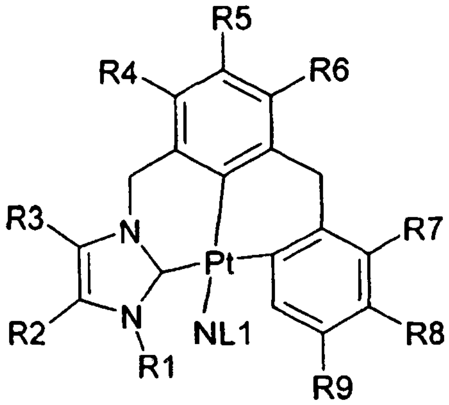

69

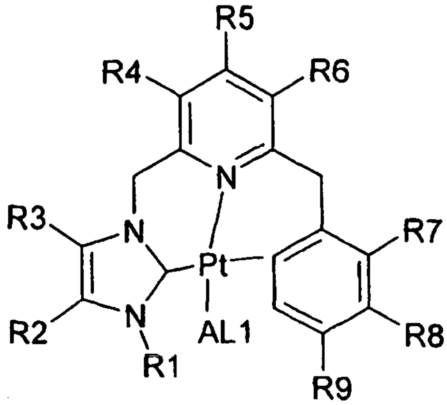

70

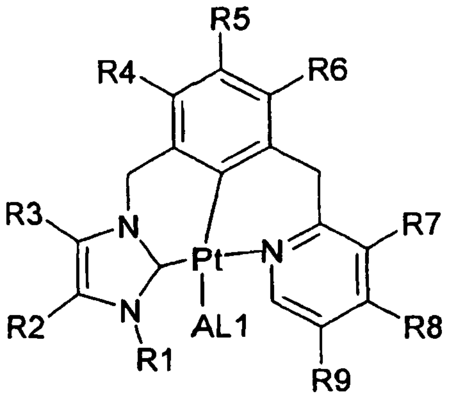

71

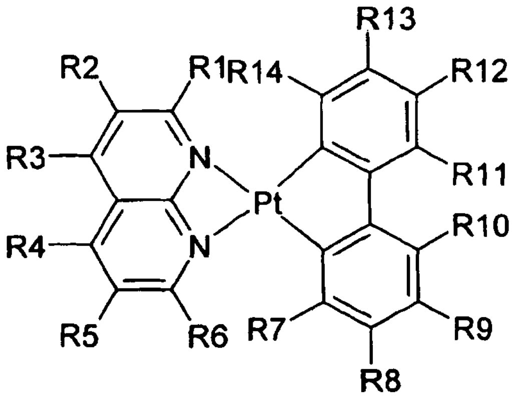

72

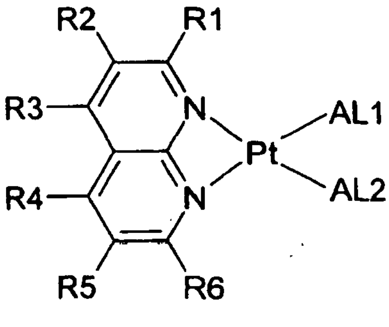

73

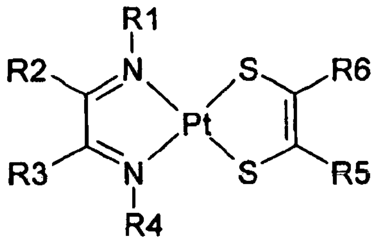

74

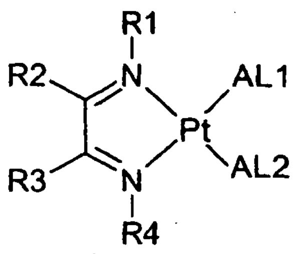

75

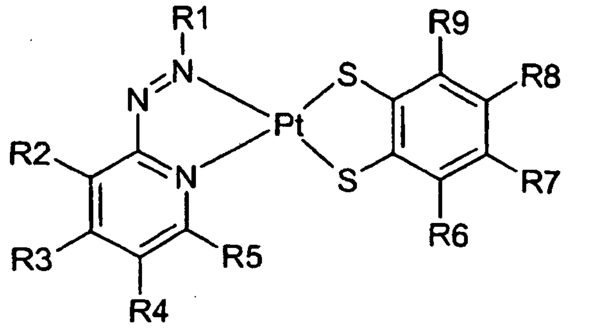

76

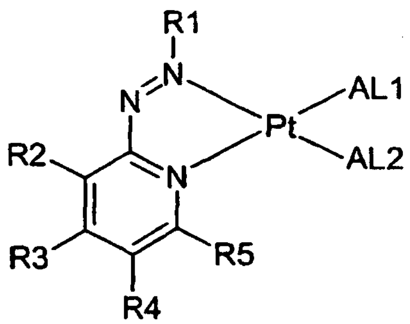

77

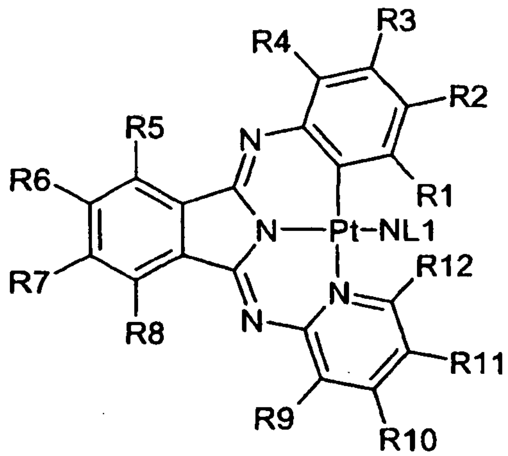

78

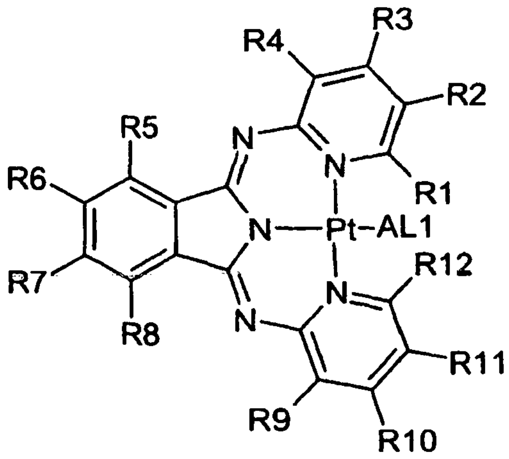

79

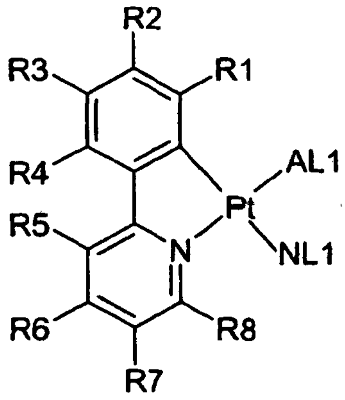

80

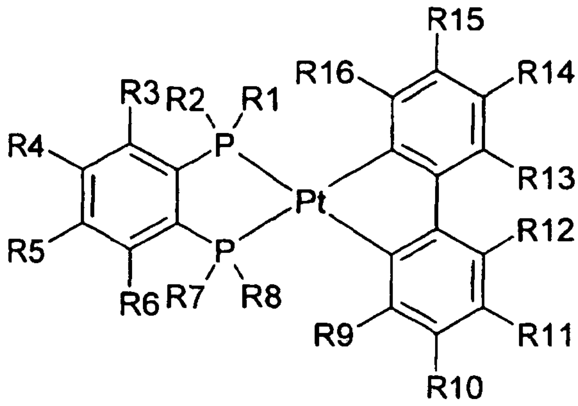

81

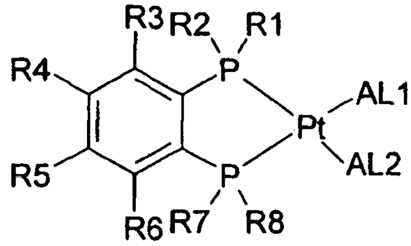

82

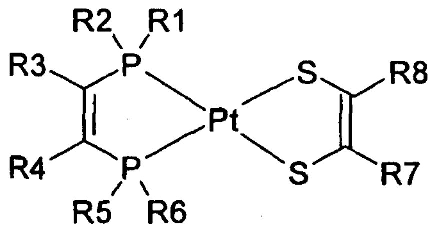

83

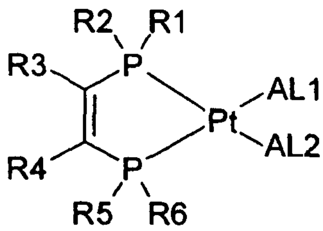

84

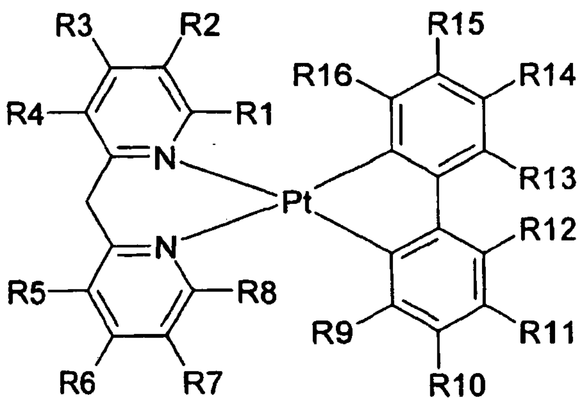

85

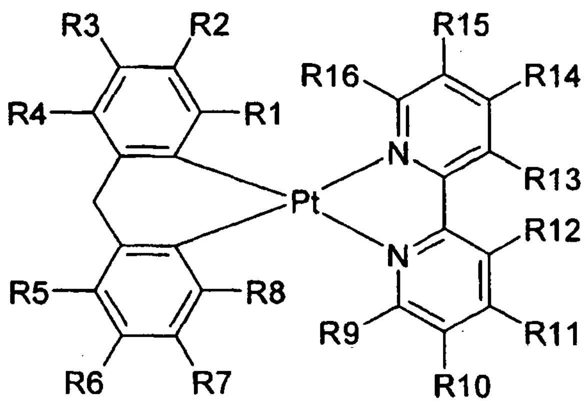

86

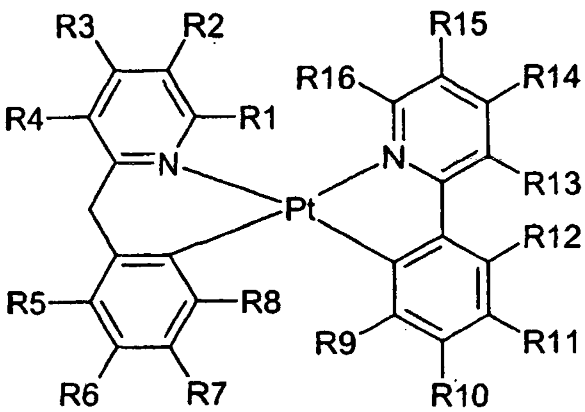

87

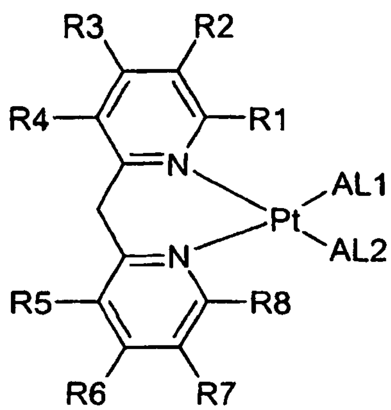

88

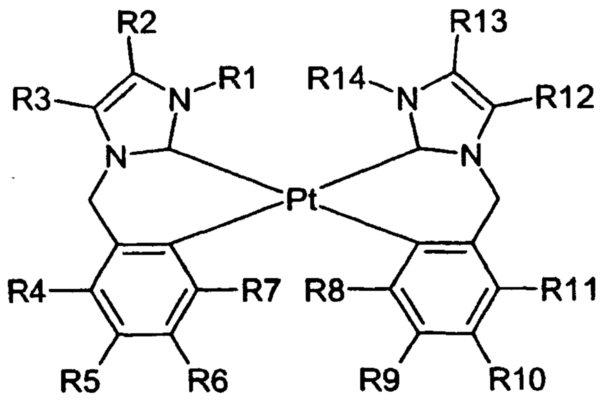

89

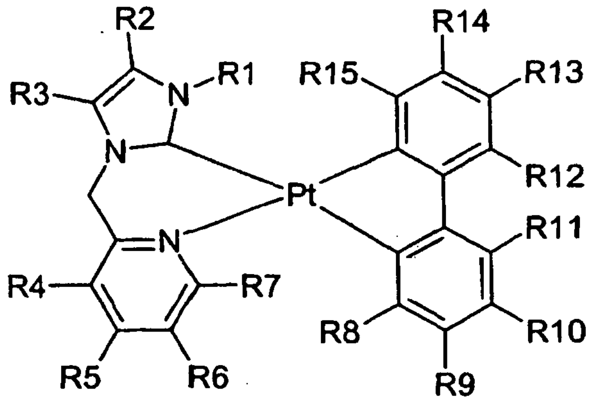

90

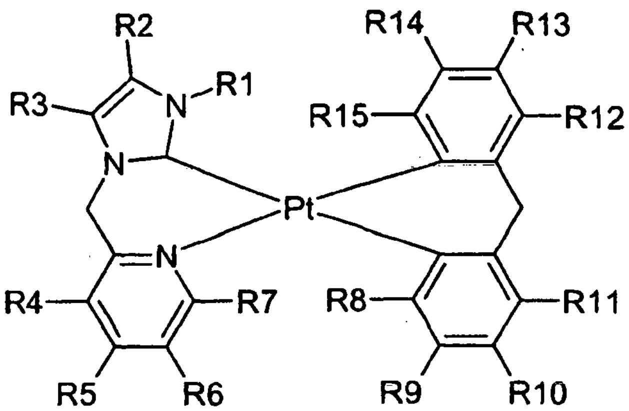

91

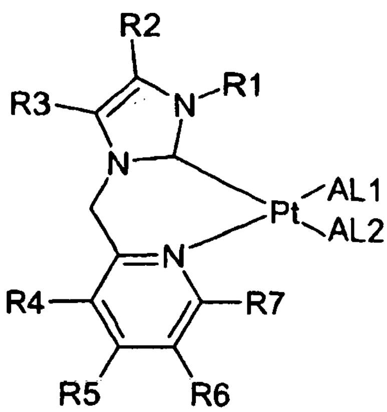

92

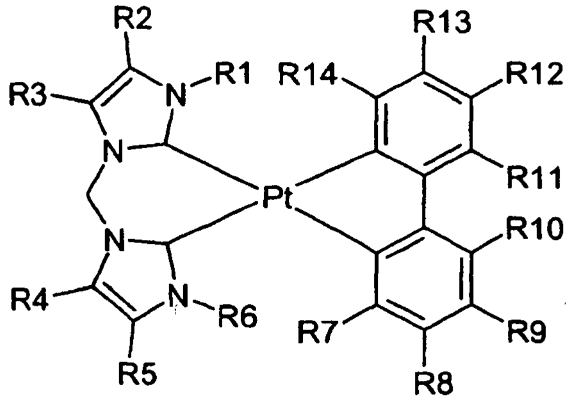

93

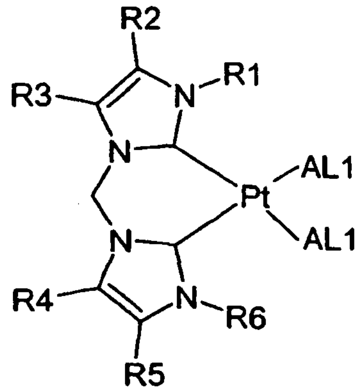

94

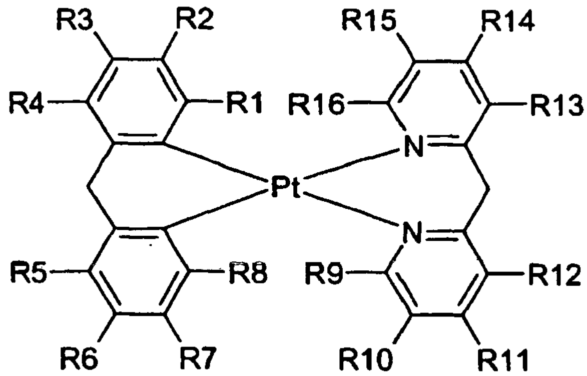

95

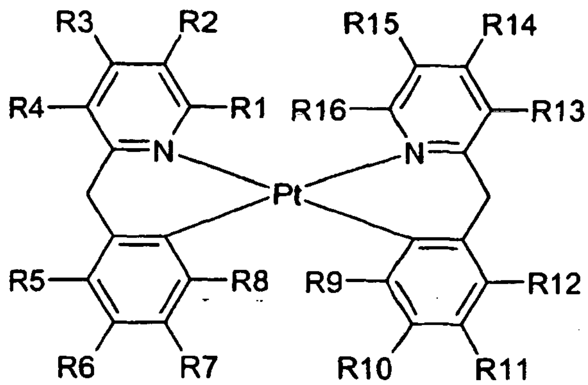

96

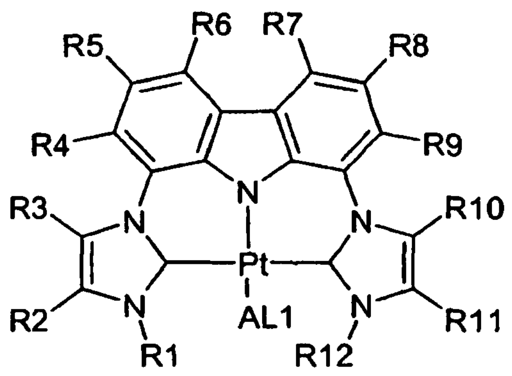

97

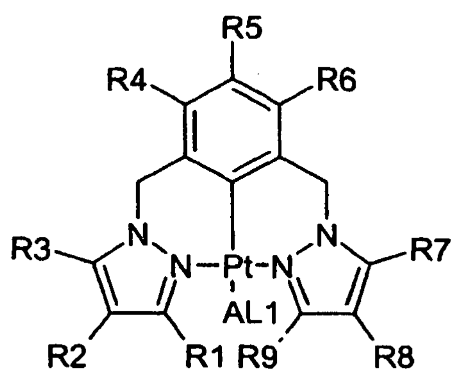

98

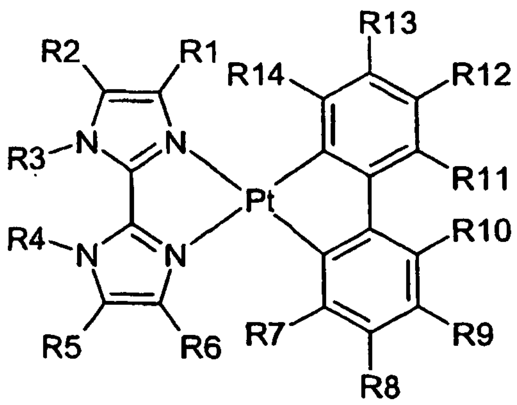

99

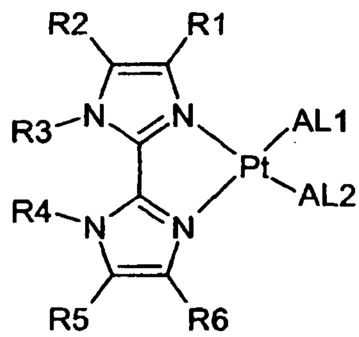

100

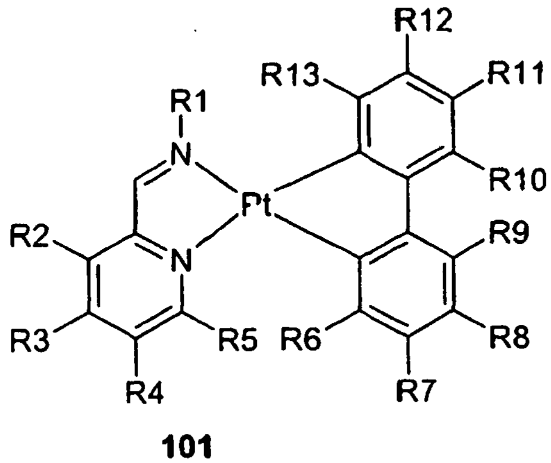

101

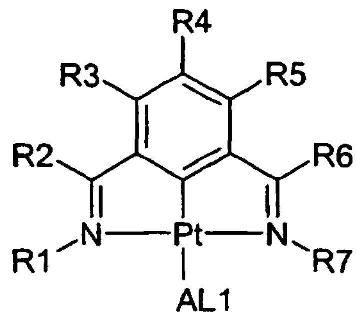

102

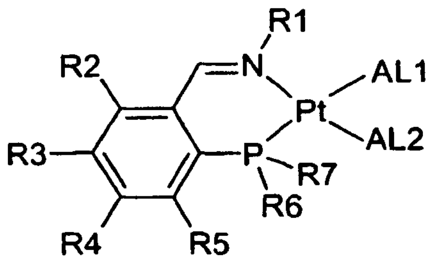

**103**

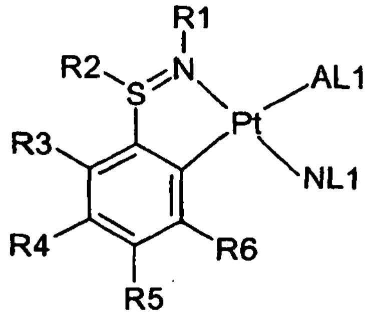

**104**

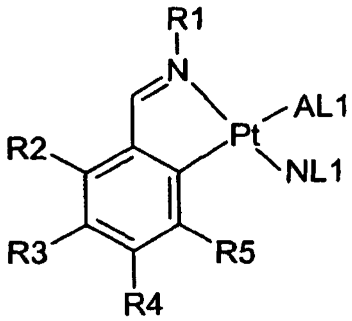

**105**

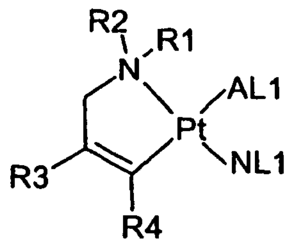

**106**

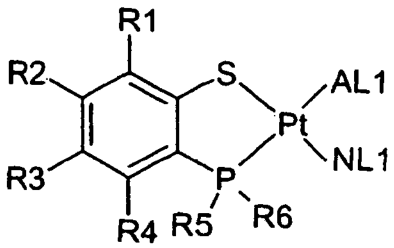

**107**

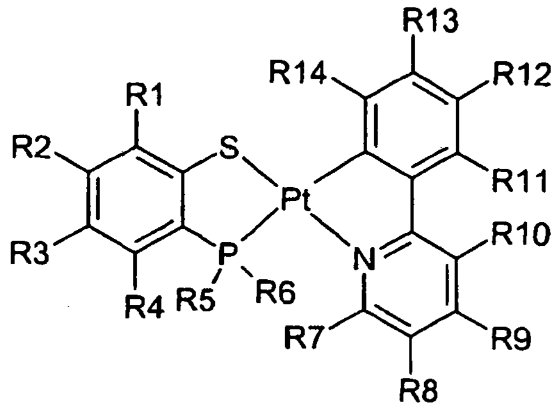

**108**

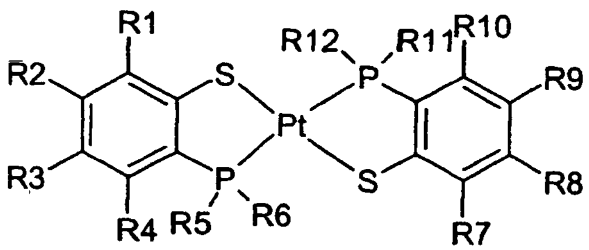

**109**

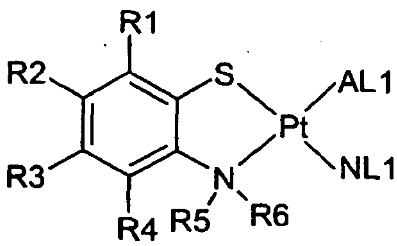

**110**

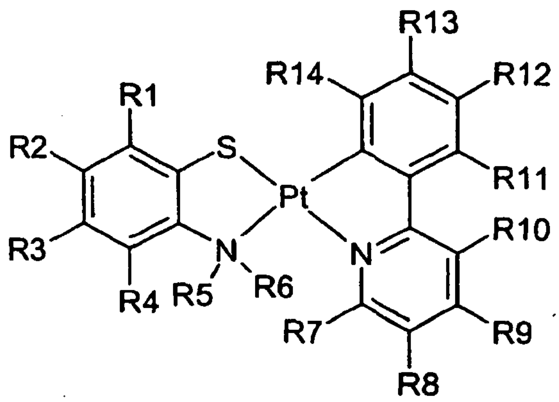

**111**

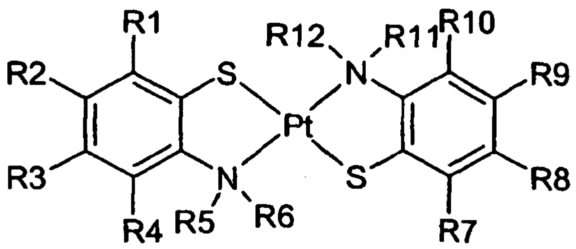

**112**

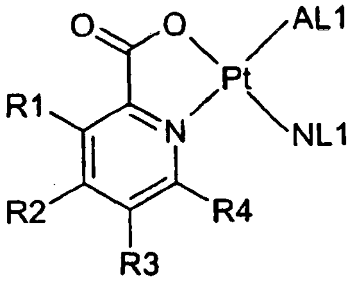

**113**

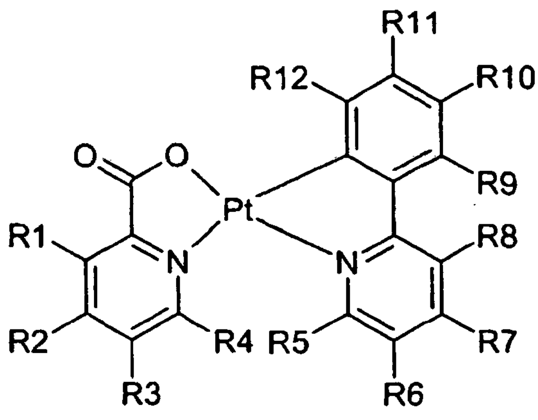

**114**

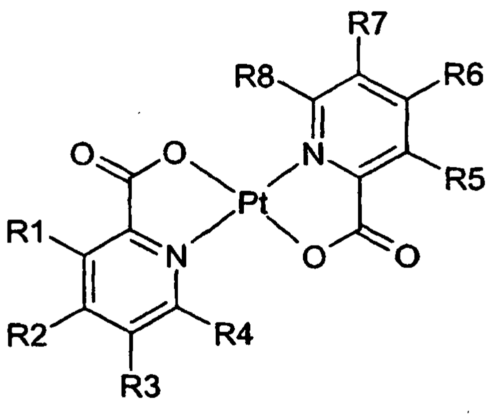

**115**

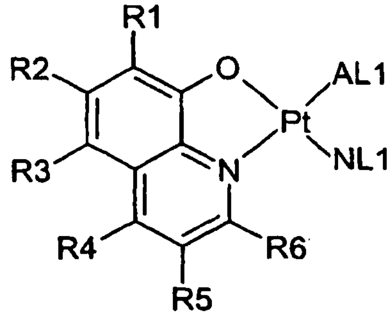

**116**

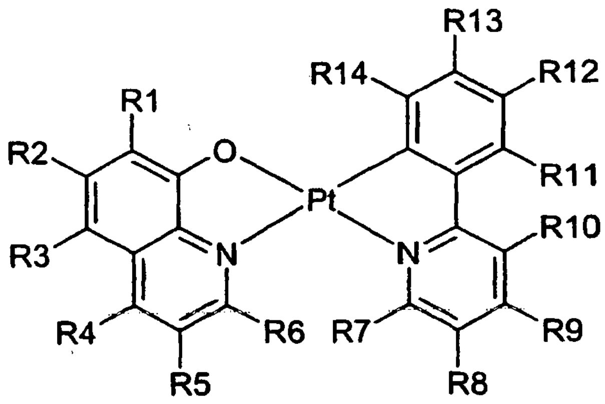

**117**

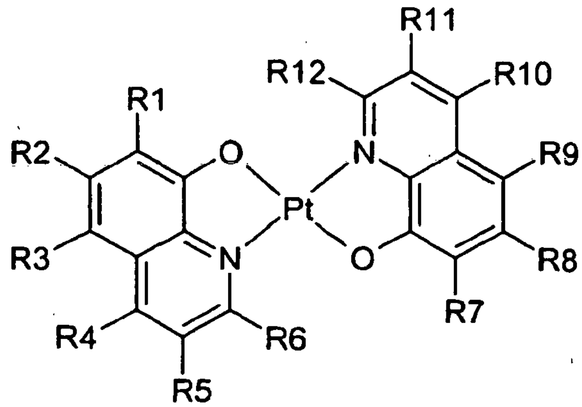

**118**

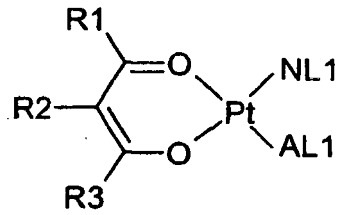

**119**

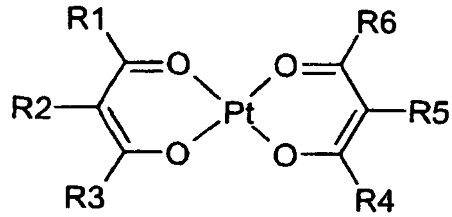

**120**

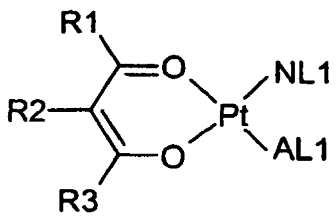

**121**

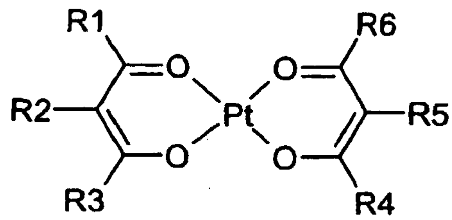

**122**

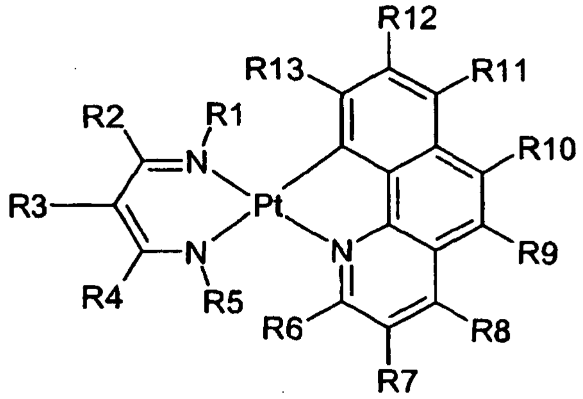

123

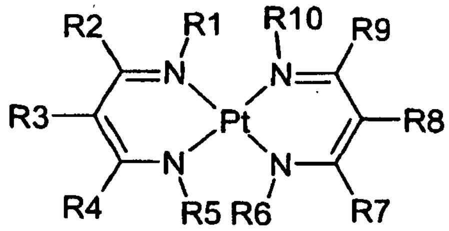

124

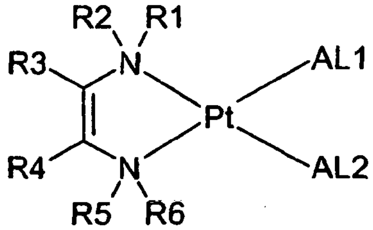

125

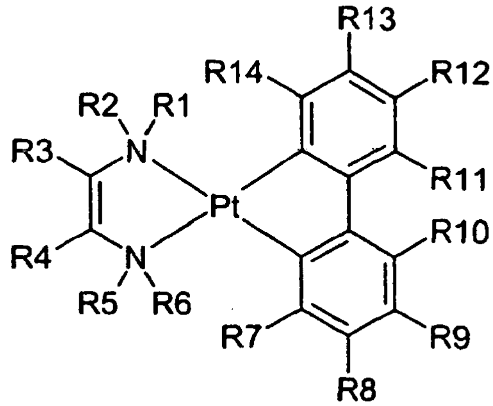

126

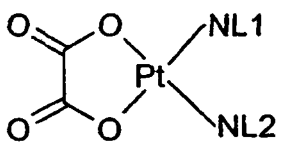

127

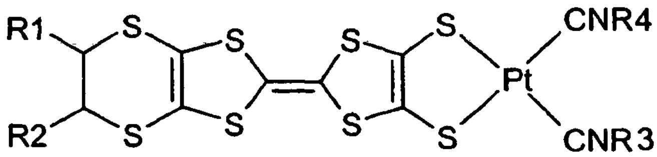

128

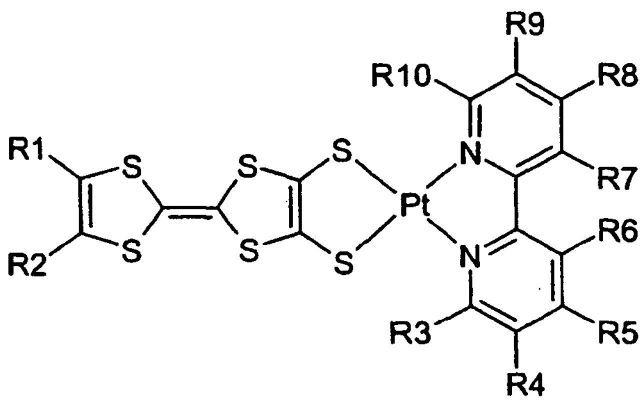

129

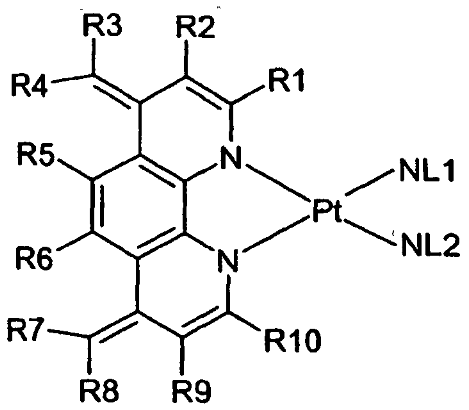

130

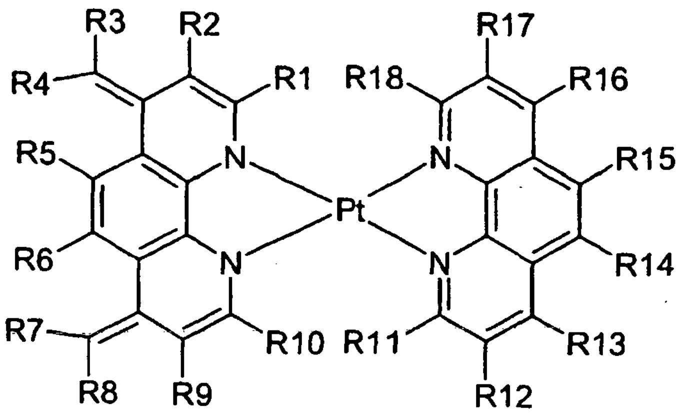

131

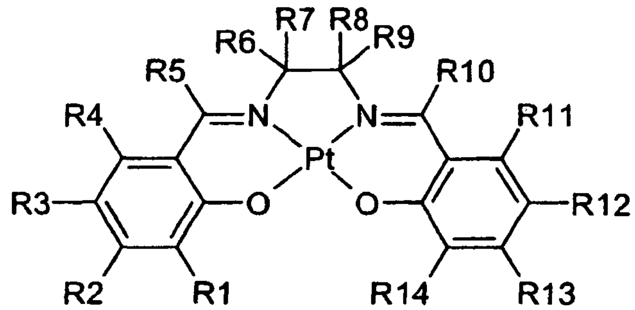

132

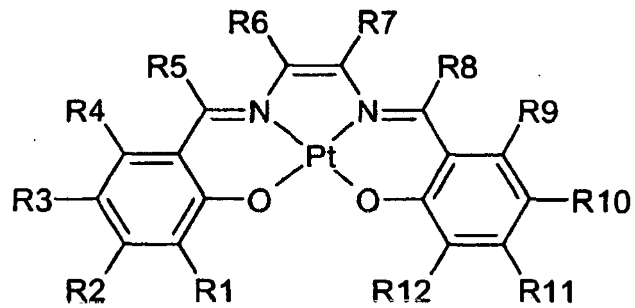

133

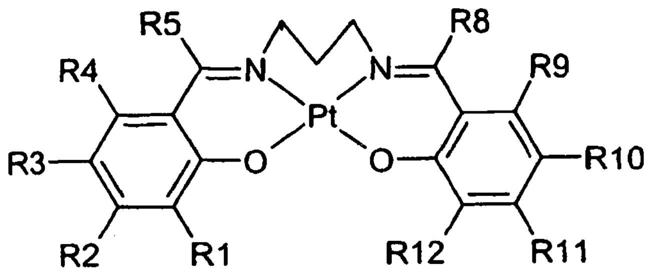

**134**

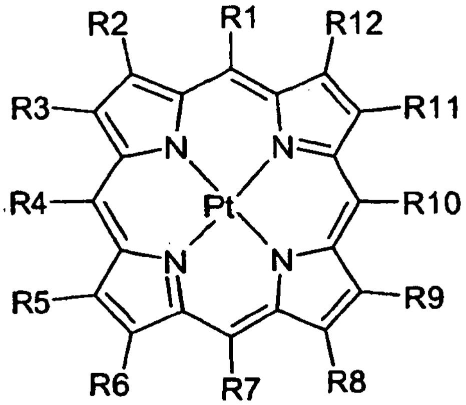

**135**

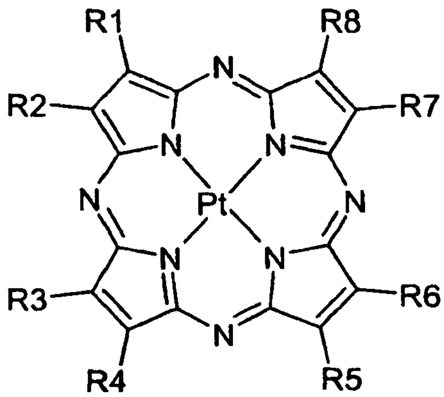

**136**

Pd(II)-Komplexe

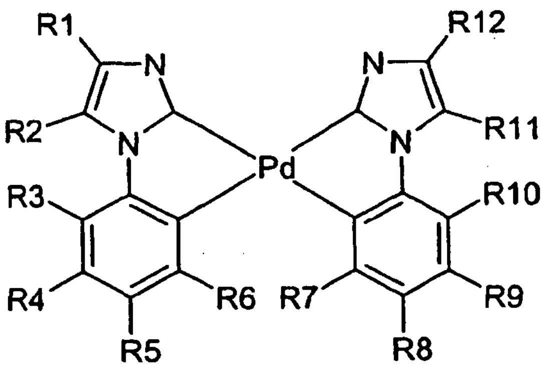

**137**

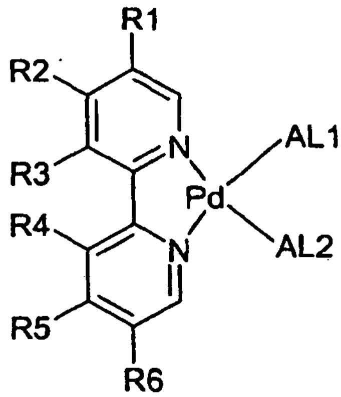

**138**

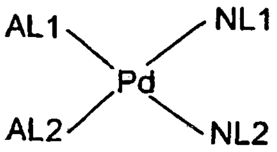

139

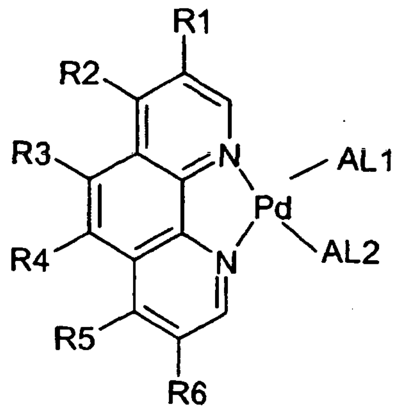

140

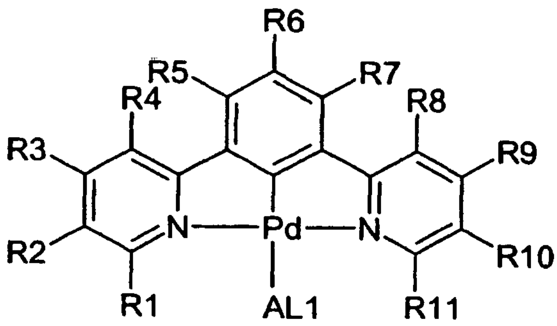

141

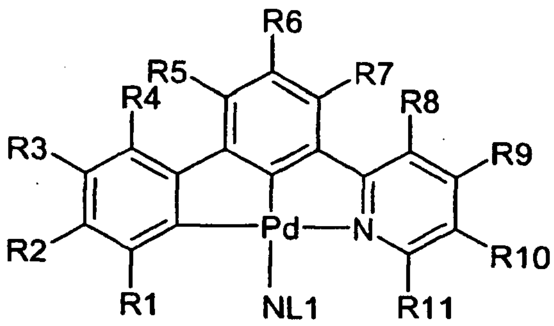

142

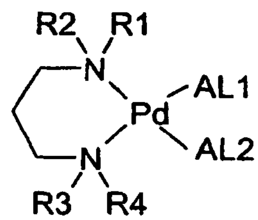

143

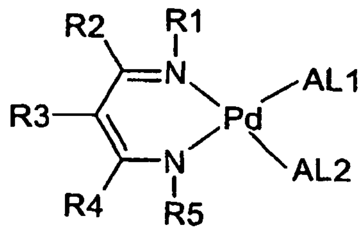

144

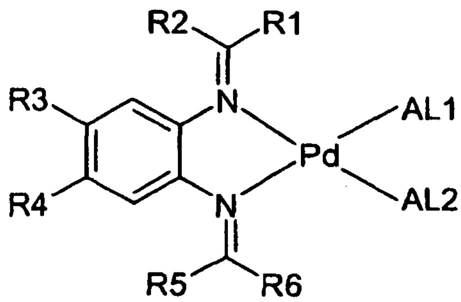

145

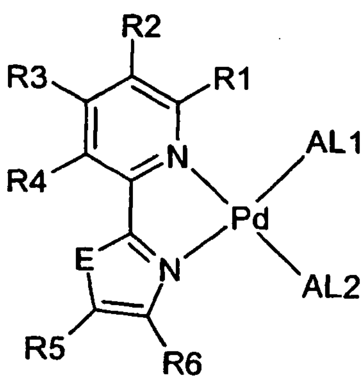

146

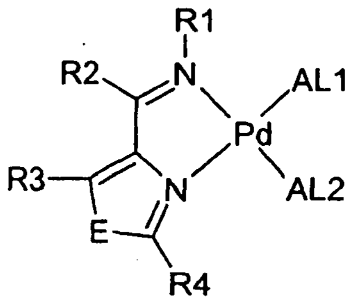

**147**

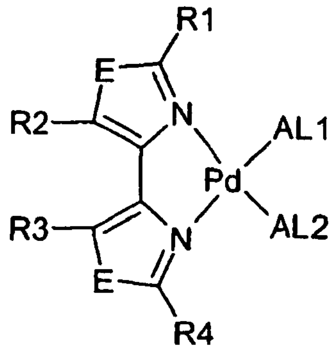

**148**

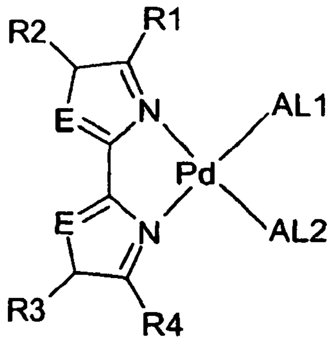

**149**

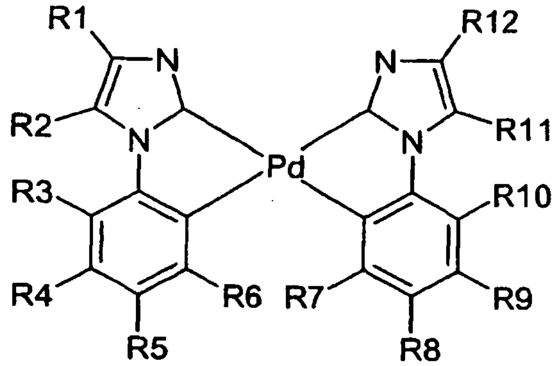

**150**

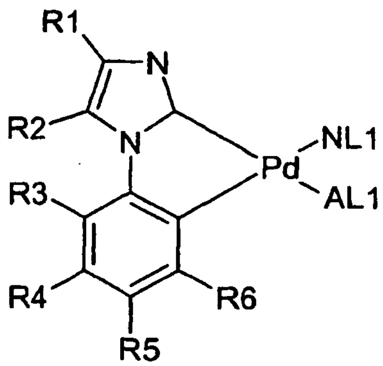

**151**

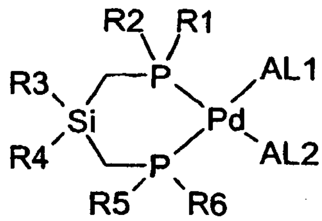

**152**

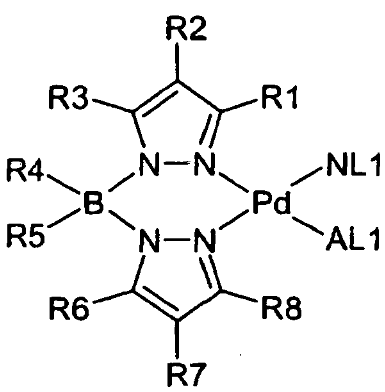

**153**

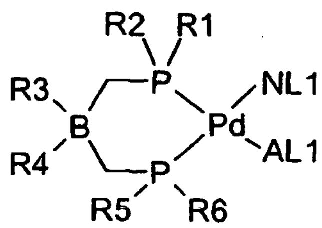

**154**

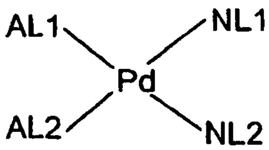

155

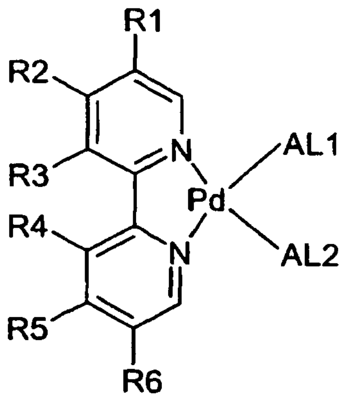

156

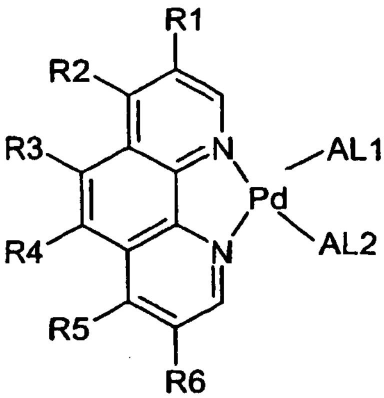

157

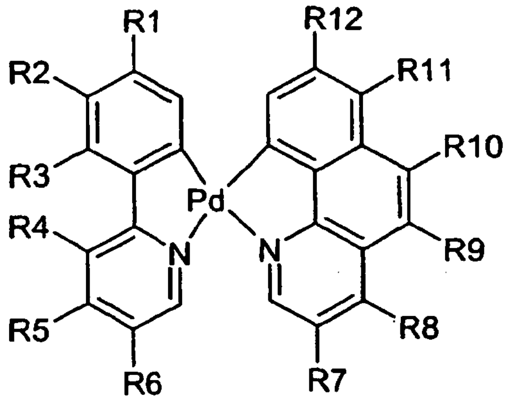

158

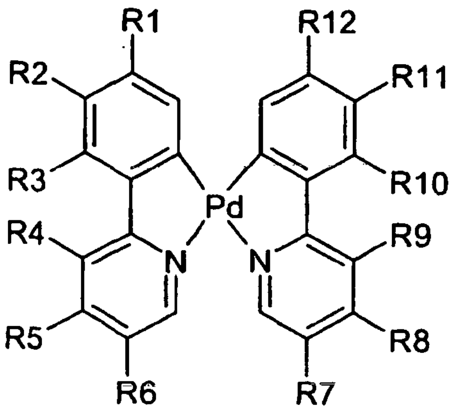

159

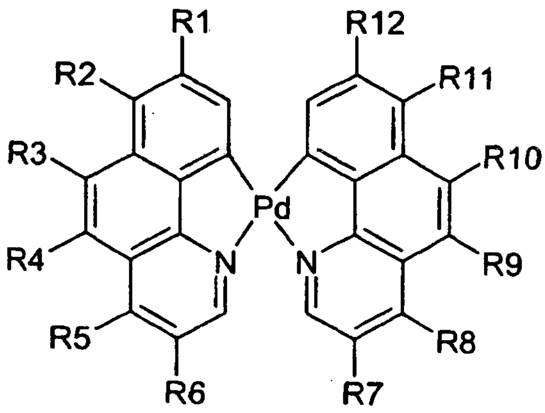

160

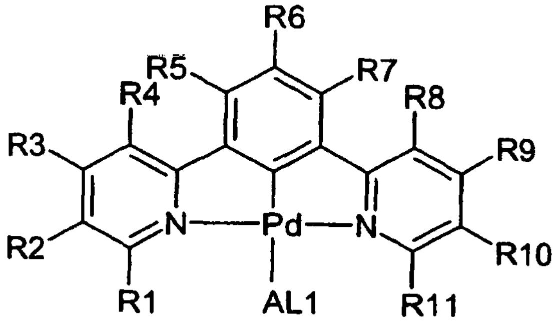

**161**

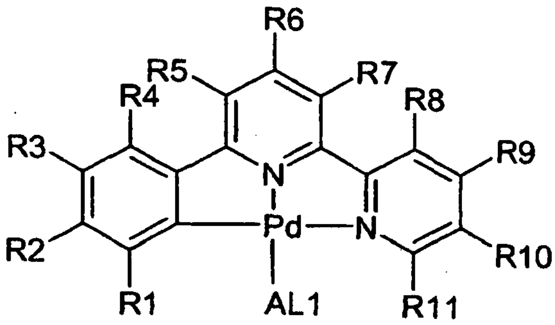

**162**

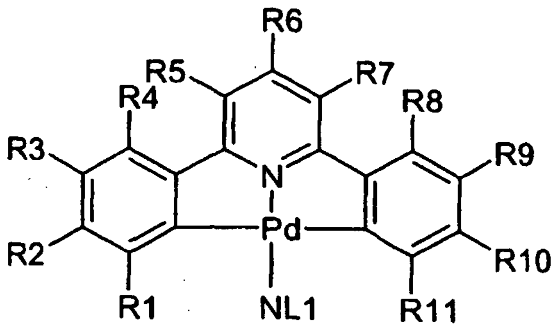

**163**

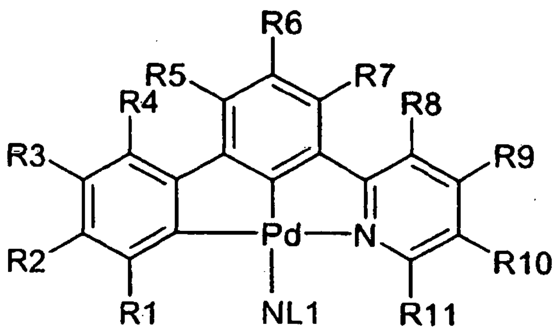

**164**

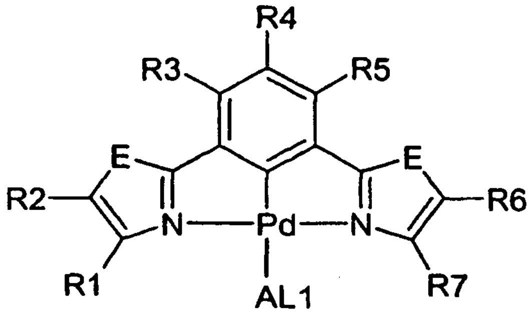

165

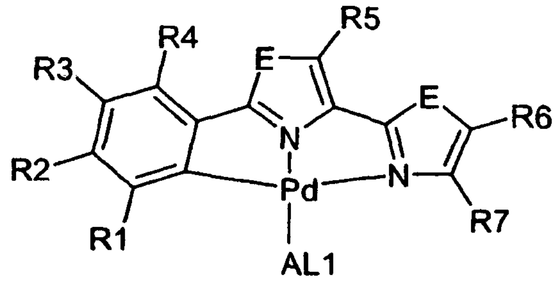

166

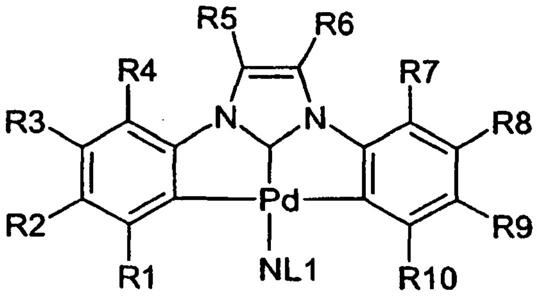

167

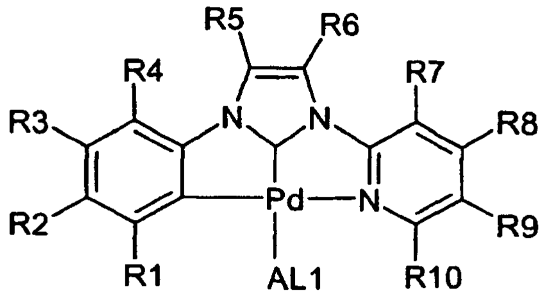

168

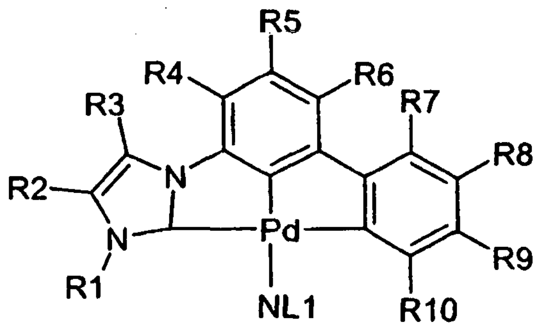

169

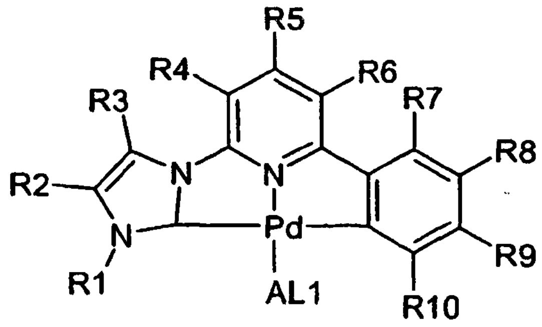

170

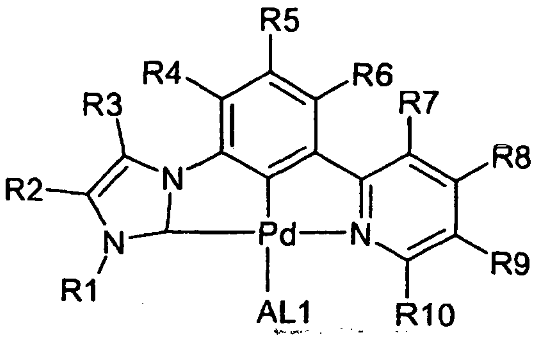

171

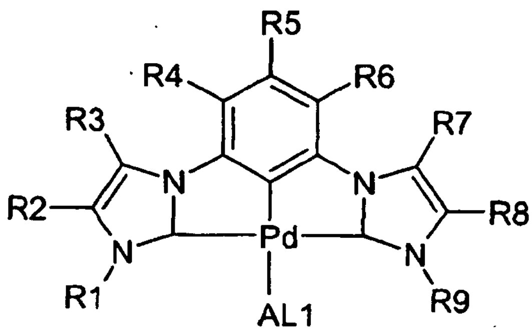

172

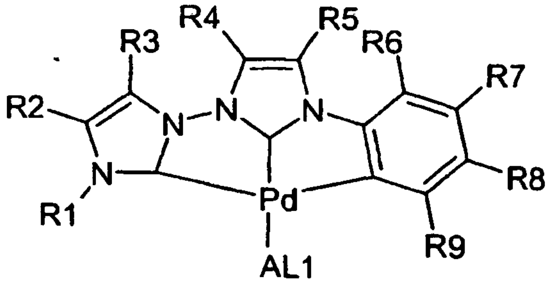

173

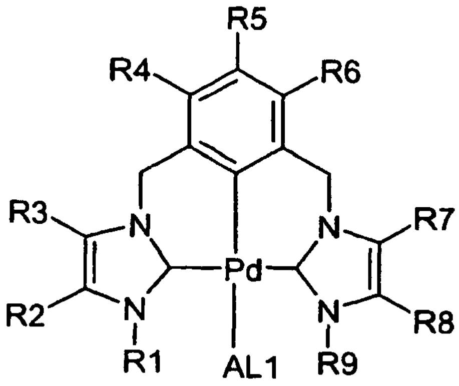

174

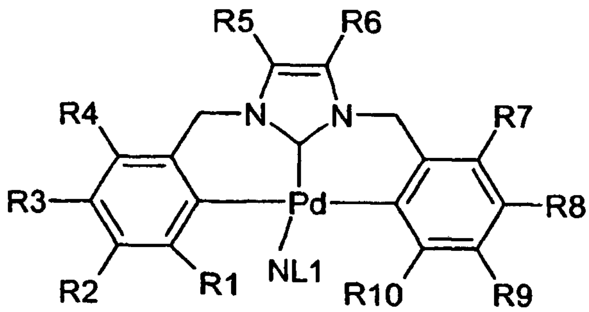

175

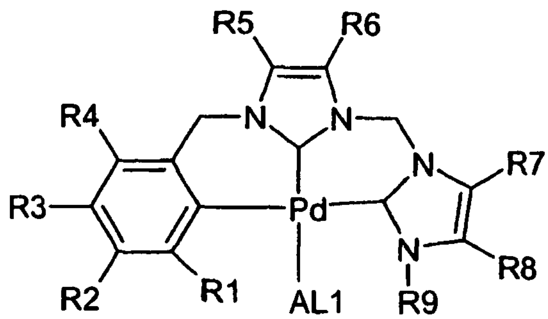

176

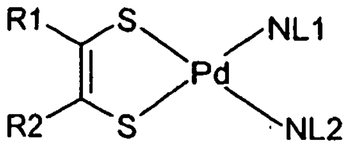

177

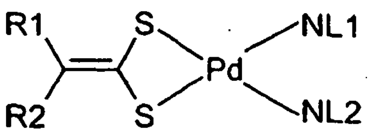

178

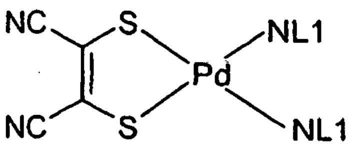

179

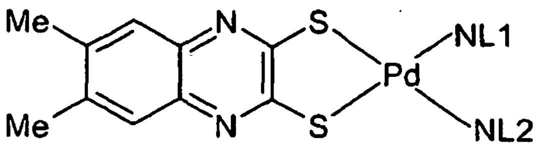

180

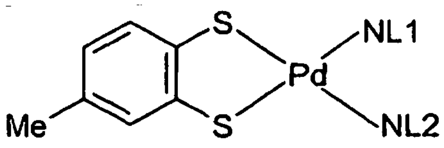

181

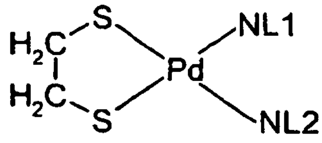

182

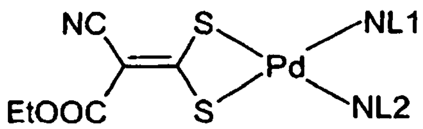

183

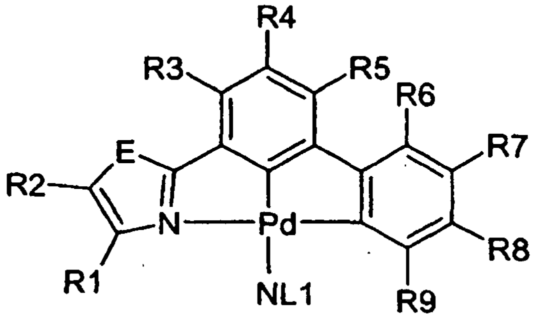

184

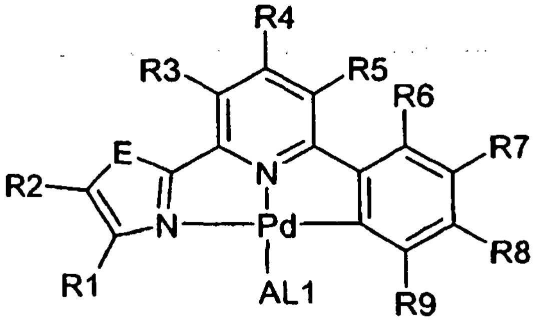

185

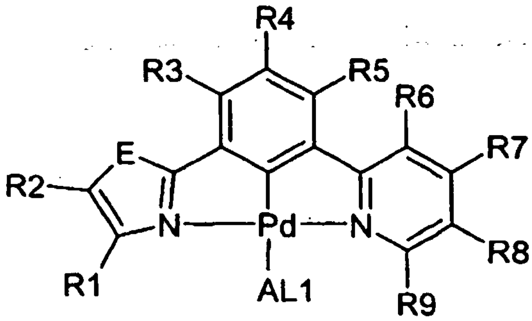

186

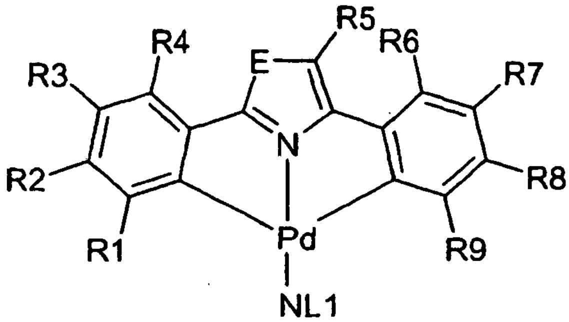

187

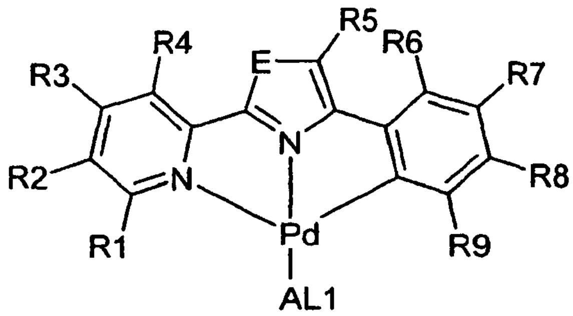

**188**

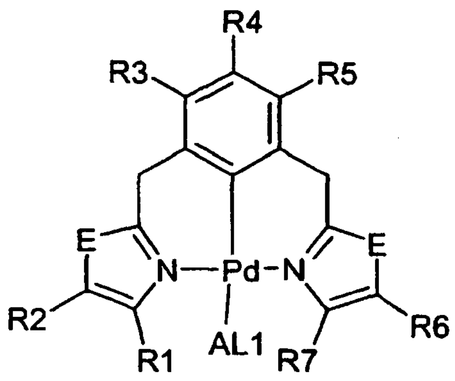

**189**

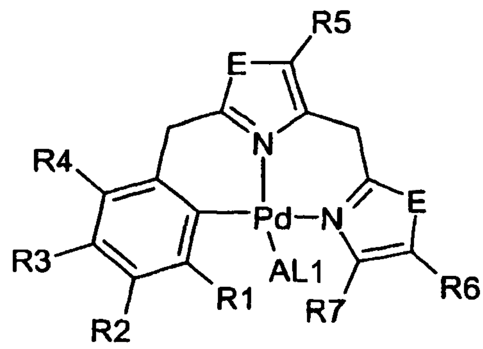

**190**

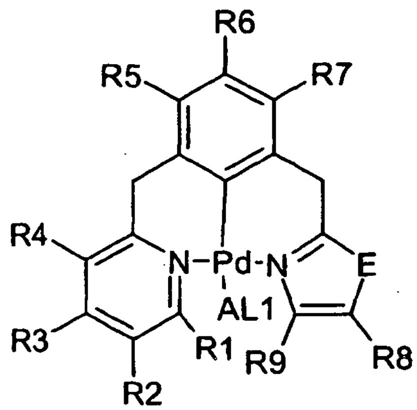

**191**

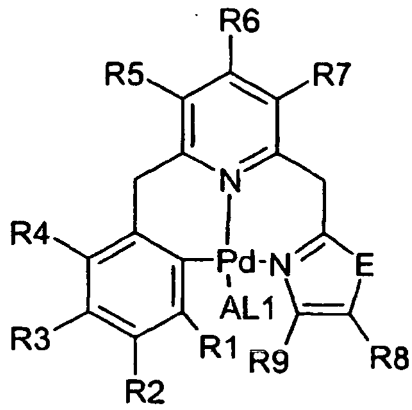

**192**

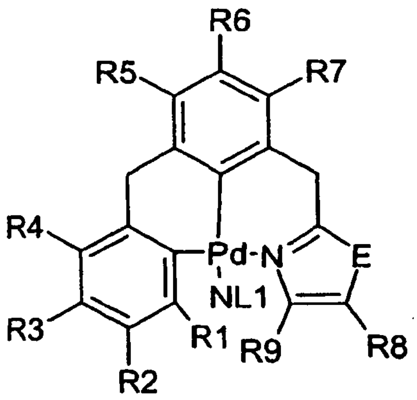

**193**

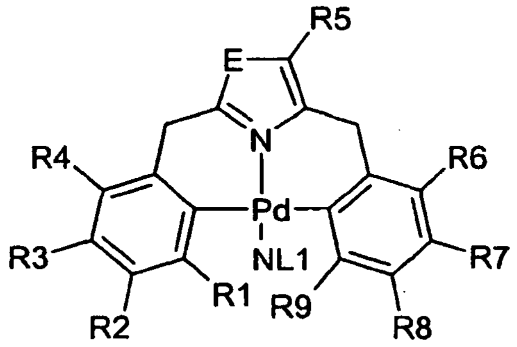

**194**

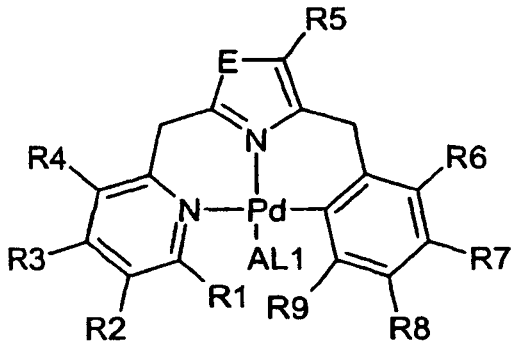

**195**

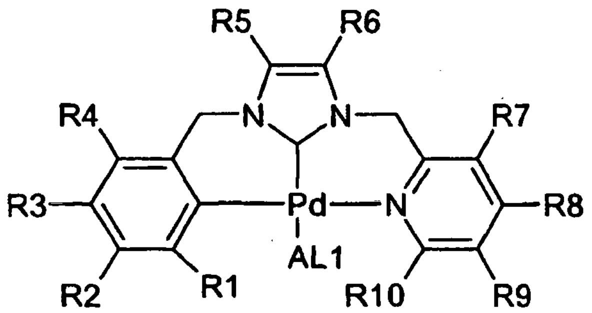

**196**

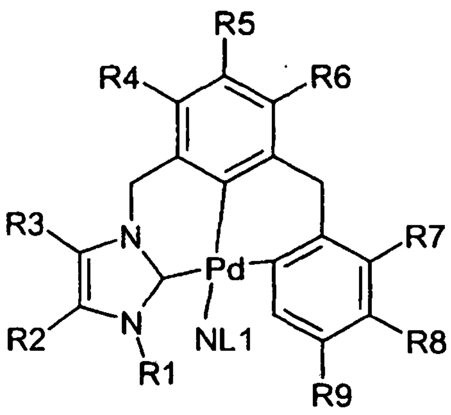

**197**

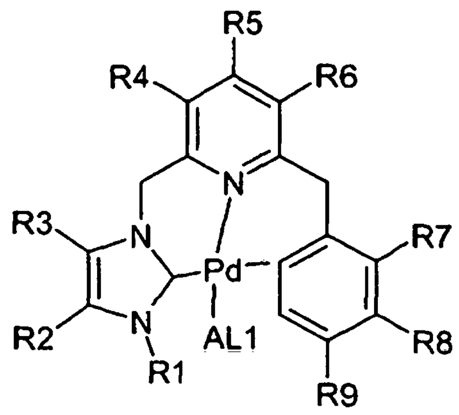

**198**

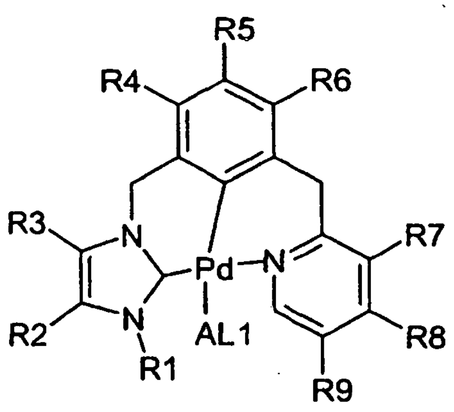

199

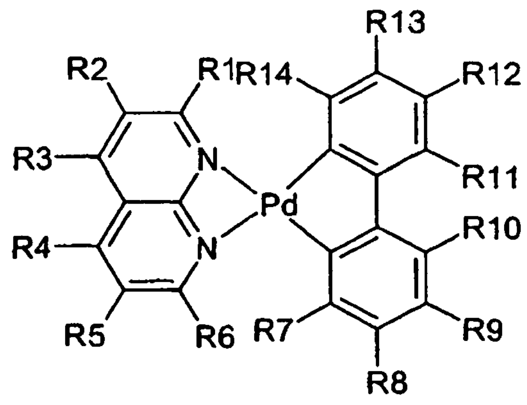

200

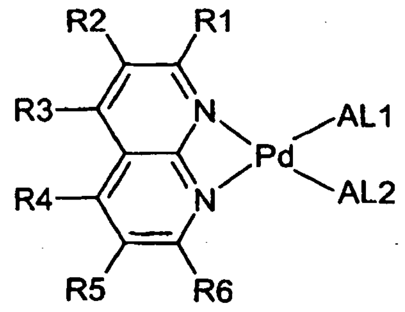

201

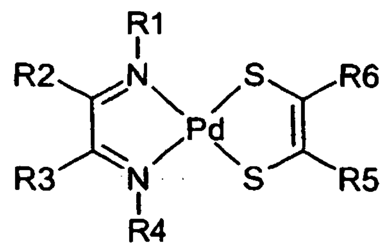

202

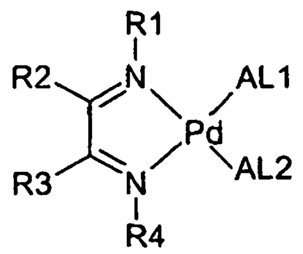

203

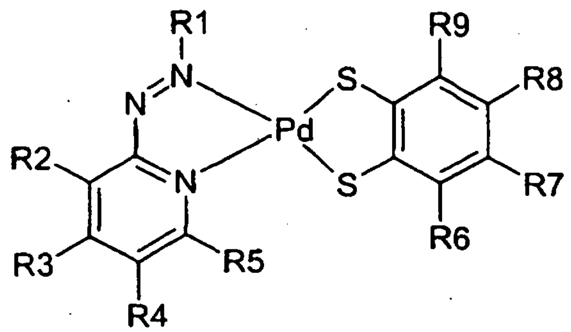

204

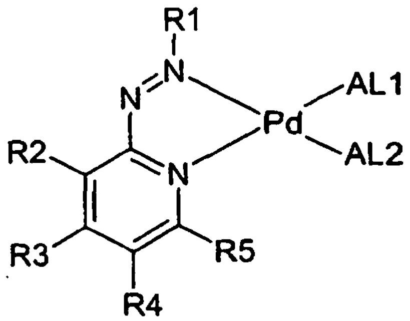

**205**

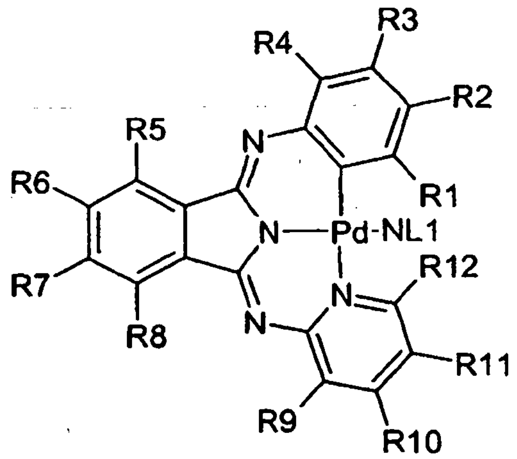

**206**

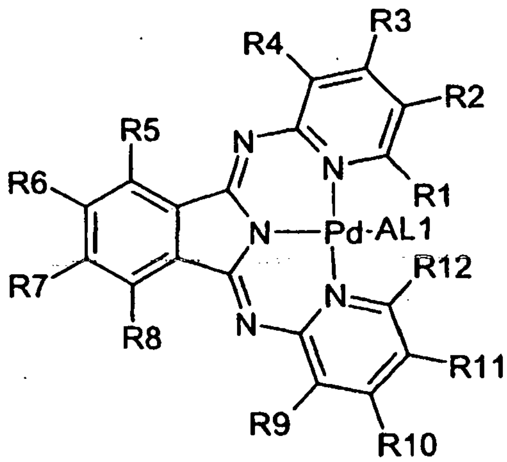

**207**

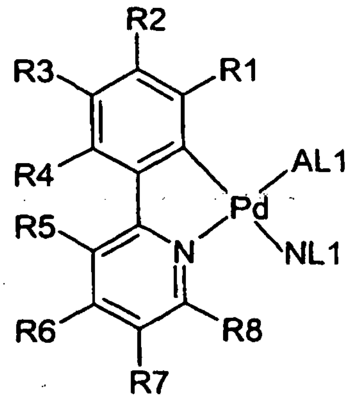

**208**

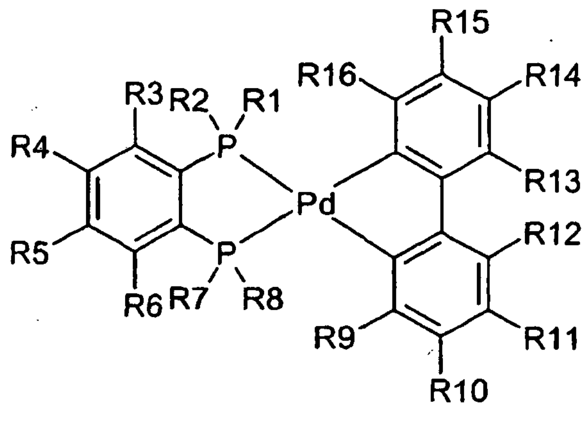

**209**

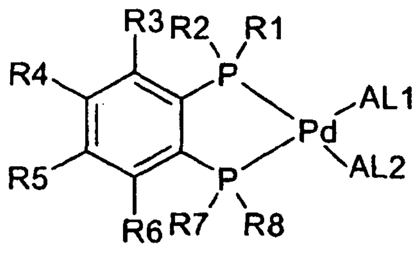

**210**

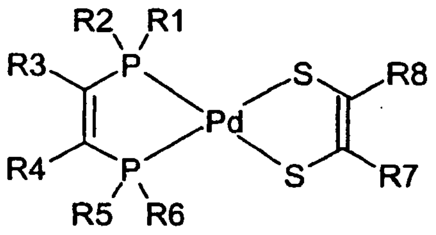

211

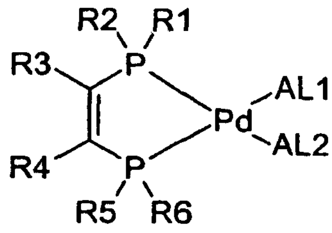

212

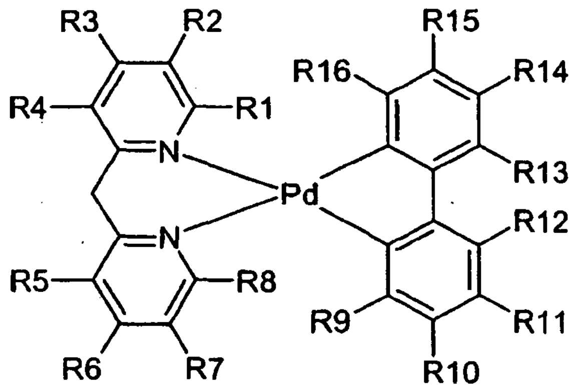

213

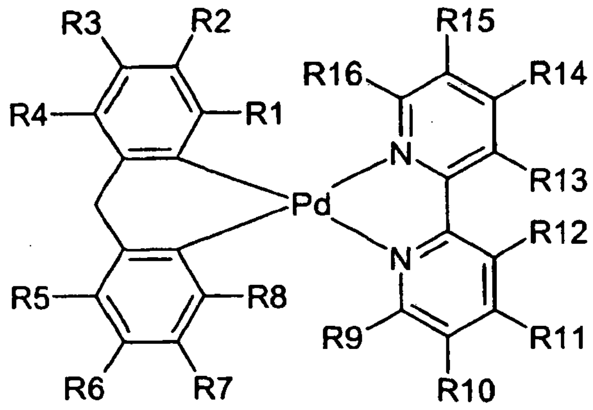

214

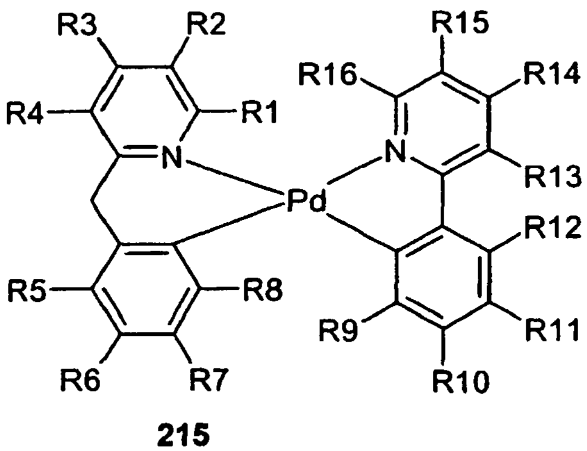

215

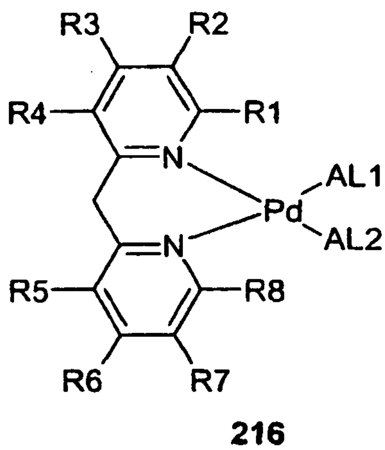

216

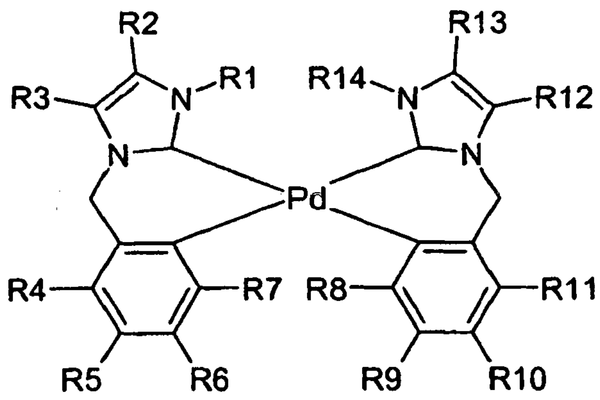

**217**

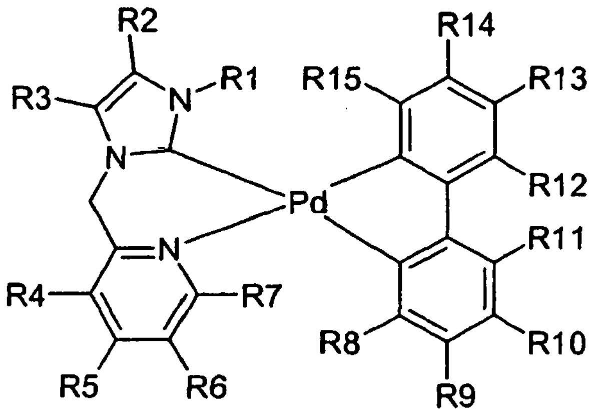

**218**

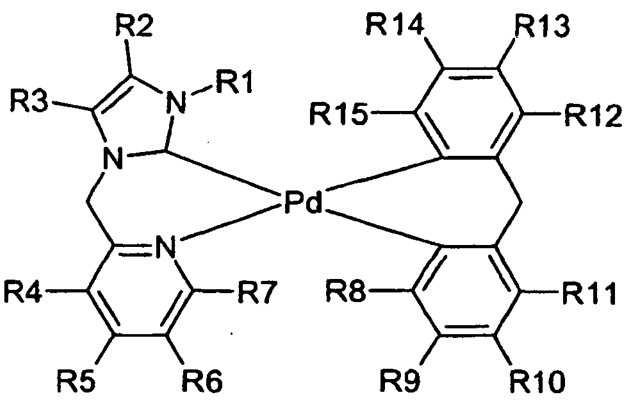

**219**

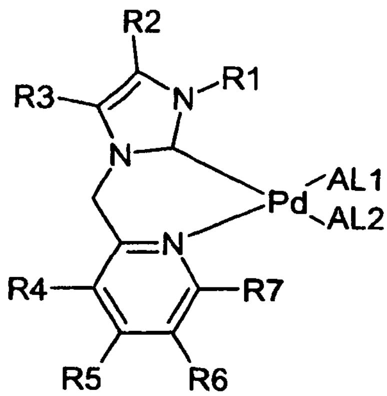

**220**

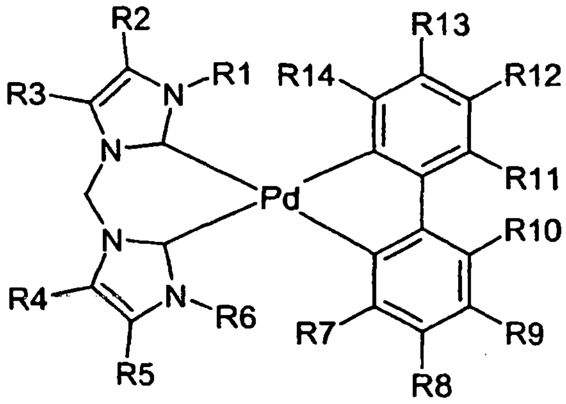

221

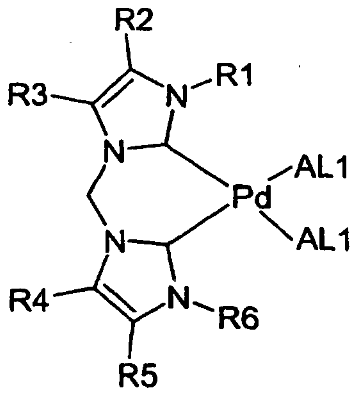

222

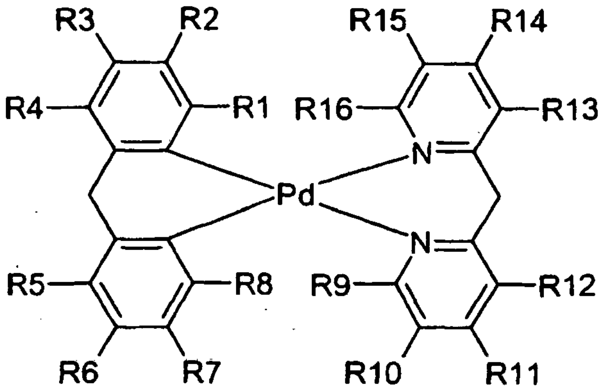

223

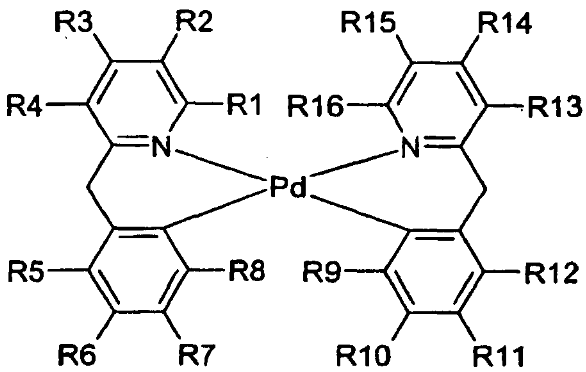

224

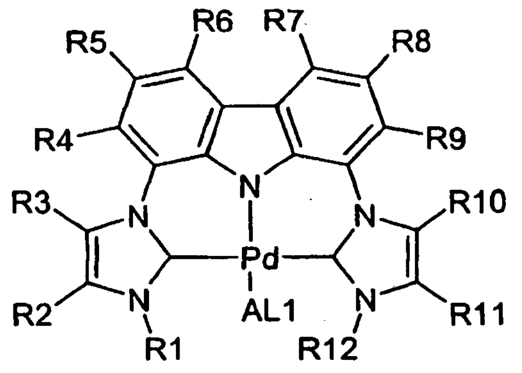

225

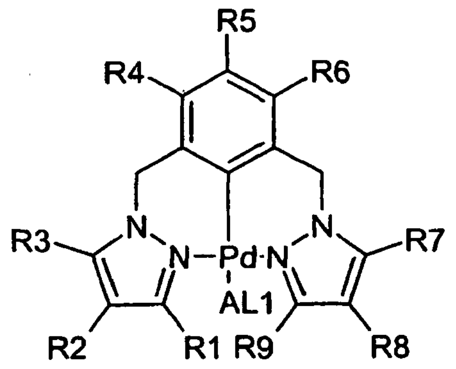

226

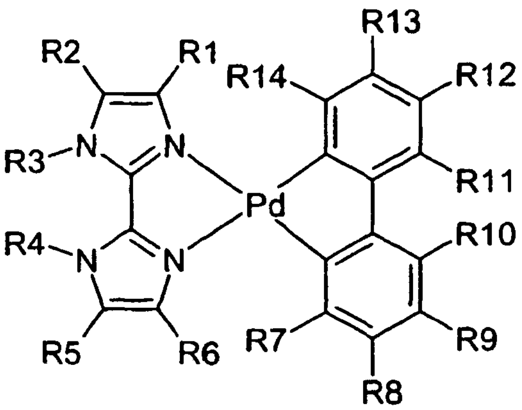

227

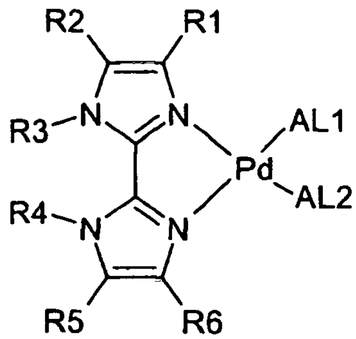

228

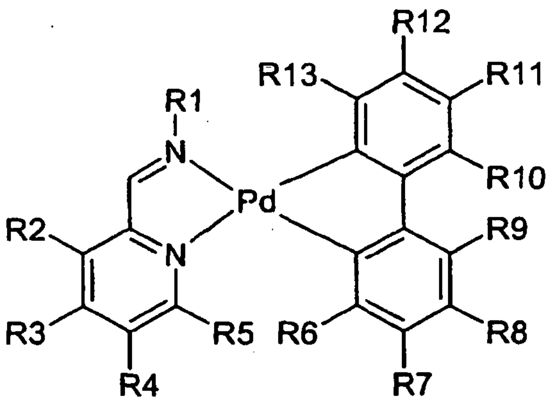

229

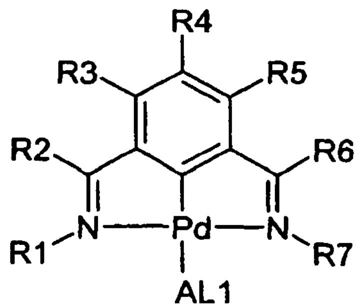

230

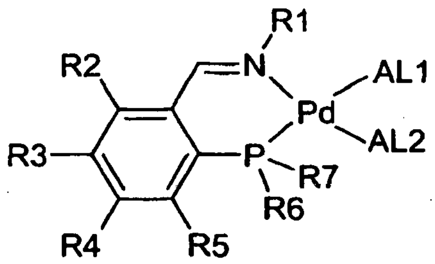

231

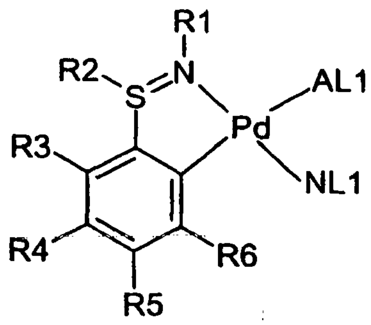

232

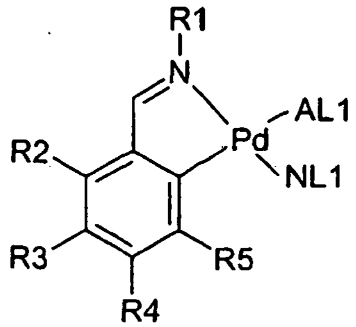

233

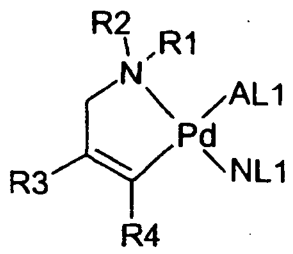

234

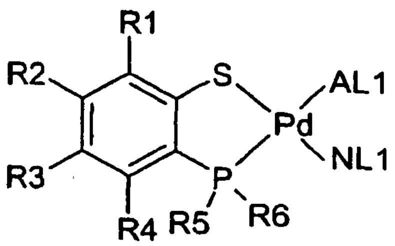

235

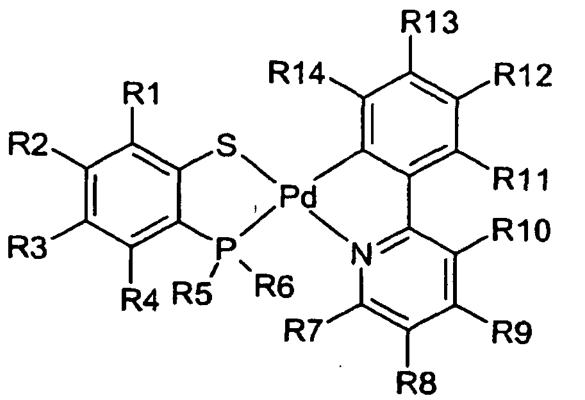

236

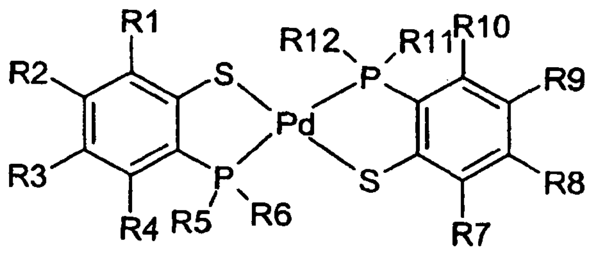

237

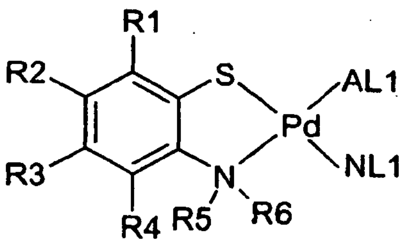

238

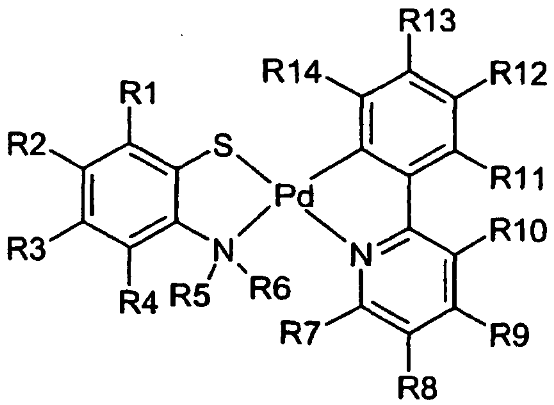

239

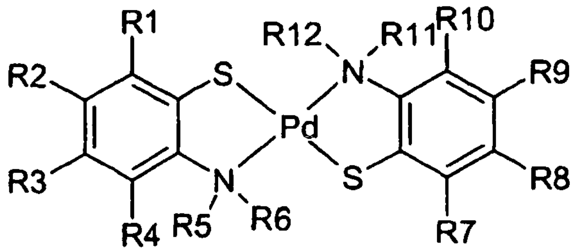

240

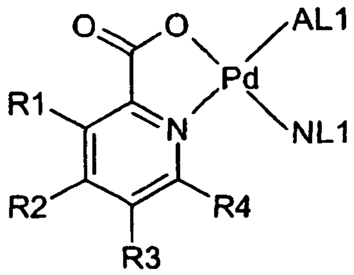

241

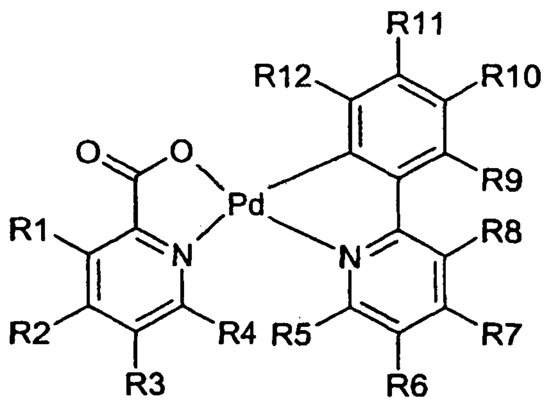

242

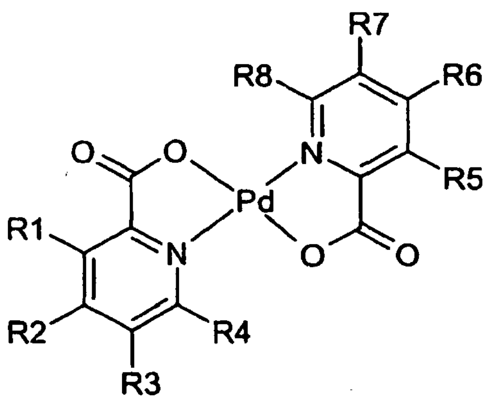

243

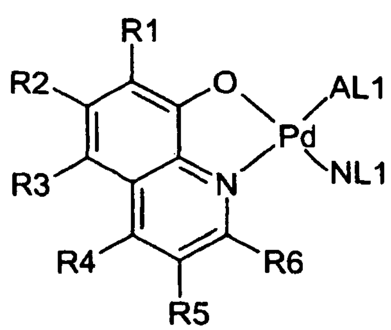

244

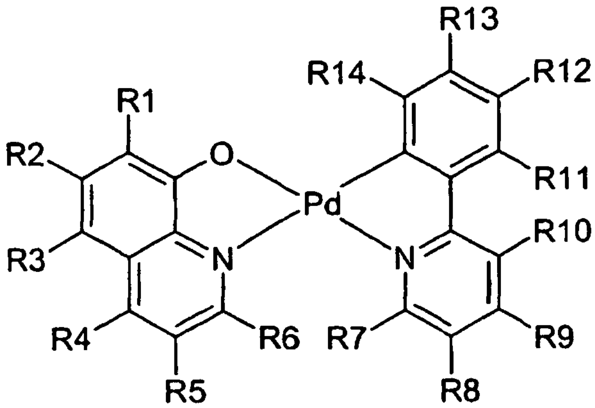

**245**

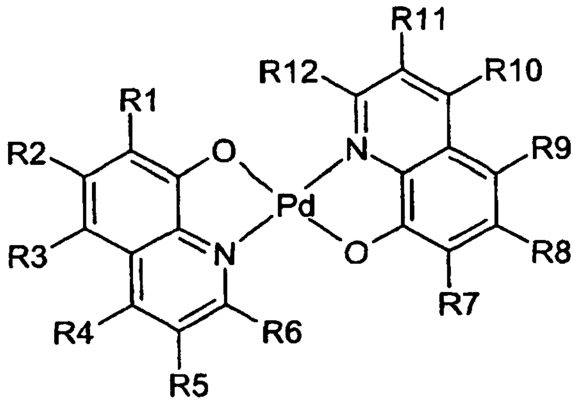

**246**

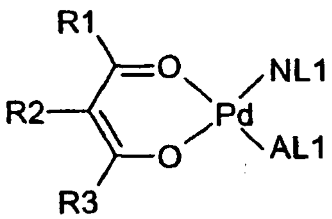

**247**

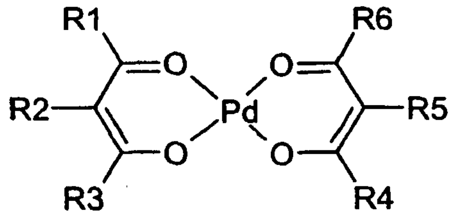

**248**

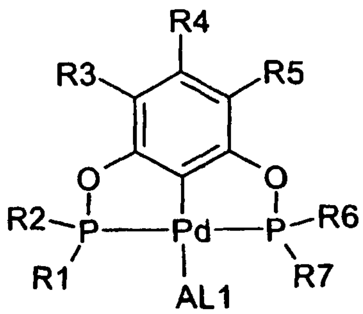

**249**

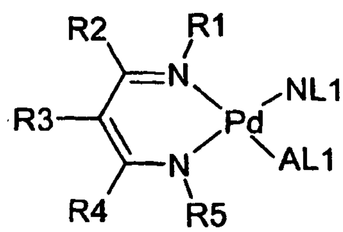

**250**

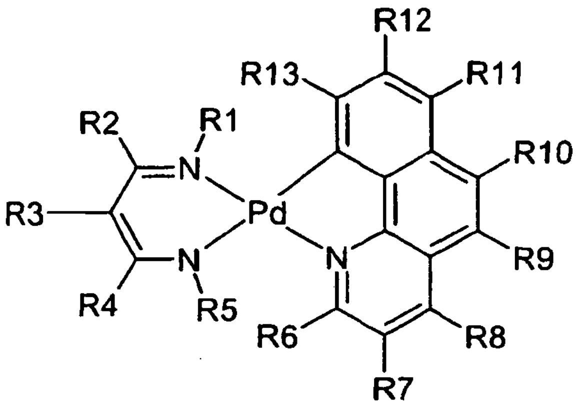

251

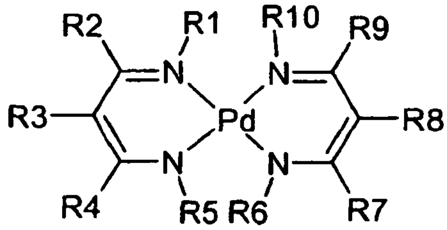

252

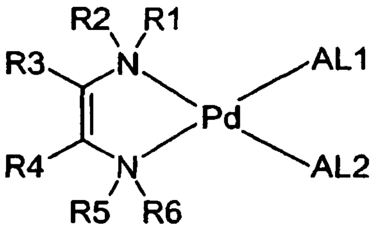

253

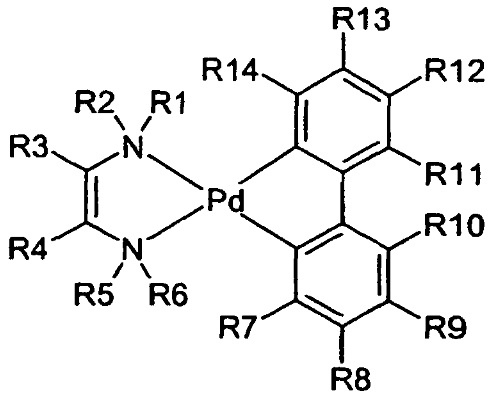

254

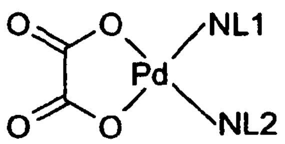

255

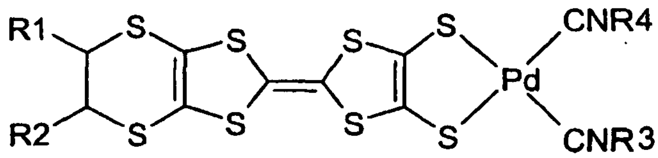

256

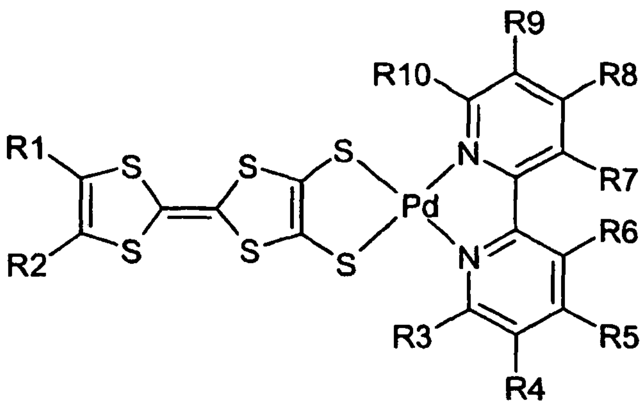

257

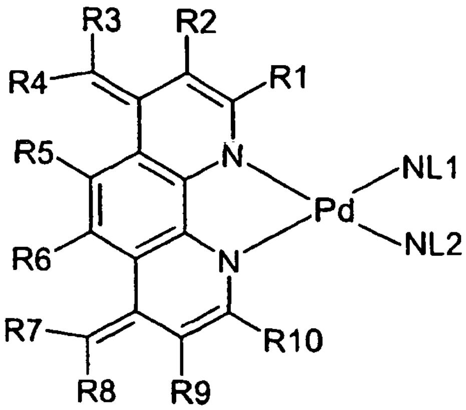

**258**

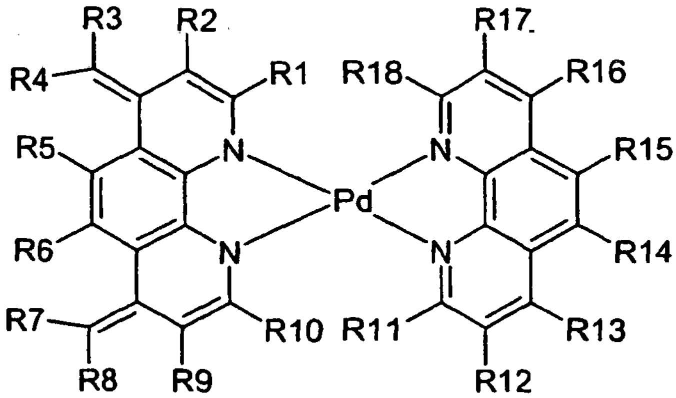

**259**

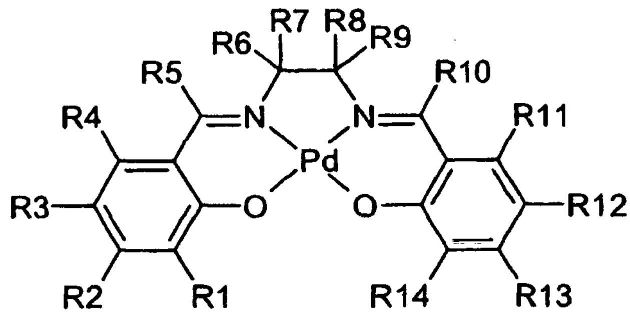

**260**

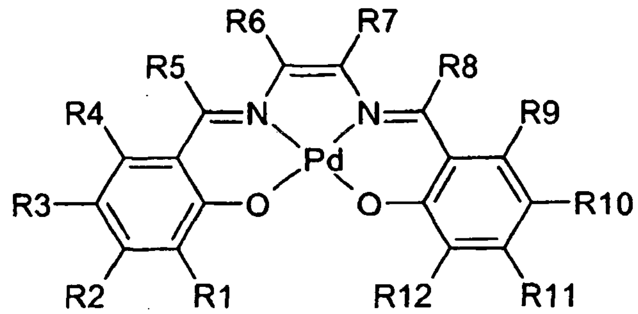

**261**

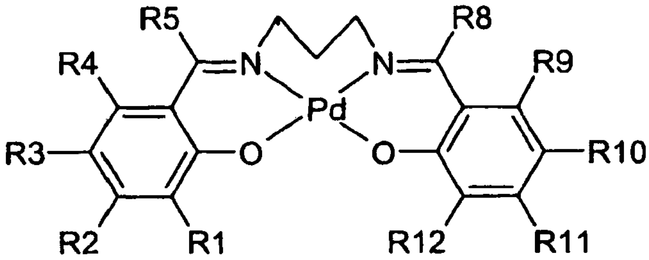

**262**

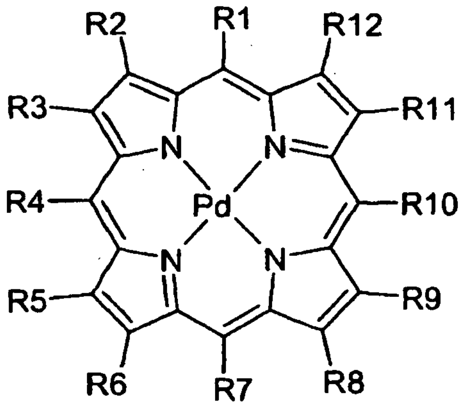

**263**

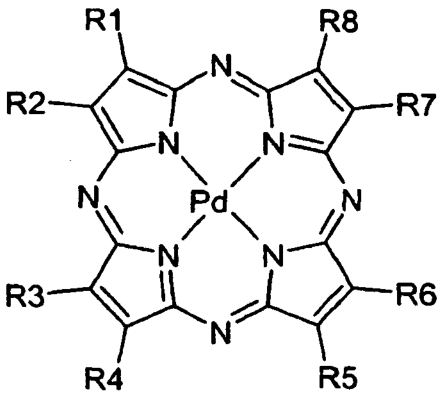

**264**

**Au(III)-Komplexe**

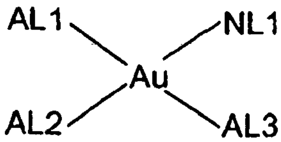

**265**

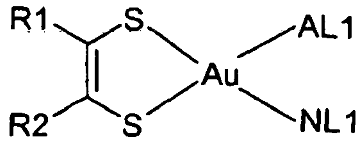

**266**

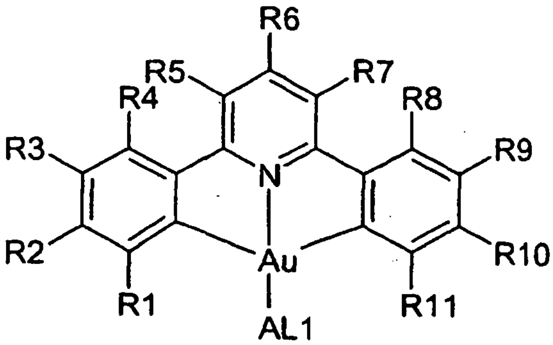

**267**

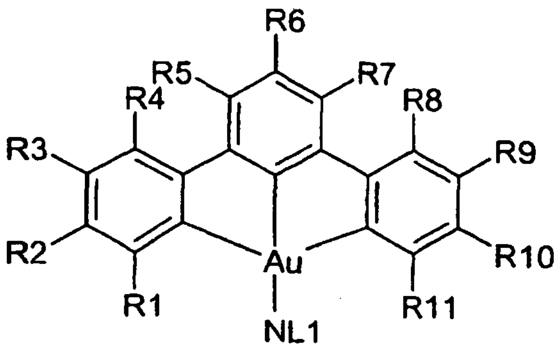

**268**

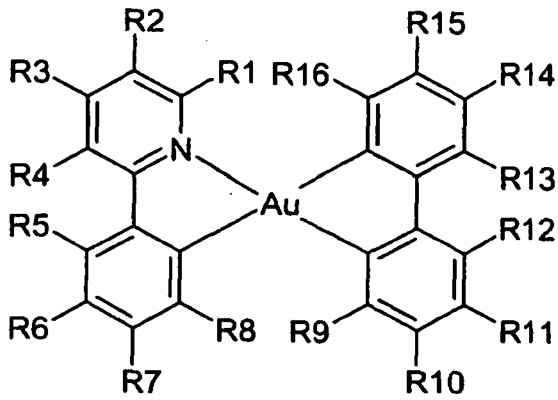

**269**

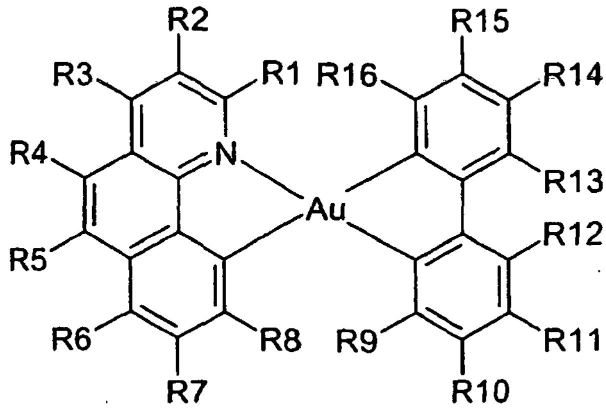

**270**

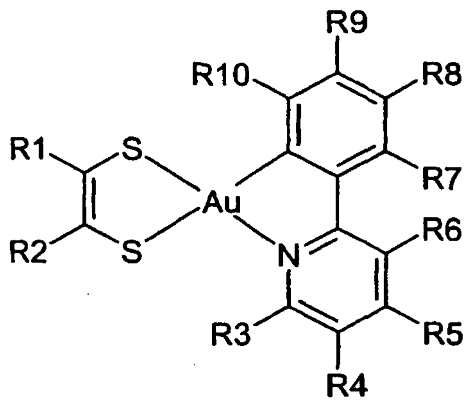

**271**

Dabei haben die Reste in den oben abgebildeten Strukturen dieselbe Bedeutung, wie oben für die Reste R1 bis R8 beschrieben.

In der erfindungsgemäßen Verwendung ist der erste neutrale Übergangsmetallkomplex der Zusammensetzung ein Pd (II)- Komplex der oben genannten Verbindungen 137 bis 264. Der zweite neutrale Übergangsmetallkomplex der Zusammensetzung ist einer der oben genannten Verbindungen 1 bis 136 oder 265- 271. Sofern die Zusammensetzung einen dritten, vierten und/ oder fünften Übergangsmetallkomplex aufweist, so ist auch dieser bevorzugt eine der oben genannten Verbindungen 1 bis 271. Es kann sich aber grundsätzlich um jeden neutralen Übergangsmetallkomplex handeln, insbesondere in den oben beschriebenen Ausführungen, so lange dieser eine quadratisch- planare oder quasi-quadratisch- planare Struktur aufweist und/ oder zur Ausbildung einer Kolumnarstruktur befähigt ist.

In einer weiteren bevorzugten Ausführungsform der Erfindung besteht die erfindungsgemäße Zusammensetzung ausschließlich (zu 100 %) aus dem ersten Übergangsmetallkomplex und dem zweiten Übergangsmetallkomplex, ohne dass weitere Komponenten hinzukommen. Das Verhältnis dieser beiden Komponenten ist zumeist beliebig, kann also beispielsweise 0,001 % zu 99,999 %, 10 % zu 90 %, 20 % zu 80 %, 30 % zu 70 %, 40 % zu 60 %, 50 % zu 50 %, 60 % zu 40 %, 70 % zu 30 %, 80 % zu 20 %, 90 % zu 10 % oder 99,999 % zu 0, 001 % betragen. Bevorzugt ist ein Verhältnis der beiden Komponenten von 40 % zu 60 % bis 60 % zu 40 %, insbesondere 50 % zu 50 %. Das für die jeweiligen verwendeten Übergangsmetallkomplexe optimale Verhältnis kann von einem Fachmann leicht mittels Routineversuchen bestimmt werden. Dabei optimiert ein Fachmann zumeist nach Emissionsfarbe, Emissionslebensdauer, Absorptionsenergie, und/oder Absorptionsstärke.

In einer weiteren Ausgestaltung der Erfindung liegt bei der Verwendung der Zusammensetzung der Anteil des ersten Übergangsmetallkomplexes und der des zweiten Übergangsmetallkomplexes zusammen bei 1 % bis unter 100 %, bevorzugt bei 10 % bis 90 %, besonders bevorzugt bei 20 % bis 80 %. Der an 100 % fehlende Anteil besteht dann aus mindestens einem weiteren (dritten, vierten und/oder fünften) neutralen Übergangsmetallkomplex, und/oder aus einem weiteren Bestandteil, etwa aus einem Dotanden oder einem Hostmaterial.

In einem weiteren Aspekt betrifft die Erfindung ein elektronisches Bauelement, das eine Zusammensetzung aufweist, die einen ersten neutralen Übergangsmetallkomplex und einen zweiten neutralen Übergangsmetallkomplex aufweist oder enthält, wobei der erste Übergangsmetallkomplex und der zweite Übergangsmetallkomplex zusammen eine Kolumnarstruktur ausbilden.

Ein derartiges Bauelement kann ausgeformt oder implementiert sein als ein Bauelement, das ausgewählt ist aus der Gruppe bestehend aus einem organischen lichtemittierenden Bauelement, einer organischen Diode, einer organischen Solarzelle, einem organischen Transistor und einer organischen lichtemittierenden Vorrichtung.

Sofern das Bauelement als organische Solarzelle (OSC) ausgeformt ist, ist die Zusammensetzung in einer Absorberschicht angeordnet, bzw. Teil der Absorberschicht. Dabei machen der erste Übergangsmetallkomplex und der zweite Übergangsmetallkomplex bevorzugt zusammen 10 % bis 100 % der Zusammensetzung aus. Bei den restlichen 90 % bis 0 % handelt es sich um Matrixmaterial der OSC, das der Leitung von Löchern bzw. Elektronen dient. Die Zusammensetzung kann auch weitere Übergangsmetallkomplexe aufweisen, wobei der Anteil der Zusammensetzung in der Absorberschicht der OSC mindestens 10 %, bevorzugt 20 % bis 50 %, besonders bevorzugt über 50 % beträgt.

Sofern das Bauelement als organische Elektrolumineszenzvorrichtung (OLED) ausgeformt ist, ist die Zusammensetzung in einer Emissionsschicht angeordnet, bzw. Teil der Emitterschicht. Bei einer Ausführungsform einer derartigen OLED machen der erste Übergangsmetallkomplex und der zweite Übergangsmetallkomplex zusammen 1 % bis 100 % der Zusammensetzung aus, ohne dass weitere Komponenten hinzukommen. Das Verhältnis dieser beiden Komponenten ist zumeist beliebig, kann also beispielsweise 10 % zu 90 %, 20 % zu 80 %, 30 % zu 70 %, 40 % zu 60 %, 50 % zu 50 %, 60 % zu 40 %, 70 % zu 30 %, 80 % zu 20 %, oder 90 % zu 10 % betragen. Möglich ist auch eine Verteilung von 0,001 % zu 99,999 % oder umgekehrt. Das für die jeweiligen verwendeten Übergangsmetallkomplexe optimale Verhältnis kann von einem Fachmann leicht mittels Routineversuchen bestimmt werden.

In einer alternativen Ausführungsform einer erfindungsgemäßen OLED machen der erste Übergangsmetallkomplex und der zweite Übergangsmetallkomplex zusammen 1 % bis unter 100 % der Zusammensetzung, bevorzugt 1 % bis 10 % der Zusammensetzung aus. Bei den an 100% fehlenden 1 % bis 99 % handelt es sich um Matrixmaterial der OLED, das dem Transport von Löchern bzw. Elektronen dient. Das Matrixmaterial kann auch inert sein, da die erfindungsgemäßen Stoffzusammensetzungen gute Loch- und Elektronen-Leitereigenschaften aufweisen. Die Zusammensetzung kann auch weitere Übergangsmetallkomplexe ausweisen, wobei der Anteil der Zusammensetzung in der Emissionsschicht der OLED mindestens 1 %, bevorzugt mindestens 10 % bis 50 %, besonders bevorzugt über 50 % beträgt. Die Emisionsfarben und die anderen Emissionseigenschaften werden durch die Veränderungen der Komponenten der Übergangsmetallkomplex-Zusammensetzung bestimmt.

Geeignete Matrixmaterialien sind ausgewählt aus Ketonen, z. B. gemäß WO 04/013080, WO 04/093207, WO 06/005627 oder der nicht offen gelegten Anmeldung DE 102008033943.1, Triarylaminen, Carbazolderivaten, z. B. CBP (N, N- Biscarbazolylbiphenyl) oder die in WO 05/039246, US 2005/0069729, JP 2004/288381, EP 1205527 oder WO 08/086851 offenbarten Carbazolderivaten, Indolocarbazolderivaten, z. B. gemäß WO 07/063754 oder WO 08/056746, Azacarbazolen, z. B. gemäß EP 1617710, EP 1617711, EP 1731584, JP 2005/347160, bipolaren Matrixmaterialien, z. B. gemäß WO 07/137725, Silanen, z. B. gemäß WO 05/111172, Azaborolen oder Boronestern, z. B. gemäß WO 06/117052, Triazinderivaten, z. B. gemäß der nicht offen gelegten Anmeldung DE 102008036982.9, WO 07/063754 oder WO 08/056746, oder Zinkkomplexen, z. B. gemäß der nicht offen gelegten Anmeldung DE 102007053771.0 oder Mischungen dieser Materialien.

In einer bevorzugten Ausführungsform einer erfindungsgemäßen OLED ist der erste Übergangsmetallkomplex ein Pd (II)- Komplex ist, und der zweite Übergangsmetallkomplex ist ein Komplex, der ausgewählt ist aus der Gruppe bestehend aus Pt (II)- Komplexen, Ir (I)- Komplexen, Rh (I)- Komplexen und Au (III)- Komplexen. Dabei ist es besonders bevorzugt, dass der Anteil des ersten Übergangsmetallkomplexes 90 % bis 99, 999 % beträgt und der Anteil des zweiten Übergangsmetallkomplexes 10 % bis 0, 001 % beträgt. So kann beispielsweise eine blaue Emissionsfarbe realisiert werden.

In einer weiteren bevorzugten Ausgestaltung des OLED ist der erste Übergangsmetallkomplex ein Pd (II)-Komplex nach Formel 137 bis 264, und der zweite Übergangsmetallkomplex ein Komplex, der ausgewählt ist aus der Gruppe bestehend aus den Pt (II)- Komplexen nach Formel 15 bis 136, den Ir (I)- Komplexen nach Formel 1 bis 7, den Rh (I)- Komplexen nach Formel 8 bis 14, und den Au (III)- Komplexen nach Formel 265 bis 271. Dabei ist es besonders bevorzugt, dass der Anteil des ersten Übergangsmetallkomplexes 90 % bis 99, 999 % beträgt und der Anteil des zweiten Übergangsmetallkomplexes 10 % bis 0, 001 % beträgt. Unabhängig von der Anzahl der verschiedenen Übergangsmetallkomplexe in der Zusammensetzung beträgt der Anteil der Zusammensetzung in der Emitterschicht der OLED gemäß dieser Ausführungsform bevorzugt zwischen 10 % und 0, 001 %, wobei der an 100 % fehlende Anteil Matrixmaterial und/ oder Dotanden ausmachen.

In einem weiteren Aspekt betrifft die Erfindung ein Verfahren zur Herstellung eines genannten elektronischen Bauelements. Ein derartiges Verfahren zeichnet sich durch das Aufbringen einer Zusammensetzung nach der obigen Beschreibung auf ein festes Trägermaterial aus. Das Aufbringen kann nasschemisch durch Zusammenbringen von Lösungen, mittels kolloidaler Suspension und/oder mittels Vakuumsublimation erfolgen. Im Rahmen dieser Verfahren kann auch die Dotierung durchgeführt werden. Einzelheiten zur Durchführung derartiger Verfahren sind dem Fachmann bekannt.

Insbesondere nicht sublimierbare Komplexe können aus einer Lösung verarbeitet werden. Dazu wird ein Gemisch der Verbindungen in dem gewünschtem Mischverhältnis in einem geeigneten Lösungsmittel gelöst und durch gängige Verfahren (Spin- Coating, Inkjet Printing, Doctor Blading) auf einem Substrat (Bauelement, Device) als dünne Schicht aufgebracht. Nicht lösliche erfindungsgemäße Zusammensetzungen können durch eine kolloidale Suspension, die beliebig viele Komponenten enthalten kann, aufgebracht werden. Die Oligomerstränge der Kolumnarstrukturen der erfindungsgemäßen Zusammensetzungen können dabei vor dem Suspendieren unter Ultraschallbearbeitung und Filtrieren durch geeignete Nanofilter auf die gewünschte Länge verkürzt werden.

Generell bevorzugt sind die folgenden Verfahren für die Herstellung:

Weiterhin bevorzugt ist ein organisches opto-elektronisches Bauteil, dadurch gekennzeichnet, dass eine oder mehrere Schichten mit einem Sublimationsverfahren beschichtet werden. Dabei werden die Materialien in Vakuum-Sublimationsanlagen bei einem Druck kleiner $10^{-5}$ mbar, bevorzugt kleiner $10^{-6}$ mbar aufgedampft. Es sei jedoch angemerkt, dass der Druck auch noch geringer sein kann, beispielsweise kleiner $10^{-7}$ mbar.

Bevorzugt ist ebenfalls ein organisches opto-elektronisches Bauteil, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist ein organisches opto- elektronisches Bauteil, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink- Jet Druck (Tintenstrahldruck), hergestellt werden. Hierfür sind lösliche Verbindungen nötig. Hohe Löslichkeit lässt sich durch geeignete Substitution der Verbindungen erreichen. Dabei können nicht nur Lösungen aus einzelnen Materialien aufgebracht werden, sondern auch Lösungen, die mehrere Verbindungen enthalten, beispielsweise Matrixmaterialien und Dotanden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden.

In einem weiteren Aspekt betrifft die Erfindung ein Verfahren zur Veränderung der Emissions- und/oder der Absorptionseigenschaften einer Zusammensetzung oder einer Verbindung. Dies wird erfindungsgemäß durch das Mischen verschiedener Übergangsmetallkomplexe der oben beschriebenen Art oder das Einbringen eines Dotiermittels in eine Zusammensetzung oder Verbindung gemäß der voranstehenden Beschreibung erreicht.

Die Erfindung betrifft eine Zusammensetzung aus mindestens einem ersten neutralen Übergangsmetallkomplex und einem zweiten neutralen Übergangsmetallkomplex gemäß der obigen Beschreibung, welche eine quadratisch-planare oder quasi-quadratisch-planare Struktur aufweisen und/oder eine Kolumnarstruktur ausbilden, insbesondere zur Verwendung in einem elektronischen Bauelement, wie einer OSC oder einer OLED.

Die in der Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Figuren

Die Erfindung wird nun anhand der Zeichnungen der Figuren näher beschrieben. Es zeigen:

Figur 1: eine schematische Darstellung zur Funktionsweise einer organischen lichtemittierenden Vorrichtung (OLED) ;

Figur 2: eine schematische Darstellung zur Funktionsweise einer organischen Solarzelle (OSC) ;

Figur 3: Emissionsspektren der reinen Oligomere von Pt (phen) $(CN)_2$ und Pt (bph) $(CO)_2$, sowie Emissionsspektrum einer Mischung von Pt (phen) $(CN)_2$ und Pt (bph) $(CO)_2$ (die Abscheidung der dünnen Schichten erfolgte auf einer Glasoberfläche durch Vakuumsublimation bei 200 °C) ;

Figur 4: ein Beispiel für ein OLED- Device mit einer erfindungsgemäßen Emitterschicht, die durch Vakuumsublimation aufgetragen werden kann (die Schichtdickenangaben sind Beispielwerte) ;

Figur 5: ein Beispiel für ein OLED- Device mit einer erfindungsgemäßen Emitterschicht, die nass- chemisch aufgetragen werden kann (die Schichtdickenangaben sind Beispielwerte) ;

Figur 6: das generelle Aufbauprinzip für ein OSC- Device; und

Figur 7: ein Beispiel für ein OSC- Device mit einer erfindungsgemäßen Absorptionsschicht (die Schichtdickenangaben gelten als Beispielwerte) .

**Figur 1**

Die in Figur 1 schematisch dargestellte und das Prinzip erläuternde organische lichtemittierende Vorrichtung (OLED, engl. Organic Light Emitting Device) besteht vorwiegend aus organischen Schichten. Die gezeigte OLED weist (von links nach rechts) eine Metall-Kathode auf, an die eine Elektronenleitungsschicht angrenzt, auf der wiederum eine Emitterschicht, gefolgt von einer Löcherleitungsschicht angeordnet ist. Die Löcherleitungsschicht ist mit einer transparenten, leitenden Anode verbunden.

Bei einer Spannung von z. B. 5 V bis 10 V treten aus einer leitenden Metallschicht, z. B. in Form einer Magnesium/ Silber- oder einer Aluminium- Kathode, negative Elektronen in eine dünne Elektronen- Leitungsschicht und wandern in Richtung der positiven Anode. Diese besteht z. B. aus einer durchsichtigen, aber elektrisch leitenden, dünnen Indium-Zinn- Oxid- Schicht, von der positive Ladungsträger, sog. Löcher, in eine organische Löcher- Leitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen Material besteht, befinden sich zusätzlich besondere Emitter- Moleküle bzw. die erfindungsgemäßen Stoffzusammensetzungen, an denen oder in deren Nähe die beiden Ladungsträger rekombinieren und dabei zu neutralen, aber energetisch angeregten Zuständen der Emitter führen. Die angeregten Zustände geben dann ihre Energie als helle Lichtemission ab, z. B. in blauer, grüner oder roter Farbe. Auf eine eigenständige Emitterschicht kann gegebenenfalls auch verzichtet werden, wenn die Emittermoleküle sich in der Loch- oder Elektronen- Leitungsschicht befinden. Entscheidend für den Bau hoch- effizienter OLEDs sind die verwendeten Leuchtmaterialien (Emitter) . Die hier beschriebenen Zusammensetzungen eignen sich insbesondere für die Verwendung als Emitter in OLEDs.

**Figur 2**

Der Aufbau einer organischen Solarzelle (OSCs, engl. organic solar cell) ist dem eines OLEDs ähnlich, wie aus Fig. 2 hervorgeht. Die gezeigte OSC weist (von links nach rechts) eine Metallelektrode (Kathode), eine Elektronenleitungsschicht, eine Lichtabsorptionsschicht, eine Löcherleitungsschicht und eine transparente Elektrode (Anode) auf. Die effiziente Umwandlung von Sonnenenergie in elektrische Energie in organischen Solarzellen beruht auf der Verwendung von Absorptionsfarbstoffen (Absorbern) in der Lichtabsorptionsschicht. Die erfindungsgemäßen Zusammensetzungen stellen die Absorber dar.

Für die bisher bekannten OSCs ist das Fehlen von Materialien mit hoher Absorption im spektralen Bereich vom Sichtbaren bis zum nahen IR (zur effektiven Absorption des Sonnenlichtes, das die Erdoberfläche erreicht) zu verzeichnen. Diese Materialien sollten gleichermaßen hohe Exzitonen-Diffusionslängen aufweisen, um nach einer Lichtabsorption einen effektiven Transfer zur Grenzfläche oder zum Dissoziationsbereich innerhalb der Absorptionsschicht zu erreichen, d. h. die Exzitonen-Wanderung muss schnell und weit genug möglich sein, um eine Exzitonen-Dissoziation zu erreichen.

Die hier gezeigte Zelle ist in einer Sandwich- Geometrie gefertigt, wobei als positive Elektrode eine transparente Halbleiter- Schicht, meistens bestehend aus Indium- Zinn- Oxid (ITO), verwendet wird. Auf diese Elektrode werden eine oder mehrere organische Schichten aufgebracht: Loch- Leitungs- Schicht, Licht- Absorptions- Schicht, Elektronen-Leitungs- Schicht und die abschließende negative Metall- Elektrode.

Der Prozess, der zur Entstehung des Photo-Stroms in einer organischen Solarzelle, die aus mehreren Schichten zusammengesetzt ist, läuft zusammengefasst wie folgt ab: Ein Photon des eingestrahlten Lichts wird von einem Farbstoff-Molekül in der Absorptions-Schicht absorbiert. Damit wird das Farbstoffmolekül elektronisch angeregt. Da das Molekül im angeregten Zustand (Exziton) andere Redox-Eigenschaften aufweist als im Grundzustand, kommt es bei geeignet gewählten HOMO- und LUMO-Lagen des Matrixmaterials oder der Lochleiter- und Elektronenleitersschicht relativ zu den HOMO-/LUMO-Lagen der Absorptionsschicht zu einer elektrischen Ladungstrennung innerhalb der Absorptions-Schicht oder an einer der Schichtgrenzen. Die dadurch entstandenen Elektronen und Löcher wandern durch die jeweilige Elektronen- bzw. Loch-Leitungs-Schicht in Richtung der Elektroden, wodurch eine elektrische Spannung an den Elektroden entsteht.

Mehrere Techniken und Bauelement-Architekturen wurden bereits vorgeschlagen um OSCs zu realisieren. Dabei unterscheidet man drei verschiedene Typen von OSCs:

1) OSCs, bei denen die organischen Schichten aus sog. "small molecules" bestehen (SM-Solarzellen werden im Allgemeinen durch Vakuumdeposition hergestellt)

2) OSCs, bei denen die organischen Schichten aus Polymeren bestehen (Polymer-Solarzellen werden durch spin-coating oder ink-jet printing hergestellt)

3) "Dye-Sensitized Solar Cells", die eine hochporöse Elektronen-Leitungsschicht aus $TiO_2$ besitzen.

Letztere werden hergestellt, indem $TiO_2$ gesintert und mit dem Farbstoff belegt wird (sog. Grätzel-Zelle).

Neben diesen drei verschieden OSC Typen kann man OSCs auch nach ihrem Funktionsprinzip unterschieden. Im Allgemeinen kommt es nach der Absorption des Photons zur Trennung der elektrischen Ladungen, gefolgt von der Wanderung des entstandenen Lochs bzw. Elektrons zu den jeweiligen Elektroden. Dabei wird je nach Funktionsprinzip die Trennung der Ladungsträger auf unterschiedliche Weise realisiert.

In einer Grätzel-Zelle wirkt das an der Oberfläche der Elektrode befindliche Farbstoffmolekül als Photosensibilisator. Nach Absorption eines Photons kommt es zu einem Elektronentransfer vom angeregten Farbstoffmolekül zur $TiO_2$-belegten Elektrode. Das oxidierte Farbstoffmolekül wird anschließend durch die im Elektrolyt befindlichen redoxaktive Substanzen wieder reduziert.

In den sog. Feststoff- Solarzellen (Heterojunction-, Bulk- Heterojunction und p- i- n- Solarzellen) werden die Ladungsträger (Elektron und Loch) an einer Grenzfläche zwischen verschiedenen Schichten des Bauelements getrennt. Dabei kann das Exziton entweder direkt an der Grenzfläche zwischen der Loch- und Elektronen- Leitungsschicht entstehen (Heterojunction- Solarzelle), oder eine zusätzliche photoaktive Schicht wird eingeführt (p- i- n- Solarzelle) . Im letzten Fall wird das Exziton im Inneren dieser photoaktiven Schicht durch Absorption des Photons erzeugt und wandert dann in Richtung Loch- oder Elektronen- Leitungsschicht, wo es dann an der Grenzfläche durch einen heterogenen Elektron- / Loch- Transfer zur Ladungstrennung kommt. Die photoaktive Schicht kann auch in Form einer "Bulk- Heterojunction" realisiert werden, die eine Mischung von Loch- und Elektronen- Leitermaterial darstellt.

<u>**Figur 3**</u>

Figur 3 zeigt die Messergebnisse des im Beispiel beschriebenen Experiments. Es ist die gemessene Intensität über die Wellenlänge bzw.

Wellenzahl aufgetragen (für zwei reine Verbindungen und die Zusammensetzung derselben, in einer Mischung von 50 % zu 50 %).

<u>**Figur 4**</u>

Das in Figur 4 gezeigte elektronische Bauelement in Form einer OLED wird im Folgenden kurz anhand der gezeigten Schichten 1 bis 8 des Bauelements beschrieben.

1. Als Trägermaterial kann Glas oder jedes andere geeignete feste oder flexible durchsichtige Material verwendet werden.

2. ITO = Indium-Zinn-Oxid

3. HIL = *hole injection layer*, CuPc = Kupfer-Phthalocyanin

4. HTL = *hole transport layer*, $\alpha$- NPD = *N*, *N'*- diphenyl- *N*, *N'*- bis (1- naphthyl)- 1, 1'- biphenyl- 4, 4'- diamin

5. Emitter-Schicht, häufig mit EML (emission layer) abgekürzt, mit Emittersubstanzen. Die Verbindungen werden durch Vakuum-Sublimation codeponiert. Diese Schicht, besteht aus den erfindungsgemäßen Metallkomplex-Mischungen oder weist diese auf. Die Konzentration der Metallkomplexe in der Zusammensetzung kann 100% betragen, d.h. diese Schicht besteht dann nur aus Metallkomplex-Mischungen. Die Konzentration kann aber auch im Bereich von 1 % bis <100 % liegen. In diesem Fall befinden sich die Metallkomplexe in einer geeigneten, ebenfalls coverdampften Matrix, die z. B. aus einem in der OLED-Technologie bekannten Matrixmaterial (z. B. vergl. M.E. Thompson *et al.*, *Chem. Mater.*, 2004, 16, 4743) besteht.

6. ETL = Elektronentransportmaterial (ETL = *electron transport layer*). Beispielsweise kann das aufdampfbare $Alq_3$ verwendet werden. Dicke z. B. 40 nm.

7. Die sehr dünne Zwischenschicht aus z. B. CsF oder LiF verringert die Elektroneninjektionsbarriere und schützt die ETL-Schicht. Diese Schicht wird in der Regel aufgedampft. Für einen weiter vereinfachten OLED-Aufbau können gegebenenfalls die ETL- und die CsF- bzw. LiF-Schicht entfallen.

8. Die leitende Kathodenschicht wird aufgedampft. Al repräsentiert ein Beispiel. Es können auch Mg:Ag (10:1) oder andere Metalle verwendet werden.

Die am Bauelement anliegende Spannung beträgt z. B. 3 V bis 15 V.

**Figur 5**

Das in Figur 5 gezeigte, nasschemisch herstellbare elektronische Bauelement in Form einer OLED wird im Folgenden kurz anhand der gezeigten Schichten 1 bis 7 des Bauelements beschrieben.

1. Als Trägermaterial kann Glas oder jedes andere geeignete feste oder flexible durchsichtige Material verwendet werden.

2. ITO = Indium-Zinn-Oxid

3. HTL = Lochleitermaterial (*hole transport layer*). PEDOT/PSS = Polyethylendioxythiophen/ Polystyrolsulfonsäure oder neue HTL-Materialien (z. B. DuPont). Hierbei handelt es sich um ein Lochleitermaterial, das wasserlöslich ist.

4. Emitter- Layer (EML) mit Emittersubstanzen. Die Verbindungen können z. B. in organischen Lösungsmitteln gelöst werden. Damit kann ein Auflösen der darunter liegenden PEDOT/PSS- Schicht vermieden werden. Die erfindungsgemäßen Zusammensetzungen in Form von Metallkomplex- Mischungen können je nach Anwendung 1 % bis 100 % (Masse%) betragen. Die erfindungsgemäßen Metallkomplex- Mischungen können auch als Suspensionen in einem Emitter- Matrixmaterial (z. B. PVK = Polyvinylcarbazol oder CBP = 4, 4'- Bis- N- carbazolyl- biphenyl) eingebracht sein. Diese fertigungstechnische Variante kann eingesetzt werden, wenn die Metall- Komplex- Mischungen nicht löslich sind.

5. ETL = Elektronentransportschicht (ETL = *electron transport layer*). Beispielsweise kann das aufdampfbare $Alq_3$ verwendet werden. Dicke z. B. 40 nm.

6. Die sehr dünne Zwischenschicht aus z. B. CsF oder LiF verringert die Elektroneninjektionsbarriere und schützt die ETL-Schicht. Diese Schicht wird in der Regel aufgedampft. Für einen vereinfachten OLED-Aufbau können gegebenenfalls die ETL- und die CsF- bzw. LiF-Schicht entfallen.

7. Die leitende Kathodenschicht wird aufgedampft. Al repräsentiert ein Beispiel. Es können auch Mg:Ag (10:1) oder andere Metalle verwendet werden.

Die am Device anliegende Spannung beträgt z. B. 3 V bis 15 V.

Die Herstellung einer derartigen OLED geschieht in der dem Fachmann bekannten Weise. Zum Beispiel lassen sich in einem typischen OLED-Schichtaufbau, bestehend aus einer ITO-Anode, einem Lochleiter (z. B. aus PEDOT/PSS), der Emitterschicht aufweisend eine erfindungsgemäße Zusammensetzung, gegebenenfalls einer Lochblockierschicht, einer Elektronenleiterschicht, einer dünnen LiF- oder CsF-Zwischenschicht zur Verbesserung der Elektroneninjektion sowie einer Metall-Elektrode (Kathode) gute Leistungseffizienzen erzielen. Diese verschiedenen Schichten mit einer Gesamtdicke von einigen 100 nm lassen sich z. B. auf einem Glassubstrat oder einem sonstigen Trägermaterial aufbringen.

**Figur 6**

Figur 6 zeigt das Aufbauprinzip für ein OSC-Bauelement in einer generellen Formulierung (Schichten 1 bis 6).

**Figur 7**

Figur 7 zeigt ein Beispiel für ein OSC-Bauelement aufweisend eine erfindungsgemäße Verbindung. Die angegebenen Schichtdicken sind beispielhaft.

1. Als Trägermaterial kann Glas oder jedes andere geeignete feste oder flexible durchsichtige Material verwendet werden.

2. ITO = Indium-Zinn-Oxid

3. ETL = Elektronentransportschicht (ETL = *electron transport layer*). Beispielsweise eine $C_{60}$-Schicht oder eine n-dotierte Schicht.

4. Licht- Absorptions- Schicht aufweisend ein Absorptionsmaterial in Form einer erfindungsgemäßen Zusammensetzung. Je nach Anwendung kann der Anteil des/der Übergangsmetallkomplexe (s) von 10 % bis 100 % betragen. In einer ersten Ausführungsform besteht die Absorptionsschicht aus reiner Metallkomplex- Mischung, die durch Vakuum- Sublimation (Co- Verdampfung) der Metall- Komplex- Verbindungen eingebracht werden. In einer zweiten Ausführungsform können die Metallkomplex- Mischungen als Dispersion in einem geeigneten Matrixmaterial nasschemisch eingesetzt werden. Als Matrix- Material kann eine geeignete elektron- oder lochleitende Substanz (oder auch eine Mischung der beiden) eingesetzt werden. Beispiele für die n- und p- Leiter- Materialien sind unten genannt.

5. HTL = *hole transport layer*, MeO- TPD = *N*, *N*, *N'*, *N'*- Tetrakis- (4- Methoxyphenyl)- benzidine. Das HTL Matrix-Material kann auch mit einem p- Dopant dotiert werden, z. B. MeO- TPD + $F_4$- TCNQ (Tetrafluorotetracyanoquinodimethan)

6. Die leitende Metallschicht wird aufgedampft. Neben dem hier gezeigten Au können auch andere Metalle verwendet werden, wie dem Fachmann bekannt ist.

Bevorzugte Verbindungen für n-Leiter-Materialien für OSCs sind die folgenden:

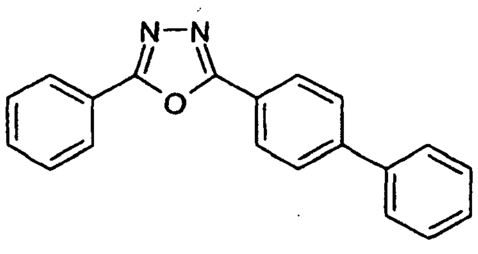

2-(4-Biphenyl)-5-phenyl-1,3,4-oxadiazol

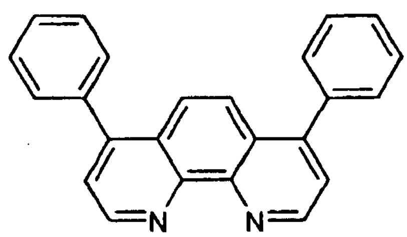

Bathocuproine

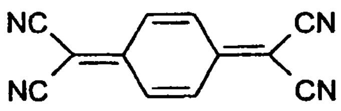

7,7,8,8-Tetracyanoquinodimethan

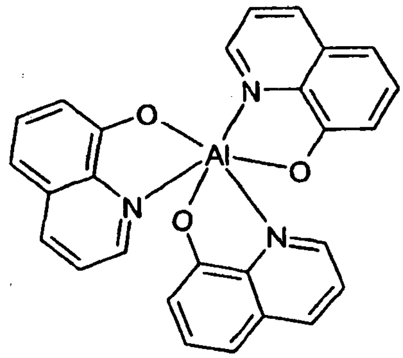

Al(III) 8-Hydroxyquinolinat

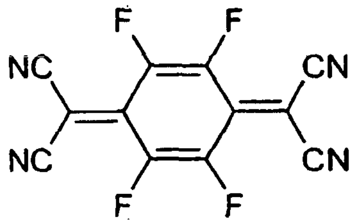

$F_4$-TCNQ

Bevorzugte Verbindungen für p-Leiter-Materialien für OSCs sind die folgenden:

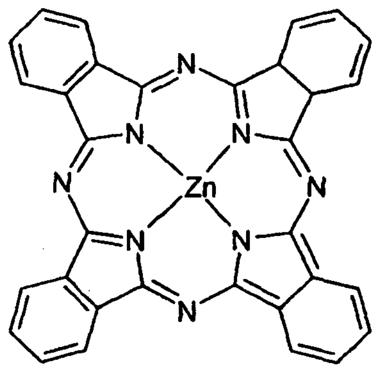

Zink(II) Phthalocyanine

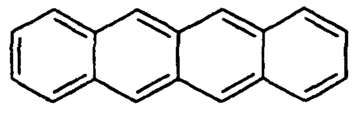

Benz[b]anthracen

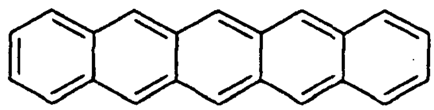

Pentacen

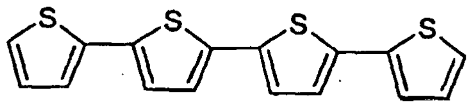

α-Quaterthiophen

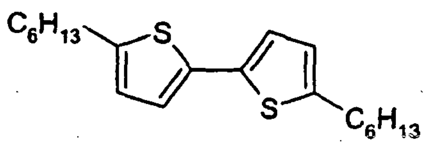

5,5'-Dihexyl-2,2'-Bithiophen

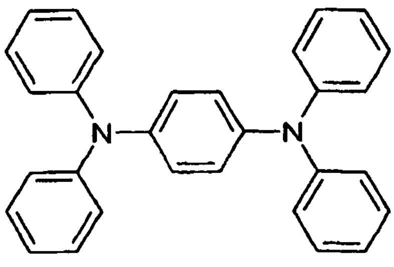

1,4-Bis-(diphenylamino)benzol

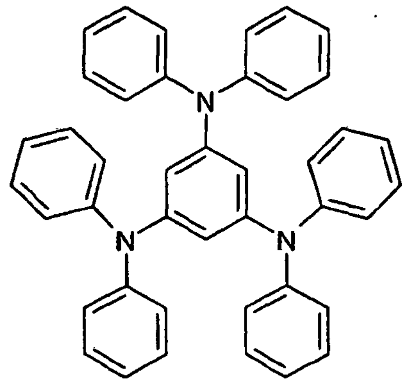

1,3,5-Tris-(diphenylamino)benzol

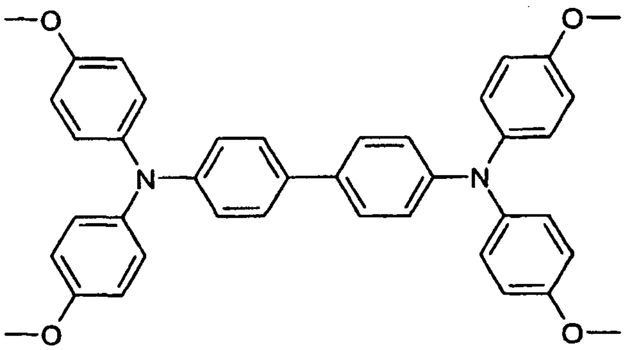

N,N,N',N'-Tetrakis-(4-Methoxyphenyl)benzidine

Die Erfindung betrifft in einem Aspekt die Verwendung einer Zusammensetzung aufweisend einen ersten Übergangsmetallkomplex und einen zweiten Übergangsmetallkomplex, insbesondere in der Verwendung in einem optoelektronischen Bauelement, wie einem OLED oder einer OSC.

Die Erfindung erlaubt in einem weiteren Aspekt die Steuerung der Absorptionsbereiche (einer OSC) bzw. die Steuerung des Emissionsbereiches (einer OLED) durch die Stoffzusammensetzungen quadratisch-planarer bzw. quasiquadratisch-planarer Übergangsmetallkomplexe.

Erfindungsgemäß ist es möglich, durch Mischen verschiedener neutraler, beispielsweise Pt (II)- Komplexe eine Veränderung der Absorptionseigenschaften zu erreichen. Insbesondere lassen sich die Metall- Metall- Abstände, beispielsweise die Pt- Pt Abstände, in den Kolumnarstrukturen nahezu beliebig variieren. Auch die durchschnittlichen Kettenlängen dieser Kolumnarstrukturen können variiert werden. Dadurch können die Lagen der Absorptionsbanden über einen großen Bereich gezielt gesteuert werden, und man kann Stoffzusammensetzungen herstellen, deren Absorption sich über den sichtbaren Spektralbereich bis zum nahen Infrarot- Bereich erstreckt. Insbesondere können OLEDs hergestellt werden, deren Emission im weißen oder blauen oder roten oder IR- Spektralbereich liegt.

Solche Mischungen sind auch für die Anwendung in OSCs sehr gut geeignet. Als Beispiele hierfür können alle Kolumnarstrukturen herangezogen werden, die aus den oben be- schriebenen Übergangsmetallkomplexen (Monomeren) aufgebaut sind. In OSCs können auch Zusammensetzungen verwendet werden, bei denen der erste und der zweite Übergangsmetall- komplex identisch sind, insbesondere Pt (II)- Biphenyl- Komplexe.

Quadratisch- planar bzw. quasi- quadratisch- planar koordinierte Pt (II)- Zentren weisen eine sehr starke Tendenz zur Ausbildung von Metall- Metall- Wechselwirkungen aus. Die daraus resultierenden Kolumnarstrukturen weisen, verglichen mit den Monomereinheiten, neue elektronische Zustände auf und dementsprechend auch neue Absorptionsbanden. Die entsprechenden Extinktionskoeffizienten sind außerordentlich hoch und liegen in dem oben geforderten $\varepsilon$ ($\lambda$)- Bereich. Darüber hinaus können die Absorptionen je nach gewählter Stoffzusammensetzung den gesamten sichtbaren Bereich überdecken und zum Teil in den nahen Infrarot- Bereich reichen. Andererseits zeigen beispielsweise die aus Pt (II)- Komplexen bestehenden Kolumnarstrukturen sehr hohe Exzitonenbeweglichkeiten.

Diese Erfindung wird durch die nachfolgenden Beispiele näher ausgeführt, ohne sie dadurch einschränken zu wollen.

**Beispiele**

**Beispiel 1:**

Durch gleichzeitige Vakuumsublimation der aus dem Stand der Technik bereits bekannten reinen Komponenten Pt (phen) $(CN)_2$ [11] und Pt (bph) $(CO)_2$ [12- 14] (phen = 1, 10- Phenanthrolin, bph = 2, 2'- Biphenyl) werden auf einem

Glassubstrat eine entsprechende Zusammensetzung in Form einer Mischschicht aufgebracht.

Bei Anregung mit Licht der Wellenlänge 337 nm emittiert die Mischschicht bei $\lambda_{max}$ = 753 nm. Damit liegt das Emissionsmaximum dieser Mischschicht zwischen den Emissionsmaxima der reinen Substanzen, die bei $\lambda_{max}$ = 716 nm (Pt (phen) (CN) 2) und $\lambda_{max}$ = 782 nm (Pt (bph) $(CO)_2$) liegen. Die Messergebnisse sind in Fig. 3 dargestellt.

Wesentliche Vorteile dieser Mischungen sind unter anderem die mögliche Anpassung der Emissions- bzw. Absorptionswellenlänge und die Möglichkeit, besonders hohe Emissionsintensitäten zu erreichen.

**Beispiel 2-4: Herstellung und Charakterisierung von organischen Elektrolumineszenzvorrichtungen, enthaltend die erfindungsgemäßen Zusammensetzungen**

Erfindungsgemäße Elektrolumineszenzvorrichtungen können, wie beispielsweise in WO 05/003253 beschrieben, dargestellt werden. Hier werden die Ergebnisse verschiedener OLEDs gegenübergestellt. Der grundlegende Aufbau, die verwendeten Materialien und ihre Schichtdicken sind zur besseren Vergleichbarkeit identisch.

Das erste Devicebeispiel beschreibt einen Vergleichsstandard nach dem Stand der Technik, bei dem die Emissionsschicht aus dem Wirtsmaterial Bis (9, 9'- spirobifluoren- 2- yl) keton und dem Gastmaterial (Dotanden) TER für eine rote Emission besteht. Des Weiteren werden erfindungsgemäße OLEDs beschrieben, die die erfindungsgemäßen Zusammensetzungen enthalten. Analog dem o. g. allgemeinen Verfahren werden OLEDs mit folgendem Aufbau erzeugt:

| | |
|---|---|
| Lochinjektionsschicht (HIL) | 20 nm 2,2',7,7'-Tetrakis(di-para-tolyl-amino)spiro-9,9'-bifluoren |
| Lochtransportschicht (HTL) | 20 nm NPB (N-Naphthyl-N-phenyl-4,4'-diaminobiphenyl). |
| Emissionsschicht (EML) | 40 nm Matrixmaterial: Spiro-Keton (SK) (Bis(9,9'-spirobifluoren-2-yl)keton) Dotand: TER = $Ir(piq)_2acac$ (10 % Dotierung, aufgedampft) oder erfindungsgemäße Zusammensetzungen. |
| Elektronenleiter (ETL) | 20 nm $AlQ_3$ (Tris(chinolinato)aluminium(III)) als Vergleich. |
| Kathode | 1 nm LiF, darauf 150 nm Al. |

Die Strukturen von TER, Spiro-Keton (SK) und den erfindungsgemäßen Verbindungen TER-1 und TER-2 sind der Übersichtlichkeit halber im Folgenden abgebildet.

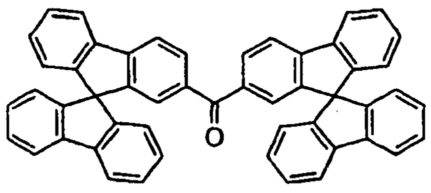

Spiro-Keton (SK)

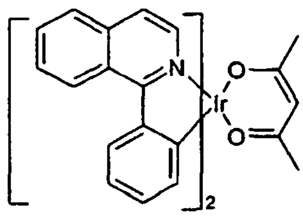

TER

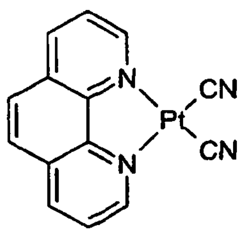

TER-1

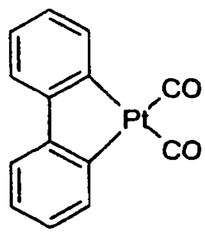

TER-2

Diese noch nicht optimierten OLEDs werden standardmäßig charakterisiert; hierfür werden die Elektrolumineszenzspektren, die externe Quanteneffizienz in Abhängigkeit von der Helligkeit, berechnet aus Strom- Spannungs- Helligkeit- Kennlinien (IUL- Kennlinien), und die Lebensdauer bestimmt. Die Ergebnisse sind in Tabelle 1 zusammengefasst.

Tabelle 1: Device-Ergebnisse mit erfindungsgemäßen Verbindungen mit TER (als Vergleichsbeispiel) und TER-1 und TER-2 als Dotanden

| Bsp. | EML 40 nm | EQE [%] bei 1000 cd/m$^2$ | Spannung [V] bei 1000 cd/m$^2$ | $\lambda_{max}$ [nm] | Lebensdauer [h], Anfangshelligkeit 1000 cd/m$^2$ |
|---|---|---|---|---|---|
| 2 Vergl. | SK : TER (10 %) | 12 | 5.5 | 635 | 3000 |
| 3 | SK (90 %): TER-1 (5 %) : TER-2 (5 %) | 13 | 5.1 | 750 | 2000 |
| 4 | SK (90 %): TER-1 (9 %) : TER-2 (1 %) | 14 | 5.0 | 725 | 2500 |

**Referenzen**

1 G. Aullón, S. Alvarez, Chem. Eur. J. 1997, 3, 655.
2 W. B. Connick, R. E. Marsh, W. P. Schaefer, H. B. Gray, Inorg. Chem. 1997, 36, 913.
3 H. Isci, W. R. Mason, Inorg. Chem. 1974, 13, 1175.
4 H. Bois, N. G. Connelly, J. G. Crossley, J.-C. Guillorit, G. R. Lewis, A. G. Orpen, P. Thornton, J. Chem. Soc., Dalton Trans. 1998, 2833.
5 G. Gliemann, H. Yersin, Structure and Bonding 1985, 62, 87.
6 A. E. Stiegman, S. F. Rice, H. B. Gray, V. M. Miskowski, Inorg. Chem. 1987, 26, 1112.
7 C.-M. Che, K.-T. Wan, L.-Y. He, C.-K. Poon, V. W.-W. Yam, J. Chem. Soc., Chem. Commun. 1989, 943.
8 J. R. Stork, M. M. Olmstead, A. L. Balch, Inorg. Chem. 2004, 43, 7508.
9 M. V. Puzyk, M. A. Ivanov, K.P. Balashev, Opt. Spectrosc. 2003, 95,81.
10 J. W. Schindler, R. C. Fukuda, A. W. Adamson, J. Am. Chem. Soc. 1982, 104, 3596.
11 C. Lennartz, A. Vogler, V. Pawlowski, (BASF AG), WO 2005/056712 A1, 2005.
12 H. Yersin, U. Monkowius, R. Czerwieniec, WO 2007/118671 A1
13 S. R. Stoyanov, J. M. Villegas, D. P. Rillema, Inorg. Chem., 2003, 42, 7852.
14 G. Y. Zheng, D. P. Rillema, Inorg. Chem., 1998, 37, 1392.


**Patentansprüche**

**1.** Zusammensetzung enthaltend einen ersten neutralen Übergangsmetallkomplex und einen zweiten neutralen Übergangsmetallkomplex, wobei der erste Übergangmetallkomplex und der zweite Übergangsmetallkomplex zusammen eine Kolumnarstruktur ausbilden und **dadurch gekennzeichnet, dass** der erste Übergangsmetallkomplex ein Pd (II)- Komplex nach Formel 137 bis 264 wie in der Beschreibung definiert ist, und der zweite Übergangsmetallkomplex ein Komplex ist, der ausgewählt ist aus der Gruppe bestehend aus den Pt (II)- Komplexen nach Formel 15 bis 136 wie in der Beschreibung definiert, den Ir (I)- Komplexen nach Formel 1 bis 7 wie in der Beschreibung definiert, den Rh (I)- Komplexen nach Formel 8 bis 14 wie in der Beschreibung definiert, und den Au (III)- Komplexen nach Formel 265 bis 271 wie in der Beschreibung definiert.

**2.** Zusammensetzung nach Anspruch 1, wobei die Zusammensetzung ein Matrixmaterial enthält.

**3.** Verwendung einer Zusammensetzung nach Anspruch 1 in einem elektronischen Bauelement.

**4.** Verwendung nach Anspruch 3, **dadurch gekennzeichnet, dass** die Zusammensetzung als Emitter oder als Absorber eingesetzt wird.

5. Elektronisches Bauelement, enthaltend eine Zusammensetzung nach Anspruch 1 oder 2.

6. Elektronisches Bauelement nach Anspruch 5, ausgeformt als ein Bauelement ausgewählt aus der Gruppe bestehend aus organischem lichtemittierendem Bauelement, organischer Diode, organischer Solarzelle, organischem Transistor und organischer lichtemittierender Diode.

7. Elektronisches Bauelement nach Anspruch 5 oder 6, wobei der erste Übergangsmetallkomplex und der zweite Übergangsmetallkomplex zusammen 1 % bis 100 % der Zusammensetzung ausmachen, bevorzugt 1 bis 10 % oder 10 bis 100 %.

8. Elektronisches Bauelement nach einem oder mehreren der Ansprüche 5 bis 7, wobei der Anteil des ersten Übergangsmetallkomplexes an der Zusammensetzung 90 % bis 99,999 % beträgt und der Anteil des zweiten Übergangsmetallkomplexes an der Zusammensetzung 10 % bis 0,001 % beträgt.

9. Verfahren zur Herstellung eines elektronischen Bauelements nach einem der Ansprüche 5 bis 8, **gekennzeichnet durch** Aufbringen einer Zusammensetzung nach Anspruch 1 oder 2 auf einen Träger.

10. Verfahren zur Veränderung der Emissions- und/oder Absorptionseigenschaften eines elektronischen Bauelements, **gekennzeichnet durch** Einbringen einer Zusammensetzung nach Anspruch 1 oder 2 in ein Matrixmaterial zur Leitung von Elektronen oder Löchern in einem elektronischen Bauelement.

## Claims

1. Composition comprising a first neutral transition-metal complex and a second neutral transition-metal complex, where the first transition-metal complex and the second transition-metal complex together form a columnar structure and **characterised in that** the first transition-metal complex is a Pd(II) complex of the formulae 137 to 264 as defined in the description, and the second transition-metal complex is a complex selected from the group consisting of the Pt(II) complexes of the formulae 15 to 136 as defined in the description, the Ir(I) complexes of the formulae 1 to 7 as defined in the description, the Rh(I) complexes of the formulae 8 to 14 as defined in the description and the Au (III) complexes of the formulae 265 to 271 as defined in the description.

2. Composition according to Claim 1, where the composition comprises a matrix material.

3. Use of a composition according to Claim 1 in an electronic component.

4. Use according to Claim 3, **characterised in that** the composition is employed as emitter or as absorber.

5. Electronic component comprising a composition according to Claim 1 or 2.

6. Electronic component according to Claim 5, formed as a component selected from the group consisting of organic light-emitting component, organic diode, organic solar cell, organic transistor and organic light-emit-ting diode.

7. Electronic component according to Claim 5 or 6, where the first transition-metal complex and the second transition-metal complex together make up 1% to 100% of the composition, preferably 1 to 10% or 10 to 100%.

8. Electronic component according to one or more of Claims 5 to 7, where the proportion of the first transition-metal complex in the composition is 90% to 99.999%, and the proportion of the second transition-metal complex in the composition is 10% to 0.001%.

9. Process for the production of an electronic component according to one of Claims 5 to 8, **characterised by** the application of a composition according to Claim 1 or 2 to a support.

10. Process for the modification of the emission and/or absorption properties of an electronic component, **characterised by** the introduction of a composition according to Claim 1 or 2 into a matrix material for the transport of electrons or holes in an electronic component.

## Revendications

1. Composition comprenant un premier complexe de métal de transition neutre et un second complexe de métal de transition neutre, dans laquelle le premier complexe de métal de transition neutre et le second complexe de métal de transition neutre forment ensemble une structure colonnaire et **caractérisée en ce que** le premier complexe de métal de transition neutre est un complexe Pd(II) des formules 137 à 264 comme défini dans la description et le second complexe de métal de transition neutre est un complexe choisi parmi le groupe constitué par les complexes Pt(II) des formules 15 à 136 comme défini dans la description, les complexes Ir(I) des formules 1 à 7 comme défini dans la description, les complexes Rh(I) des formules 8 à 14 comme défini dans la description et les complexes Au (III) des formules 265 à 271 comme défini dans la description.

2. Composition selon la revendication 1, dans laquelle la composition comprend un matériau de matrice.

3. Utilisation d'une composition selon la revendication 1 dans un composant électronique.

4. Utilisation selon la revendication 3, **caractérisée en ce que** la composition est utilisée en tant qu'émetteur ou en tant qu'absorbeur.

5. Composant électronique comprenant une composition selon la revendication 1 ou 2.

6. Composant électronique selon la revendication 5, formé en tant que composant choisi parmi le groupe constitué par un composant émetteur de lumière organique, une diode organique, une cellule solaire organique, un transistor organique et une diode émettrice de lumière organique.

7. Composant électronique selon la revendication 5 ou 6, dans lequel le premier complexe de métal de transition neutre et le second complexe de métal de transition neutre constituent ensemble 1 % à 100% de la composition, de préférence 1 à 10% ou 10 à 100%.

8. Composant électronique selon une ou plusieurs des revendications 5 à 7, dans lequel la proportion du premier complexe de métal de transition neutre dans la composition est de 90% à 99,999%, et la proportion du second complexe de métal de transition neutre dans la composition est de 10% à 0,001%.

9. Procédé pour la fabrication d'un composant électronique selon l'une des revendications 5 à 8, **caractérisé par** l'application d'une composition selon la revendication 1 ou 2 sur un support.

10. Procédé pour la modification des propriétés d'émission et/ou d'absorption d'un composant électronique, **caractérisé par** l'introduction d'une composition selon la revendication 1 ou 2 à l'intérieur d'un matériau de matrice pour le transport d'électrons ou de trous dans un composant électronique.

**Figur 1**

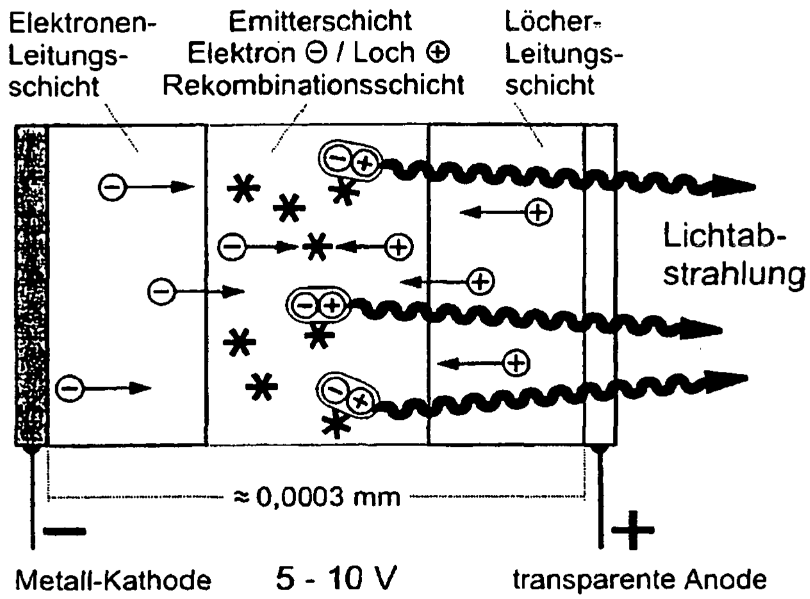


**Figur 2**

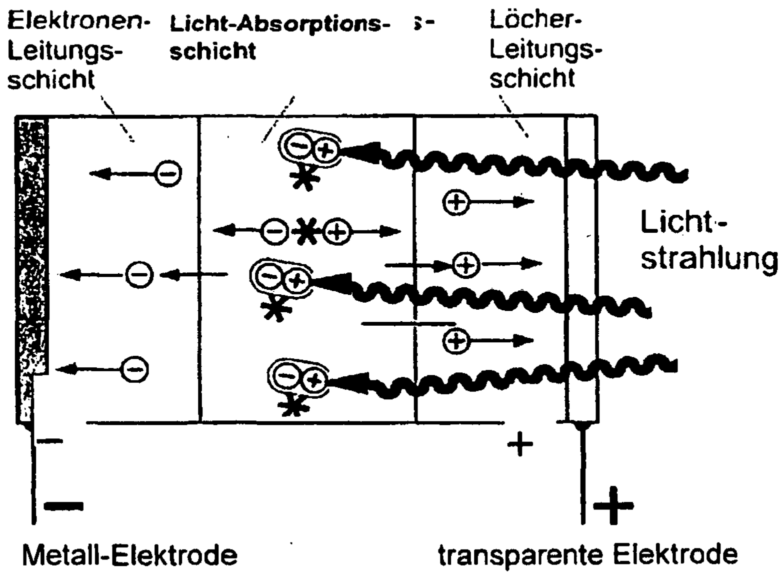

Figur 3

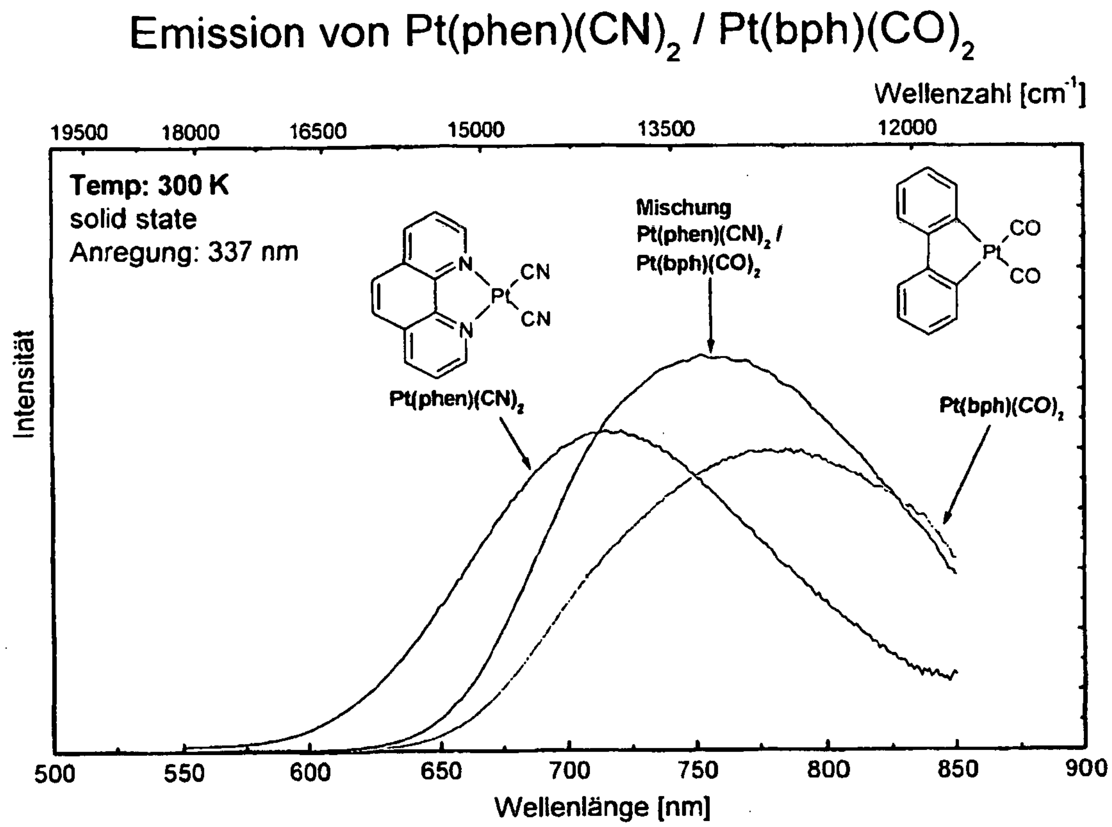


Figur 4

| | |
|---|---|
| 8 | Kathode, Al: 60 nm |
| 7 | Zwischenschicht LiF: 0,8 nm |
| 6 | ETL, $Alq_3$: 40 nm |
| 5 | Emitter Schicht: 30 bis 100 nm |
| 4 | HTL: α-NPD: 50 nm |
| 3 | HIL: CuPc: 10nm |
| 2 | Anode, ITO: 40 nm |
| 1 | Trägermaterial, Glas |

Figur 5

| | |
|---|---|
| 7 | Kathode, Al: 60 nm |
| 6 | Zwischenschicht CsF: 0,8 nm |
| 5 | ETL $Alq_3$: 40 nm |
| 4 | Emitter Layer: 30 bis 100 nm |
| 3 | HTL, PEDOT: PSS: 50 nm |
| 2 | Anode, ITO: 40 nm |
| 1 | Trägermaterial, Glas |

Figur 6

| | |
|---|---|
| 6 | Elektrode, positiv |
| 5 | HTL: p-Leiter-Material |
| 4 | Absorptions-Schicht |
| 3 | ETL: n-Leiter-Material |
| 2 | Elektrode, negativ |
| 1 | Trägermaterial |

Figur 7

| | |
|---|---|
| 6 | Positive Elektrode, Au: 60 nm |
| 5 | HTL: MeO-TPD: 10 nm |
| 4 | Erfindungsgemäße Stoffzusammensetzung: 50 bis 100 nm |
| 3 | ETL, $C_{60}$: 50 nm |
| 2 | Negative Elektrode, ITO: 40 nm |
| 1 | Trägermaterial, Glas |

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 200406353 A
- WO 04013080 A
- WO 04093207 A
- WO 06005627 A
- DE 102008033943
- WO 05039246 A
- US 20050069729 A
- JP 2004288381 A
- EP 1205527 A
- WO 08086851 A
- WO 07063754 A
- WO 08056746 A
- EP 1617710 A
- EP 1617711 A
- EP 1731584 A
- JP 2005347160 A
- WO 07137725 A
- WO 05111172 A
- WO 06117052 A
- DE 102008036982
- DE 102007053771
- WO 05003253 A
- WO 2005056712 A1
- WO 2007118671 A1


### In der Beschreibung aufgeführte Nicht-Patentliteratur


- **M. S. ARNOLD et al.** *Appl. Phys. Lett.,* 2008, vol. 92, 053301
- **G. AULLÓN ; S. ALVAREZ.** *Chem. Eur. J.,* 1997, vol. 3, 655
- **W. B. CONNICK ; R. E. MARSH ; W. P. SCHAEFER ; H. B. GRAY.** *Inorg. Chem.,* 1997, vol. 36, 913
- **H. ISCI ; W. R. MASON.** *Inorg. Chem.,* 1974, vol. 13, 1175
- **H. BOIS ; N. G. CONNELLY ; J. G. CROSSLEY ; J.-C. GUILLORIT ; G. R. LEWIS ; A. G. ORPEN ; P. THORNTON.** *J. Chem. Soc., Dalton Trans.,* 1998, 2833
- **G. GLIEMANN ; H. YERSIN.** *Structure and Bonding,* 1985, vol. 62, 87
- **A. E. STIEGMAN ; S. F. RICE ; H. B. GRAY ; V. M. MISKOWSKI.** *Inorg. Chem.,* 1987, vol. 26, 1112
- **C.-M. CHE ; K.-T. WAN ; L.-Y. HE ; C.-K. POON ; V. W.-W. YAM.** *J. Chem. Soc., Chem. Commun.,* 1989, 943
- **J. R. STORK ; M. M. OLMSTEAD ; A. L. BALCH.** *Inorg. Chem. 2,* 2004, vol. 43, 7508
- **M. V. PUZYK ; M. A. IVANOV ; K.P. BALASHEV.** *Opt. Spectrosc.,* 2003, vol. 95, 81
- **J. W. SCHINDLER ; R. C. FUKUDA ; A. W. ADAMSON.** *J. Am. Chem. Soc.,* 1982, vol. 104, 3596
- **S. R. STOYANOV ; J. M. VILLEGAS ; D. P. RILLEMA.** *Inorg. Chem.,* 2003, vol. 42, 7852
- **G. Y. ZHENG ; D. P. RILLEMA.** *Inorg. Chem.,* 1998, vol. 37, 1392